# EUROPEAN PATENT APPLICATION

(11) **EP 4 431 516 A1**
(43) Date of publication of application: **18.09.2024**
(21) Application number: 23162180.6
(22) Date of filing: 15.03.2023
(51) Int. Cl.: C07F 5/02, C09K 11/06, H10K 50/12, H10K 85/60

(54) **COMPOUND AND AN ORGANIC ELECTROLUMINESCENCE DEVICE COMPRISING THE COMPOUND**

(71) Applicant: Idemitsu Kosan Co., Ltd, Tokyo 100-8321 (JP)
(72) Inventor: Murer, Peter, 4058 Basel (CH); Lin, Chao-Chen, 4058 Basel (CH)
(74) Representative: Büchel, Edwin

(57) **Abstract**

The present invention relates to specific compounds of formula (I), a material, preferably an emitter material, for an organic electroluminescence device comprising said specific compounds, an organic electroluminescence device comprising said specific compounds, an electronic equipment comprising said organic electroluminescence device, a light emitting layer comprising at least one host and at least one dopant, wherein the dopant comprises at least one of said specific compounds, and the use of said compounds in an organic electroluminescence device.

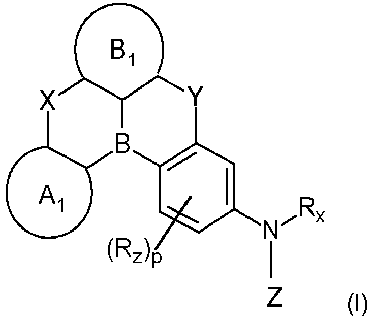

## Description

The present invention relates to specific compounds, a material, preferably an emitter material, for an organic electroluminescence device comprising said specific compounds, an organic electroluminescence device comprising said specific compounds, an electronic equipment comprising said organic electroluminescence device, a light emitting layer comprising at least one host and at least one dopant, wherein the dopant comprises at least one of said specific compounds, and the use of said compounds in an organic electroluminescence device.

When a voltage is applied to an organic electroluminescence device (hereinafter may be referred to as an organic EL device), holes are injected to an emitting layer from an anode and electrons are injected to an emitting layer from a cathode. In the emitting layer, injected holes and electrons are re-combined and excitons are formed.

An organic EL device comprises an emitting layer between the anode and the cathode. Further, there may be a case where it has a stacked layer structure comprising an organic layer such as a hole-injecting layer, a hole-transporting layer, an electron-injecting layer, an electron-transporting layer, etc.

WO2020085829, US20210119134, DE102021108828 and US20220077406 relate to a plurality of light-emitting materials comprising at least one of first anthracene compound and at least one of second cyclic boron compound having the formula mentioned below, and an organic electroluminescent device.

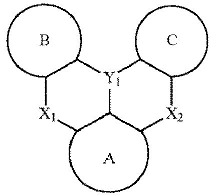

US20210210684 relates to a plurality of light-emitting materials comprising at least one of first phenanthrene compound (1) and at least one of second cyclic boron compound (2), and an organic electroluminescent device. 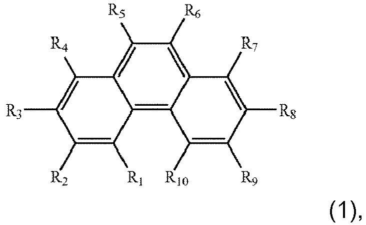 with the proviso that at least one of R₁ to R₁₀ is 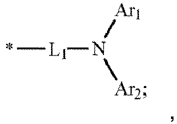 and

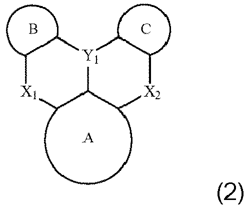

WO2022145775 A1 relates to a polycyclic compound represented by formula (I); and an organic light emitting device which comprises a first electrode, a second electrode and at least one organic layer provided between the first electrode and the second electrode, at least one of the organic layers comprising the polycyclic compound. 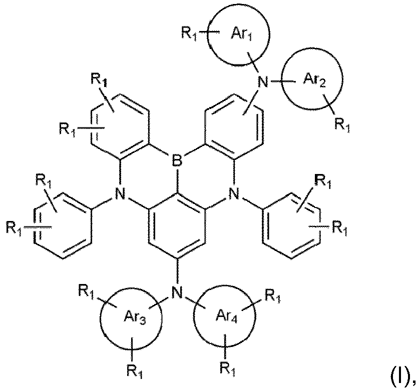 wherein at least one of R₁ is benzofuranyl or benzothiophenyl.

The specific structure and substitution pattern of compounds has a significant impact on the performance of the compounds in organic electronic devices.

Notwithstanding the developments described above, there remains a need for organic electroluminescence devices comprising new materials, especially dopant (= emitter) materials, to provide improved performance of electroluminescence devices.

Accordingly, it is an object of the present invention, with respect to the aforementioned related art, to provide materials suitable for providing organic electroluminescence devices which ensure good performance of the organic electroluminescence devices, especially good EQEs and/or a long lifetime. More particularly, it should be possible to provide dopant (= emitter) materials, especially blue light emitting dopant materials having balanced properties, especially good EQEs, and/or a long lifetime when used as dopant in organic electroluminescence devices.

Said object is according to one aspect of the present invention solved by a compound represented by formula (I): 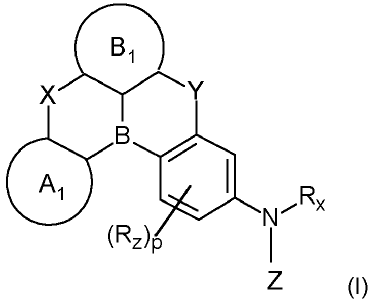 wherein
Z represents a group of formula (IIa), (IIb) or (IIc) 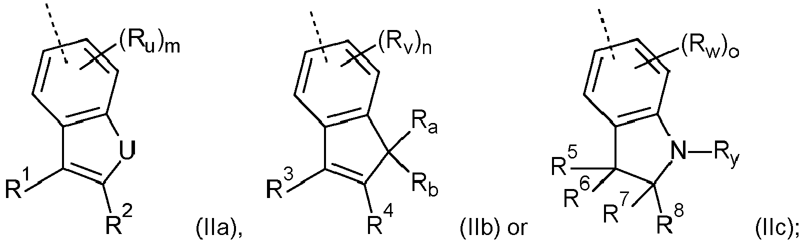
ring A₁ represents a substituted or unsubstituted aryl group having 6 to 30 ring carbon atoms, or a substituted or unsubstituted heteroaryl group having 5 to 30 ring atoms;
two substituents at ring A₁ can form a ring;
ring B₁ is an aryl group having 6 to 30 ring carbon atoms substituted by at least one group R²⁶, or a substituted heteroaryl group having 5 to 30 ring atoms substituted by at least one group R₂₆;
R²⁶ represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; an alkylhalide group having from 1 to 20 carbon atoms which is unsubstituted or substituted; a cycloalkyl group having from 3 to 20 ring carbon atoms which is unsubstituted or substituted; CN; OR⁵¹; SR⁵²; BR⁵³R⁵⁴; SiR⁵⁵R⁵⁶R⁵⁷ or halogen;
X represents O, S, NR_{EX}, SiR⁴⁴R⁴⁵, or CR⁴⁶R⁴⁷;
Y represents O, S, NR_{EY}, SiR⁴⁴R⁴⁵, or CR⁴⁶R⁴⁷;
R_{EX} and R_{EY} each independently represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; an alkenyl group having from 2 to 20 carbon atoms which is unsubstituted or substituted; an iminyl group Rₓ-C=N, an alkynyl group having from 2 to 20 carbon atoms which is unsubstituted or substituted;
R_{EX} or a substituent on R_{EX} may be bonded to the ring A₁ and/or to the ring B₁ or to a substituent on the ring A₁ and/or the ring B₁ to form a ring structure which is unsubstituted or substituted;
R_{EY} or a substituent on R_{EY} may be bonded to the ring B₁ or to a substituent on the ring B₁ to form a ring structure which is unsubstituted or substituted;
R⁴⁴, R⁴⁵, R⁴⁶ and R⁴⁷ each independently represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted;
   or
R⁴⁴ and R⁴⁵ or R⁴⁶ and R⁴⁷ can form a ring which is unsubstituted or substituted;
Rₓ represents an aryl group having from 6 to 30 ring carbon atoms which is unsubstituted or substituted; a heteroaryl group having from 5 to 30 ring atoms which is unsubstituted or substituted;
R¹, R², R³ and R⁴ each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted;
   or
R¹ and R² or R³ and R⁴ can form a ring, preferably an aryl ring, which is unsubstituted or substituted;
U represents NR⁴⁸, O, or S, preferably NR⁴⁸, or O, more preferably NR⁴⁸;
R⁴⁸ represents an aryl group having from 6 to 30 ring carbon atoms which is unsubstituted or substituted; or a heteroaryl group having from 5 to 30 ring atoms which is unsubstituted or substituted;
Rₐ and R_{b} each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted;
   or
Rₐ and R_{b} can form a ring which is unsubstituted or substituted;
R⁵, R⁶, R⁷ and R⁸ each independently represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; preferably an aryl group having from 6 to 30 ring carbon atoms which is unsubstituted or substituted; or an alkyl group having from 1 to 20 carbon atoms which is unsubstituted or substituted;
   and/or
R⁵ and R⁶, R⁶ and R⁷, R⁷ and R⁸ and/or R⁵ and R⁸, preferably R⁵ and R⁸ and/or R⁶ and R⁷, can form a substituted or unsubstituted aliphatic ring;
R_{y} represents an aryl group having from 6 to 30 ring carbon atoms which is unsubstituted or substituted; or a heteroaryl group having from 5 to 30 ring atoms which is unsubstituted or substituted;
Rᵤ, Rᵥ, R_{w} and R_{z} each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; an alkylhalide group having from 1 to 20 carbon atoms which is unsubstituted or substituted; a cycloalkyl group having from 3 to 20 ring carbon atoms which is unsubstituted or substituted; CN; NR⁴⁹R⁵⁰; OR⁵¹; SR⁵²; BR⁵³R⁵⁴; SiR⁵⁵R⁵⁶R⁵⁷ or halogen; preferably hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; NR⁴⁹R⁵⁰;
n, m, o and p each independently represents 0, 1, 2, or 3, preferably 0 or 1, more preferably 0;
R⁴⁹, R⁵⁰, R⁵¹, R⁵², R⁵³, and R⁵⁴ each independently represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted or a cycloalkyl group having from 3 to 20 ring carbon atoms which is unsubstituted or substituted;
   and/or
R⁴⁹ and R⁵⁰ and/or R⁵³ and R⁵⁴ can form a substituted or unsubstituted ring;
R⁵⁵, R⁵⁶ and R⁵⁷ each independently represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted or a cycloalkyl group having from 3 to 20 ring carbon atoms which is unsubstituted or substituted; and
the dotted lines are bonding sites.

The compounds of formula (I) can be in principal used in any layer of an EL device. Preferably, the compound of formula (I) is a dopant (= emitter) in organic EL elements, especially in the light-emitting layer, more preferably a fluorescent dopant. Particularly, the compounds of formula (I) are used as fluorescent dopants in organic EL devices, especially in the light-emitting layer.

The term organic EL device (organic electroluminescence device) is used interchangeably with the term organic light-emitting diode (OLED) in the present application.

It has been found that the specific compounds of formula (I) having balanced properties, especially good EQEs and/or a long lifetime, especially when the specific compounds of formula (I) are used as dopants (light emitting material), especially fluorescent dopants in organic electroluminescence devices.

Examples of the optional substituent(s) indicated by "substituted or unsubstituted" and "may be substituted" referred to above or hereinafter include an aryl group having from 6 to 30, preferably from 6 to 18 ring carbon atoms which is in turn unsubstituted or substituted, a heteroaryl group having from 5 to 30, preferably 5 to 18 ring atoms which is in turn unsubstituted or substituted, an alkyl group having 1 to 20, preferably 1 to 8 carbon atoms, a cycloalkyl group having 3 to 20, preferably 3 to 6 carbon atoms, a group OR⁵¹, an alkylhalide group having 1 to 20, preferably 1 to 8 carbon atoms, halogen (fluorine, chlorine, bromine, iodine), CN, a silyl group
SiR⁵⁵R⁵⁶R⁵⁷, BR⁵³R⁵⁴, a group SR⁵², and NR⁴⁹R⁵⁰;
   or
two adjacent substituents together form a ring structure which is in turn unsubstituted or substituted.
R⁴⁹, R⁵⁰, R⁵¹, R⁵², R⁵³, R⁵⁴, R⁵⁵ R⁵⁶ and R⁵⁷ are defined above and below.

The terms hydrogen, halogen, an alkyl group having from 1 to 20 carbon atoms which is unsubstituted or substituted, an alkylhalide group having from 1 to 20 carbon atoms which is unsubstituted or substituted, a cycloalkyl group having from 3 to 20 ring carbon atoms which is unsubstituted or substituted, a substituted or unsubstituted aryl group having from 6 to 30, preferably from 6 to 18 ring carbon atoms; a substituted or unsubstituted heteroaryl group having from 5 to 30, preferably 5 to 18 ring atoms, a group OR⁵¹, an alkylhalide group having 1 to 20, preferably 1 to 8 carbon atoms, halogen (fluorine, chlorine, bromine, iodine), CN, a silyl group SiR⁵⁵R⁵⁶R⁵⁷, BR⁵³R⁵⁴, a group SR⁵², and NR⁴⁹R⁵⁰ are known in the art and generally have the following meaning, if said groups are not further specified in specific embodiments mentioned below:
The hydrogen atom referred to herein includes isotopes different from neutron numbers, i.e., light hydrogen (protium), heavy hydrogen (deuterium) and tritium.

In chemical formulae herein, it is meant that a hydrogen atom (i.e. protium, deuterium, or tritium) is bonded to each of bondable positions that are not annexed with symbols "R" etc., or a "D" representing a deuterium.

The term "unsubstituted" referred to by "unsubstituted or substituted" means that a hydrogen atom is not substituted by one of the groups mentioned above. The hydrogen atom(s) in the "unsubstituted" group is protium, deuterium, or tritium.

The substituted or unsubstituted aryl group having from 6 to 30, preferably from 6 to 18 ring carbon atoms most preferably having from 6 to 13 ring carbon atoms, may be a non-condensed aromatic group or a condensed aromatic group. Specific examples thereof include phenyl group, naphthyl group, phenanthryl group, biphenyl group, terphenyl group, fluoranthenyl group, triphenylenyl group, phenanthrenyl group, fluorenyl group, indenyl group, anthracenyl, chrysenyl, spirofluorenyl group, benzo[c]phenanthrenyl group, with phenyl group, naphthyl group, biphenyl group, terphenyl group, phenanthryl group, triphenylenyl group, fluorenyl group, indenyl group and fluoranthenyl group being preferred, phenyl group, 1-naphthyl group, 2-naphthyl group, biphenyl-2-yl group, biphenyl-3-yl group, biphenyl-4-yl group, phenanthrene-9-yl group, phenanthrene-3-yl group, phenanthrene-2-yl group, triphenylene-2-yl group, fluorene-1-yl group, fluorene-4-yl group, fluorene-2-yl group, preferably fluorene-2-yl group, especially a 9,9-di-C₁₋₂₀alkylfluorene-2-yl group, like a 9,9-dimethylfluorene-2-yl group, a 9,9-di-C₆₋₁₈arylfluorene-2-yl group, like a 9,9-diphenylfluorene-2-yl group, or a 9,9-di-C₅₋₁₈heteroarylfluorene-2-yl group, 1,1-dimethylindenyl group, fluoranthene-3-yl group, fluoranthene-2-yl group and fluoranthene-8-yl group being more preferred, and phenyl group being most preferred.

The substituted or unsubstituted heteroaryl group having from 5 to 30, preferably 5 to 18 ring atoms, most preferably having from 5 to 13 ring atoms, may be a non-condensed heteroaromatic group or a condensed heteroaromatic group. In a preferred embodiment, the heteroaryl group which is substituted or unsubstituted is a heteroaryl group having from 5 to 8 ring atoms which is unsubstituted or substituted or a heteroaryl group having from 10 to 30 ring atoms, preferably from 10 to 18 ring atoms, more preferably from 10 to 13 ring atoms which is unsubstituted or substituted. Specific examples thereof include the residues of pyrrole ring, dibenzothiophene ring, isoquinoline ring, quinoxaline ring, quinazoline ring, phenanthridine ring, phenanthroline ring, pyridine ring, pyrazine ring, pyrimidine ring, pyridazine ring, quinoline ring, acridine ring, carbazole ring, furan ring, thiophene ring, dibenzofuran ring, triazine ring, oxazole ring, oxadiazole ring, thiazole ring, thiadiazole ring, triazole ring, imidazole ring, indolidine ring, 4-imidazo[1,2-a]benzimidazoyl, 5-benzimidazo[1,2-a]benzimidazoyl, and benzimidazolo[2,1-b][1 ,3]benzothiazolyl, with the residues of dibenzofuran ring, carbazole ring, and dibenzothiophene ring being preferred, and the residues of dibenzofuran-1-yl group, dibenzofuran-3-yl group, dibenzofuran-2-yl group, dibenzofuran-4-yl group, 9-phenylcarbazole-3-yl group, 9-phenylcarbazole-2-yl group, 9-phenylcarbazole-4-yl group, dibenzothiophene-2-yl group, and dibenzothiophene-4-yl, dibenzothiophene-1-yl group, and dibenzothiophene-3-yl group being more preferred; and with the residues of dibenzofuran-1-yl group, dibenzofuran-3-yl group, dibenzofuran-2-yl group, dibenzofuran-4-yl group, dibenzothiophene-2-yl group, dibenzothiophene-4-yl, dibenzothiophene-1-yl group, and dibenzothiophene-3-yl group being most preferred. Further most preferred are the residues dibenzofuran-3-yl group, dibenzofuran-4-yl group, dibenzothiophene-3-yl group and dibenzothiophene-4-yl group.

In the compounds of formula (I): Ring A₁ and ring B₁ each independently represents an aromatic group having 6 to 30 ring carbon atoms or a heteroaromatic group having 5 to 30 ring atoms, which - in the case of ring A₁ - is unsubstituted or substituted, and - in the case of ring B₁ - is substituted by at least one group R²⁶. Preferably, ring A₁ and ring B₁ each independently represents an aromatic group having 6 to 18 ring carbon atoms or a heteroaromatic group having 5 to 18 ring atoms, which - in the case of ring A₁ - is unsubstituted or substituted, and - in the case of ring B₁ - is substituted by at least one group R²⁶. Preferred rings A₁ and B₁ are mentioned below.

More preferably, the aromatic group is defined as the preferred embodiments and specific examples mentioned in the definition of the aryl group mentioned above and the heteroaromatic group is defined as the preferred embodiments and specific examples mentioned in the definition of the heteroaryl group mentioned above.

Examples of the alkyl group having from 1 to 20 carbon atoms which is unsubstituted or substituted include methyl group, ethyl group, n-propyl group, isopropyl group, n-butyl group, s-butyl group, isobutyl group, t-butyl group, n-pentyl group, n-hexyl group, n-heptyl group, n-octyl group, n-nonyl group, neopentyl group, 1-methylpentyl group, with methyl group, ethyl group, n-propyl group, isopropyl group, n-butyl group, s-butyl group, isobutyl group, t-butyl group being preferred. Preferred are alkyl groups having 1 to 8 carbon atoms, more preferably 1 to 4 carbon atoms. Suitable examples for alkyl groups having 1 to 8 carbon atoms respectively 1 to 4 carbon atoms are mentioned before.

Examples of the alkylhalide group having from 1 to 20 carbon atoms which is unsubstituted or substituted include those disclosed as alkyl groups wherein the hydrogen atoms thereof are partly or entirely substituted by halogen atoms. Preferred alkylhalide groups are fluoroalkyl groups having 1 to 20 carbon atoms including the alkyl groups mentioned above wherein the hydrogen atoms thereof are partly or entirely substituted by fluorine atoms, for example CF₃.

Examples of the cycloalkyl group having from 3 to 20 ring carbon atoms which is unsubstituted or substituted include cyclopropyl group, cyclobutyl group, cyclopentyl group, cyclohexyl group, cyclooctyl group, and adamantyl group, with adamantyl group, cyclopentyl group, and cyclohexyl group being preferred. Preferred are cycloalkyl groups having 3 to 6 carbon atoms as well as adamantyl groups. Suitable examples for cycloalkyl groups having 3 to 6 carbon atoms are mentioned before.

Examples of halogen include fluorine, chlorine, bromine, and iodine, with fluorine being preferred.

The group OR⁵¹ is preferably a C₁₋₂oalkoxy group or a C₆₋₁₈aryloxy group. Examples of an alkoxy group having 1 to 20 carbon atoms, preferably 1 to 8 carbon atoms, include those having an alkyl portion selected from the alkyl groups mentioned above. Examples of an aryloxy group having 6 to 18 ring carbon atoms include those having an aryl portion selected from the aryl groups mentioned above, for example -OPh.

The group SR⁵² is preferably a C₁₋₂₀alkylthio group or a C₆₋₁₈arylthio group. Examples of an alkylthio group having 1 to 20 carbon atoms, preferably 1 to 8 carbon atoms, include those having an alkyl portion selected from the alkyl groups mentioned above. Examples of an arylthio group having 6 to 18 ring carbon atoms include those having an aryl portion selected from the aryl groups mentioned above, for example -SPh.

The group SiR⁵⁵R⁵⁶R⁵⁷ is preferably a C₁₋₂₀alkyl and/or C₆₋₁₈aryl substituted silyl group. Preferred examples of C₁₋₂₀alkyl and/or C₆₋₁₈aryl substituted silyl groups include alkylsilyl groups having 1 to 8 carbon atoms in each alkyl residue, preferably 1 to 4 carbon atoms, including trimethylsilyl group, triethylsilyl group, tributylsilyl group, dimethylethylsilyl group, t-butyldimethylsilyl group, propyldimethylsilyl group, dimethylisopropylsilyl group, dimethylpropylsilyl group, dimethylbutylsilyl group, dimethyltertiarybutylsilyl group, diethylisopropylsilyl group, and arylsilyl groups having 6 to 18 ring carbon atoms in each aryl residue, preferably triphenylsilyl group, and alkyl/arylsilyl groups, preferably phenyldimethylsilyl group, diphenylmethylsilyl group, and diphenyltertiarybutylsilyl group, with diphenyltertiarybutylsilyl group and t-butyldimethylsilyl group being preferred.

BR⁵³R⁵⁴ is preferably a C₁₋₂₀alkyl and/or C₆₋₁₈aryl substituted bor group. Preferred examples of C₁₋₂₀alkyl and/or C₆₋₁₈aryl substituted bor groups include alkylbor groups having 1 to 8 carbon atoms in each alkyl residue, preferably 1 to 4 carbon atoms, and arylbor groups having 6 to 13 ring carbon atoms in each aryl residue, and alkyl/arylbor groups.

NR⁴⁹R⁵⁰ is preferably a C₁₋₂₀alkyl and/or C₆₋₁₈aryl and/or heteroaryl having 5 to 18 ring atoms substituted amino group. Preferred examples of C₁₋₂₀alkyl and/or C₆₋₁₈aryl and/or heteroaryl having 5 to 18 ring atoms substituted amino groups include alkylamino groups having 1 to 8 carbon atoms in each alkyl residue, preferably 1 to 4 carbon atoms, and arylamino groups and/or heteroarylamino groups having 6 to 18 ring carbon atoms in each aryl residue and/or 5 to 18 ring atoms in each heteroaryl residue, and mixed amino groups comprising alkyl and aryl groups, aryl and heteroatyl groups or alkyl and heteroaryl groups. Preferably, NR⁴⁹R⁵⁰ is a C₆₋₁₈aryl and/or heteroaryl having 5 to 18 ring atoms substituted amino group.

The optional substituents preferably each independently represents an aryl group having from 6 to 18 ring carbon atoms which is unsubstituted or substituted; a heteroaryl group having from 5 to 8 ring atoms which is unsubstituted or substituted; a heteroaryl group having from 10 to 18 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; halogen, CN; SiR⁵⁵R⁵⁶R⁵⁷, SR⁵² or OR⁵¹;
or
two adjacent substituents together form an aromatic or heteroaromatic ring structure which is in turn unsubstituted or substituted.

More preferably, the optional substituents each independently represents an aryl group having from 6 to 18 ring carbon atoms which is unsubstituted or substituted; a heteroaryl group having from 5 to 8 ring atoms which is unsubstituted or substituted; a heteroaryl group having from 10 to 18 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; halogen, SiR⁵⁵R⁵⁶R⁵⁷ or CN;
or
two adjacent substituents together form an aromatic or heteroaromatic ring structure which is in turn unsubstituted or substituted.

Most preferably, the optional substituents each independently represents an alkyl group having 1 to 4 carbon atoms which is unsubstituted or substituted; a cycloalkyl group having from 3 to 6 ring carbon atoms which is unsubstituted or substituted; an aryl group having 6 to 13 ring carbon atoms which is unsubstituted or substituted; a heteroaryl group having from 5 to 8 ring atoms which is unsubstituted or substituted; a heteroaryl group having from 10 to 13 ring atoms which is unsubstituted or substituted; halogen, SiR⁵⁵R⁵⁶R⁵⁷ or CN.

R⁴⁹, R⁵⁰, R⁵¹, R⁵², R⁵³ and R⁵⁴ each independently represents an aryl group having from 6 to 18 ring carbon atoms which is unsubstituted or substituted; a heteroaryl group having from 5 to 18 ring atoms which is unsubstituted or substituted and which is linked via a carbon atom to B or N or O or S; an alkyl group having from 1 to 20 carbon atoms which is unsubstituted or substituted; or a cycloalkyl group having from 3 to 20 ring carbon atoms which is unsubstituted or substituted, preferably an aryl group having from 6 to 18 ring carbon atoms which is unsubstituted or substituted; or an alkyl group having from 1 to 20 carbon atoms which is unsubstituted or substituted.

R⁵⁵, R⁵⁶ and R⁵⁷ represents an aryl group having from 6 to 18 ring carbon atoms which is unsubstituted or substituted; a heteroaryl group having from 5 to 18 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted.

The optional substituents mentioned above may be further substituted by one or more of the optional substituents mentioned above.

The number of the optional substituents depends on the group which is substituted by said substituent(s). The maximum number of possible substituents is defined by the number of hydrogen atoms present. Preferred are 1, 2, 3, 4, 5 or 6 optional substituents per group which is substituted, more preferred are 1, 2, 3, 4 or 5 optional substituents, most preferred are 1, 2, 3 or 4 optional substituents, further most preferred are 1, 2 or 3 optional substituents, even further most preferred are 1 or 2 optional substituents per group which is substituted. In a further preferred embodiment, some or all of the groups mentioned above are unsubstituted.

In a further preferred embodiment, the total number of substituents in the compound of formula (I) is 0, 1, 2, 3, 4, 5, 6, 7 or 8, preferably 0, 1, 2, 3, 4, 5, or 6, i.e. the remaining residues are hydrogen.

The "carbon number of a to b" in the expression of "substituted or unsubstituted X group having a to b carbon atoms" is the carbon number of the unsubstituted X group and does not include the carbon atom(s) of an optional substituent.

The term "unsubstituted" referred to by "unsubstituted or substituted" means that a hydrogen atom is not substituted by one the groups mentioned above.

An index of 0 in the definition in any formula mentioned above and below means that a hydrogen atom is present at the position defined by said index.

Ring structures formed by two adjacent substituents are aromatic rings, heteroaromatic rings, aliphatic rings or heteroaliphatic rings.

Preferred aromatic rings comprise 6 to 30 ring atoms, preferably 6 to 18 ring atoms, more preferably 6 to 10 ring atoms. More preferred aromatic rings are rings (B), (C) and (D) mentioned below.

Preferred heteroaromatic rings comprise 5 to 30 ring atoms, preferably 5 to 18 ring atoms, more preferably 5 to 10 ring atoms. More preferred heteroaromatic rings are rings (A), (E) and (F) mentioned below.

Preferred aliphatic rings comprise 5 to 18 ring atoms, preferably 5 or 6 ring atoms. More preferred aliphatic rings are rings (G) mentioned below.

Preferred heteroaliphatic rings comprise 5 to 18 ring atoms, preferably 5 or 6 ring atoms.

The numbers of ring atoms mentioned above include the ring atoms to which the two adjacent atoms are attached.

The heteroaromatic and heteroaliphatic rings comprise at least one heteroatom, preferably 1, 2 or 3, more preferably 1 or 2 heteroatoms, most preferably 1 heteroatom. The heteroatoms are preferably selected from N, NR^{e'}, O and S, preferably O or S. In the case that more than one heteroatom is present in the ring, the heteroatoms are the same or different.

Examples for ring structures formed by two adjacent substituents are shown below: 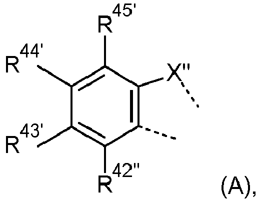 e.g. 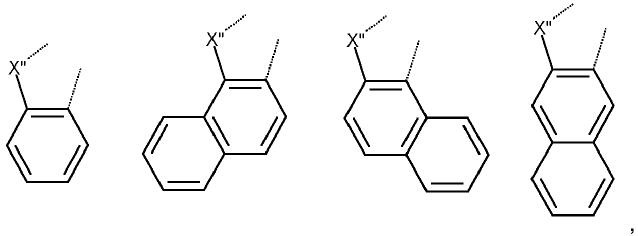 preferably 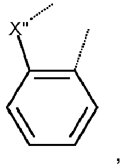 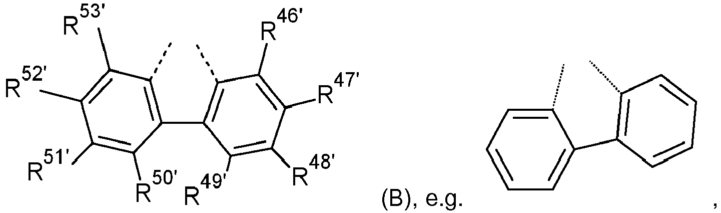 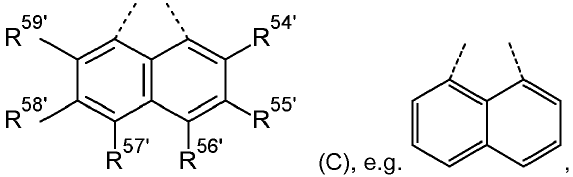 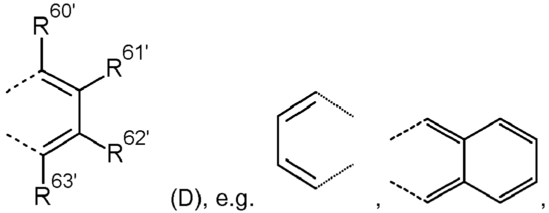 preferably 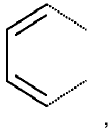 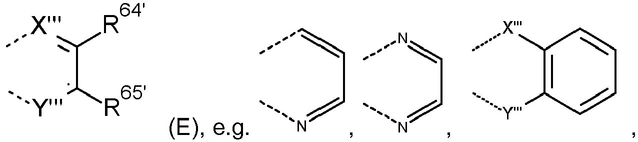 like 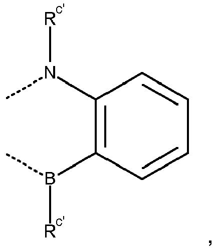 preferably 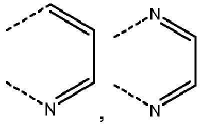 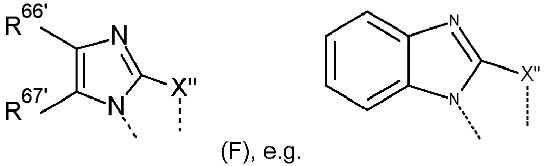 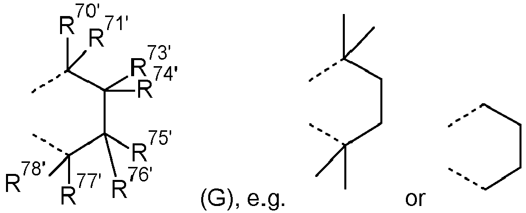 wherein
X" represents O, S or CR^{68'}R^{69'};
R^{42"} R^{43'}, R^{44'}, R^{45'} R^{46'}, R^{47'} R^{48'} R^{49'} R^{50'}, R^{51'}, R^{52'} R^{53'}, R^{54'} R^{55'} R^{56'}, R^{57'} R^{58'} R^{59'} R^{60'}, R^{61'}, R^{62'}, R^{63'}, R^{64'}, R^{65'}, R^{66'} and R^{67'}, R^{70'}, R^{71'}, R^{72'}, R^{73'}, R^{74'}, R^{75'}, R^{76'}, R^{77'} and R^{78'} each independently represents hydrogen, an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted;
   or
two adjacent residues together form an aromatic or heteroaromatic ring structure which is unsubstituted or substituted,
wherein the dotted lines are bonding sites;
R^{68'} and R^{69'} each independently represents hydrogen; an aryl group having from 6 to 30 ring carbon atoms which is unsubstituted or substituted; a heteroaryl group having from 5 to 30 ring atoms which is unsubstituted or substituted or an alkyl group having from 1 to 20 carbon atoms which is unsubstituted or substituted;
   or
R^{68'} and R^{69'} together form an aromatic ring structure having from 3 to 13 ring atoms which is unsubstituted or substituted or an aliphatic ring structure having from 3 to 9 ring atoms which is unsubstituted or substituted;
X‴ and Y‴ each independently represents O, CR^{c'}R^{d'}, S, BR^{e'} or NR^{e'},
R^{c'} and R^{d'} each independently represents C₁ to C₈ alkyl or substituted or unsubstituted C₆ to C₁₈ aryl, preferably C₁ to C₄ alkyl or substituted or unsubstituted C₆ to C₁₀ aryl, more preferably methyl or unsubstituted or substituted phenyl,
R^{e'} represents C₁ to C₈ alkyl, preferably C₁ to C₄ alkyl, or substituted or unsubstituted C₆ to C₁₀ aryl, preferably unsubstituted or substituted phenyl,
   and
the dotted lines are bonding sites.

Preferred examples for ring structures formed by two adjacent substituents are the ring structures (A), (D) and (G), more preferred ring structures formed by two adjacent substituents are 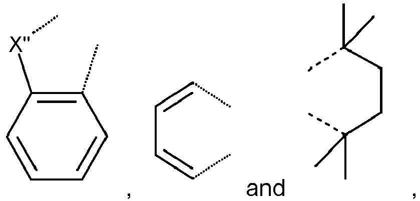 wherein said ring structures are unsubstituted or substituted. Suitable and preferred substituents are mentioned above.

### The compounds of formula (I)

In the compounds represented by formula (I) Z represents a group of formula (Ila), (Ilb) or (IIc), and
ring B₁ is a substituted aromatic group having 6 to 30 ring carbon atoms substituted by at least one group R²⁶, or a substituted heteroaromatic group having 5 to 30 ring atoms substituted by at least one group R²⁶.

The specific compounds of formula (I) having balanced properties, especially good EQEs and/or a long lifetime, especially when the specific compounds of formula (I) are used as dopants (light emitting material), especially fluorescent dopants in organic electroluminescence devices.

Ring A₁ 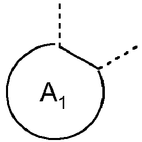 in formula (I) represents a substituted or unsubstituted aromatic group having 6 to 30 ring carbon atoms, or a substituted or unsubstituted heteroaromatic group having 5 to 30 ring atoms;
two substituents at ring A₁ can form a ring;

Ring A₁ is preferably represented by a group of formula (VII) 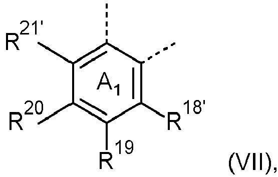 or by a group of formula (VII') 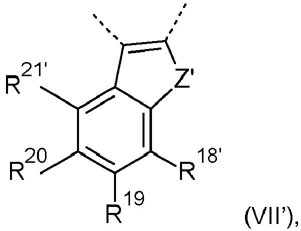 preferably a group of formula (VII);
wherein
R^{18'}, R¹⁹, R²⁰ and R^{21'} each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; an alkylhalide group having from 1 to 20 carbon atoms which is unsubstituted or substituted; a cycloalkyl group having from 3 to 20 ring carbon atoms which is unsubstituted or substituted; CN; NR⁴⁹R⁵⁰; OR⁵¹; SR⁵²; BR⁵³R⁵⁴; SiR⁵⁵R⁵⁶R⁵⁷ or halogen;
   and/or
two adjacent residues R^{18'}, R¹⁹, R²⁰ and/or R^{21'} together may form a ring which is unsubstituted or substituted;
preferably, R^{18'}, R¹⁹, R²⁰ and R^{21'} each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; or NR⁴⁹R⁵⁰;
   and/or
two adjacent residues R¹⁹ and R²⁰ together may form an aliphatic ring which is unsubstituted or substituted;
more preferably, at least two of R^{18'}, R¹⁹, R²⁰ and R^{21'} represent hydrogen, and the remaining of R^{18'}, R¹⁹, R²⁰ and R^{21'} each independently represents hydrogen, an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; or NR⁴⁹R⁵⁰; preferably an alkyl group having from 1 to 20 carbon atoms which is unsubstituted or substituted; more preferably an unsubstituted alkyl group having from 1 to 8 carbon atoms;
   and/or
two adjacent residues R¹⁹ and R²⁰ together may form an aliphatic ring which is unsubstituted or substituted;
most preferably, at least two of R^{18'}, R¹⁹, R²⁰ and R^{21'} do not represent hydrogen; further most preferably, at least R¹⁹ or R²⁰ do not represent hydrogen;
   and - in formula (VII'):
Z' represents O, S, NR^{9'}, CR^{10'}R^{11'}, preferably O or S;
R^{9'} represents a substituted or unsubstituted aryl group having 6 to 30 ring carbon atoms, or a substituted or unsubstituted heteroaryl group having 5 to 30 ring atoms; preferably a substituted or unsubstituted aryl group having 6 to 18 ring carbon atoms;
R^{10'} and R^{11'} each independently represents a substituted or unsubstituted alkyl group having 1 to 20 carbon atoms, preferably 1 to 8 carbon atoms, more preferably 1 to 4 carbon atoms.

The dotted lines are bonding sites.

The ring A₁ in formula (I) is more preferably represented by a group of formula (Vlla)

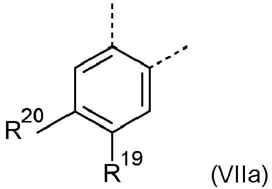

The residues and groups in formula (Vlla) are the same as defined above.

Preferably, R¹⁹ and R²⁰ in formula (Vlla) each independently represents hydrogen; an alkyl group having from 1 to 20 carbon atoms which is unsubstituted or substituted;
or
R¹⁹ and R²⁰ together may form an aliphatic ring which is unsubstituted or substituted; and the dotted lines are bonding sites.
Ring B₁ is a substituted aromatic group having 6 to 30 ring carbon atoms substituted by at least one group R²⁶, or a substituted heteroaromatic group having 5 to 30 ring atoms substituted by at least one group R²⁶;
R²⁶ represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; an alkylhalide group having from 1 to 20 carbon atoms which is unsubstituted or substituted; a cycloalkyl group having from 3 to 20 ring carbon atoms which is unsubstituted or substituted; CN; OR⁵¹; SR⁵²; BR⁵³R⁵⁴; SiR⁵⁵R⁵⁶R⁵⁷ or halogen. Preferred groups R²⁶ are the groups mentioned below in the definition of R^{26b}.

The ring B₁ 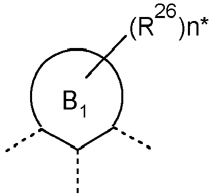 in formula (I) preferably represents an aromatic group having 6 to 30 ring carbon atoms, preferably 6 to 18 ring carbon atoms, or a heteroaromatic group having 5 to 30 ring atoms, preferably 5 to 18 ring atoms, and the definition of R²⁶ is mentioned above.
n* is 1, 2 or 3, preferably 1 or 2, more preferably 1.

The ring 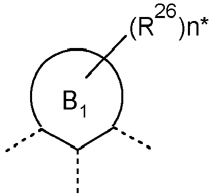 is more preferably represented by a group of formula (VIII) 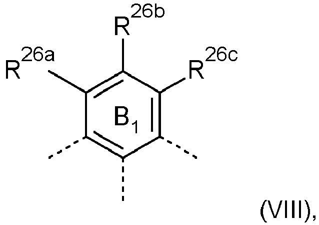 wherein
R^{26a}, R^{26b} and R^{26c} each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; an alkylhalide group having from 1 to 20 carbon atoms which is unsubstituted or substituted; a cycloalkyl group having from 3 to 20 ring carbon atoms which is unsubstituted or substituted; CN; NR⁴⁹R⁵⁰; OR⁵¹; SR⁵²; BR⁵³R⁵⁴; SiR⁵⁵R⁵⁶R⁵⁷ or halogen;
   and/or
two adjacent residues R^{26a}, R^{26b} and/or R^{26c} together may form a ring which is unsubstituted or substituted;
preferably, R^{26a}, R^{26b} and R^{26c} each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; or NR⁴⁹R⁵⁰;
more preferably, two of R^{26a}, R^{26b} and R^{26c} represent hydrogen, and the remaining of R^{26a}, R^{26b} and R^{26c} represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; or NR⁴⁹R⁵⁰; preferably an alkyl group having from 1 to 20 carbon atoms which is unsubstituted or substituted; more preferably an unsubstituted alkyl group having from 1 to 8 carbon atoms;
most preferably, R^{26b} does not represent hydrogen and preferably represents an alkyl group having from 1 to 20 carbon atoms which is unsubstituted or substituted; more preferably an unsubstituted alkyl group having from 1 to 8 carbon atoms, or a cycloalkyl group having from 3 to 20 ring atoms, preferably a cycloalkyl group having 5 or 6 ring atoms or an adamantyl group.

More preferably, the ring B₁ is therefore represented by a group of formula (Villa) 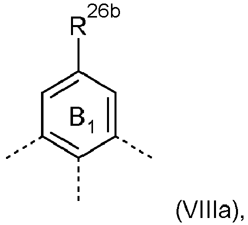 wherein the residue R^{26b} is defined above.
X represents NR_{EX}, O, S, SiR⁴⁴R⁴⁵, or CR⁴⁶R⁴⁷; preferably NR_{EX}, O, or S; more preferably NR_{EX}.
Y represents NR_{EY}, O, S, SiR⁴⁴R⁴⁵, or CR⁴⁶R⁴⁷; preferably NR_{EY}, O, or S; more preferably NR_{EY}.
R_{EX} preferably represents a group of formula (V) 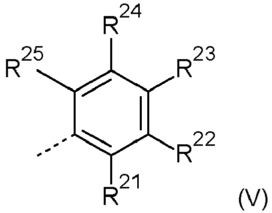
wherein R²¹, R²², R²³, R²⁴, and R²⁵ each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; an alkylhalide group having from 1 to 20 carbon atoms which is unsubstituted or substituted; a cycloalkyl group having from 3 to 20 ring carbon atoms which is unsubstituted or substituted; CN; NR⁴⁹R⁵⁰; OR⁵¹; SR⁵²; BR⁵³R⁵⁴; SiR⁵⁵R⁵⁶R⁵⁷ or halogen;
   and/or
two adjacent residues R²¹, R²², R²³, R²⁴ and/or R²⁵ together may form a ring which is unsubstituted or substituted;
preferably, R²¹, R²², R²³, R²⁴, and R²⁵ each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; or NR⁴⁹R⁵⁰;
   and/or
two adjacent residues R²³ and R²⁴ together may form an aliphatic ring which is unsubstituted or substituted; and
the dotted line is a bonding site.

More preferably, at least two of R²¹, R²², R²³, R²⁴, and R²⁵ represent hydrogen, and the remaining of R²¹, R²², R²³, R²⁴, and R²⁵ each independently represents hydrogen, an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; or NR⁴⁹R⁵⁰; preferably an alkyl group having from 1 to 20 carbon atoms which is unsubstituted or substituted; more preferably an unsubstituted alkyl group having from 1 to 8 carbon atoms;
and/or
two adjacent residues R²³ and R²⁴ together may form an aliphatic ring which is unsubstituted or substituted;
most preferably, at least one of R²¹, R²², R²³, R²⁴, and R²⁵ does not represent hydrogen; further most preferably, at least R²³ does not represent hydrogen.

The dotted line is a bonding site.

Further most preferably, R_{EX} represents a group of formula (Vc) 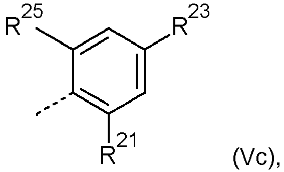 wherein the residues R²¹, R²³, and R²⁵ are defined above. The dotted line is a bonding site.

R_{EY} preferably represents a group of formula (VI) 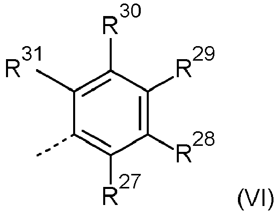 wherein R²⁷, R²⁸, R²⁹, R³⁰, and R³¹ each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; an alkylhalide group having from 1 to 20 carbon atoms which is unsubstituted or substituted; a cycloalkyl group having from 3 to 20 ring carbon atoms which is unsubstituted or substituted; CN; NR⁴⁹R⁵⁰; OR⁵¹; SR⁵²; BR⁵³R⁵⁴; SiR⁵⁵R⁵⁶R⁵⁷ or halogen;
and/or
two adjacent residues R²⁷, R²⁸, R²⁹, R³⁰ and/or R³¹ together may form a ring which is unsubstituted or substituted;
preferably, R²⁷, R²⁸, R²⁹, R³⁰, and R³¹ each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; or NR⁴⁹R⁵⁰;
   and/or
two adjacent residues R²⁹ and R³⁰ together may form an aliphatic ring which is unsubstituted or substituted; and
the dotted line is a bonding site.

More preferably, at least two of R²⁷, R²⁸, R²⁹, R³⁰, and R³¹ represent hydrogen, and the remaining of R²⁷, R²⁸, R²⁹, R³⁰, and R³¹ each independently represents hydrogen, an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; or NR⁴⁹R⁵⁰; preferably an alkyl group having from 1 to 20 carbon atoms which is unsubstituted or substituted; more preferably an unsubstituted alkyl group having from 1 to 8 carbon atoms;
and/or
two adjacent residues R²⁹ and R³⁰ together may form an aliphatic ring which is unsubstituted or substituted;
most preferably, at least one of R²⁷, R²⁸, R²⁹, R³⁰, and R³¹ does not represent hydrogen; further most preferably, at least R²⁹ does not represent hydrogen.

The dotted line is a bonding site.

Further most preferably, R_{EY} represents a group of formula (Vlc) 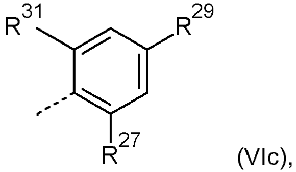 wherein the residues R²⁷, R²⁹, and R³¹ are defined above. The dotted line is a bonding site.

In a further preferred embodiment, R_{EX} represents a group of formula (Va) or a group of formula (Vb) 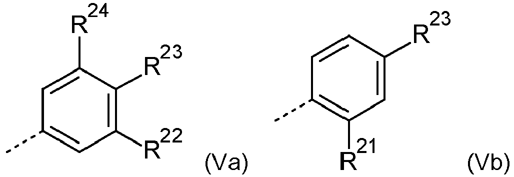 and/or
R_{EY} represents a group of formula (VIa) or a group of formula (Vlb) 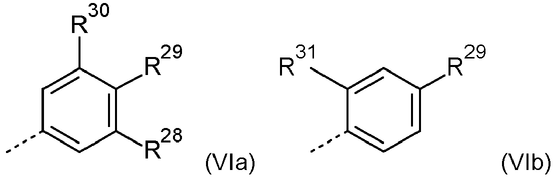 wherein
R²³ in the group of formula (Va) is An; and/or
R²⁹ group of formula (Vla) is Ar₂;
   and/or
R²¹ in the group of formula (Vb) is Ar₃; and/or
R³¹ group of formula (Vlb) is Ar₄.
Ar₁, Ar₂, Ar₃, and Ar₄ are each independently an aryl group having from 6 to 30 ring carbon atoms which is unsubstituted or substituted; or a heteroaryl group having from 5 to 30 ring atoms which is unsubstituted or substituted; preferably aryl group having from 6 to 18 ring carbon atoms which is unsubstituted or substituted; or a heteroaryl group having from 5 to 18 ring atoms which is unsubstituted or substituted;
   wherein
Ar₁ or a substituent at Ar₁ may be fused to R²², and/or
Ar₂ or a substituent at Ar₂ may be fused to R²⁸,
   wherein
R²⁴ is preferably hydrogen if Ar₁ is fused to R²², and/or
R³⁰ is preferably hydrogen if Ar₂ is fused to R²⁸;
R²² and R²⁴ in formula (Va), R²⁸ and R³⁰ in formula (Vla), R²³ in formula (Vb) and R²⁹ in formula (Vb) each independently represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; or NR⁴⁹R⁵⁰; and
the dotted lines are bonding sites.

Preferably, R²² and R²⁴ in formula (Va), R²⁸ and R³⁰ in formula (Vla), R²³ in formula (Vb) and R²⁹ in formula (Vb)
each independently represents an alkyl group having from 1 to 20 carbon atoms which is unsubstituted or substituted; or a cycloalkyl group having from 3 to 20 ring carbon atoms which is unsubstituted or substituted.

More preferably, R²² and R²⁴ in formula (Va), R²⁸ and R³⁰ in formula (Vla), R²³ in formula (Vb) and R²⁹ in formula (Vb)
each independently represents an alkyl group having from 1 to 8 carbon atoms which is unsubstituted or substituted; or a cycloalkyl group having 5 or 6 ring carbon atoms or an adamantyl group which is unsubstituted or substituted.

Preferably, Ar₁, Ar₂, Ar₃ and Ar₄ each independently represents 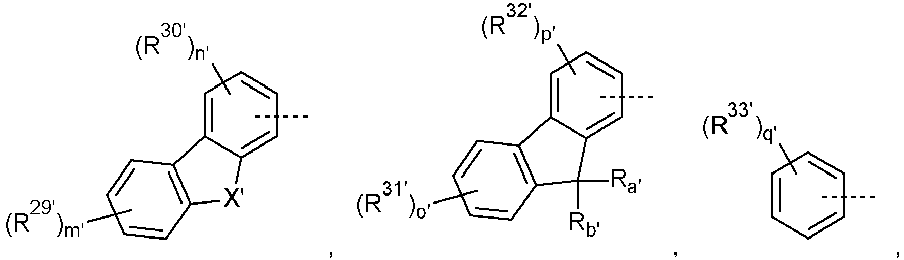 wherein
X' is O, S, NR^{34'}, preferably O;
R_{a'} and R_{b'} each independently represents hydrogen, an alkyl group having from 1 to 20 carbon atoms which is unsubstituted or substituted; an aryl group having from 6 to 30 ring carbon atoms which is unsubstituted or substituted; a heteroaryl group having from 5 to 30 ring atoms which is unsubstituted or substituted;
R_{a'} and R_{b'} together form a ring structure which is unsubstituted or substituted;
R^{29'}, R^{30'}, R^{31'}, R^{32'}, R^{33'}and R^{34'} each independently represents an alkyl group having from 1 to 20 carbon atoms which is unsubstituted or substituted; a cycloalkyl group having from 3 to 20 ring carbon atoms which is unsubstituted or substituted; an aryl group having from 6 to 30 ring carbon atoms which is unsubstituted or substituted; or a heteroaryl group having from 5 to 30 ring atoms which is unsubstituted or substituted;
q' represents 0, 1, 2, 3, 4 or 5, preferably 0, 1 or 2, more preferably 0 or 1;
m' and o' each independently represents 0, 1, 2, 3 or 4, preferably 0 or 1, more preferably 0;
n' and p' each independently represents 0, 1, 2 or 3, preferably 0 or 1, more preferably 0;
   and
the dotted lines are bonding sites.

More preferred groups R_{EX} are therefore groups (Vaa) and (Vba) 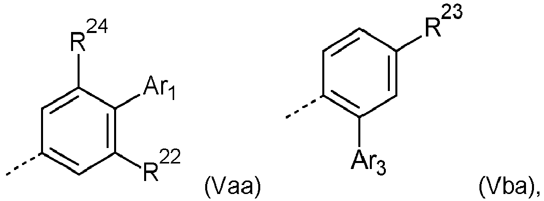 wherein Ar₁, Ar₃, R²², R²³ and R²⁴ are defined above.

More preferred groups R_{EY} are therefore groups (Vlaa) and (Vlba) 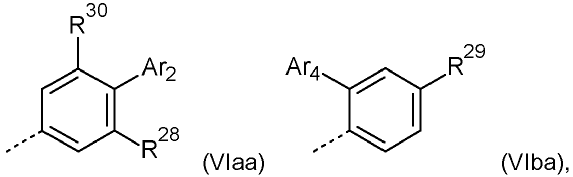 wherein Ar₂, Ar₄, R²⁸, R²⁹ and R³⁰ are defined above.

The dotted lines are bonding sites.

Rₓ represents an aryl group having from 6 to 30 ring carbon atoms which is unsubstituted or substituted; a heteroaryl group having from 5 to 30 ring atoms which is unsubstituted or substituted; preferably an aryl group having from 6 to 30 ring carbon atoms which is unsubstituted or substituted; more preferably an aryl group having from 6 to 18 ring carbon atoms which is unsubstituted or substituted.

Most preferably, Rₓ represents a group of formula (III) 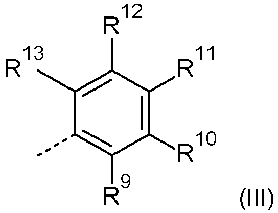
wherein R⁹, R¹⁰, R¹¹, R¹², and R¹³ each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; an alkylhalide group having from 1 to 20 carbon atoms which is unsubstituted or substituted; a cycloalkyl group having from 3 to 20 ring carbon atoms which is unsubstituted or substituted; CN; NR⁴⁹R⁵⁰; OR⁵¹; SR⁵²; BR⁵³R⁵⁴; SiR⁵⁵R⁵⁶R⁵⁷ or halogen;
   and/or
two adjacent residues R⁹, R¹⁰, R¹¹, R¹² and/or R¹³ together may form a ring which is unsubstituted or substituted;
preferably, R⁹, R¹⁰, R¹¹, R¹², and R¹³ each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; or NR⁴⁹R⁵⁰;
   and/or
two adjacent residues R¹⁰ and R¹¹ together may form an aliphatic ring which is unsubstituted or substituted;
more preferably, at least two of R⁹, R¹⁰, R¹¹, R¹², and R¹³ represent hydrogen, and the remaining of R⁹, R¹⁰, R¹¹, R¹², and R¹³ each independently represents hydrogen, an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; or NR⁴⁹R⁵⁰; preferably an alkyl group having from 1 to 20 carbon atoms which is unsubstituted or substituted; more preferably an unsubstituted alkyl group having from 1 to 8 carbon atoms;
   and/or
two adjacent residues R¹⁰ and R¹¹ together may form an aliphatic ring which is unsubstituted or substituted;
most preferably, at least one of R⁹, R¹⁰, R¹¹, R¹², and R¹³ does not represent hydrogen; further most preferably, at least R¹¹ does not represent hydrogen.

The dotted line is a bonding site.

Further most preferably, Rₓ represents a group of formula (Illa) 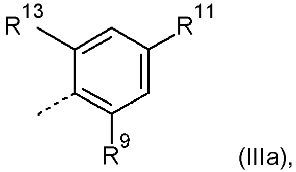 wherein the residues R⁹, R¹¹, and R¹³ are defined above. The dotted line is a bonding site.

R_{y} and R⁴⁸ each independently represents a group of formula (IV) 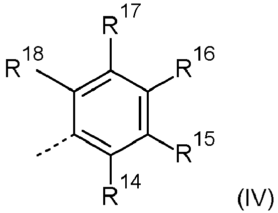
wherein R¹⁴, R¹⁵, R¹⁶, R¹⁷, and R¹⁸ each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; an alkylhalide group having from 1 to 20 carbon atoms which is unsubstituted or substituted; a cycloalkyl group having from 3 to 20 ring carbon atoms which is unsubstituted or substituted; CN; NR⁴⁹R⁵⁰; OR⁵¹; SR⁵²; BR⁵³R⁵⁴; SiR⁵⁵R⁵⁶R⁵⁷ or halogen;
   and/or
two adjacent residues R¹⁴, R¹⁵, R¹⁶, R¹⁷ and/or R¹⁸ together may form a ring which is unsubstituted or substituted;
preferably, R¹⁴, R¹⁵, R¹⁶, R¹⁷, and R¹⁸ each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted;
more preferably, R¹⁴, R¹⁵, R¹⁶, R¹⁷, and R¹⁸ each independently represents hydrogen; or an alkyl group having from 1 to 20 carbon atoms which is unsubstituted or substituted;
most preferably, at least two, preferably at least three, more preferably at least four of R¹⁴, R¹⁵, R¹⁶, R¹⁷, and R¹⁸ represent hydrogen, and the remaining of R¹⁴, R¹⁵, R¹⁶, R¹⁷, and R¹⁸ each independently represents hydrogen; or an alkyl group having from 1 to 20 carbon atoms which is unsubstituted or substituted;
   and
the dotted line is a bonding site.

Further most preferably, R_{y} and R⁴⁸ are unsubstituted phenyl.

Z represents a group of formula (IIa), (Ilb) or (lIc), preferably a group of formula (IIa) or (IIc), more preferably a group of formula (Ila) 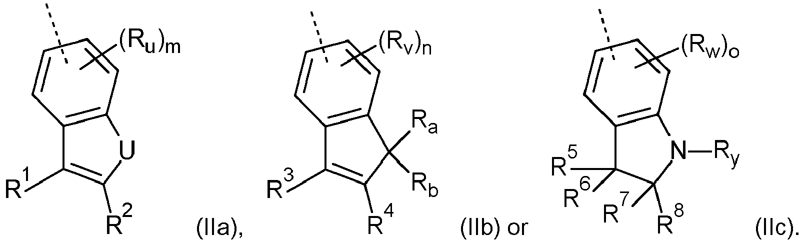
R¹, R², R³ and R⁴ each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted;
   or
R¹ and R² or R³ and R⁴ can form a ring, preferably an aromatic ring, which is unsubstituted or substituted;
preferably, R¹, R², R³ and R⁴ each independently represents hydrogen; an aryl group having from 6 to 18 ring carbon atoms which is unsubstituted or substituted; a heteroaryl group having from 5 to 18 ring atoms which is unsubstituted or substituted; an alkyl group having from 1 to 8 carbon atoms which is unsubstituted or substituted;
   or
R¹ and R² or R³ and R⁴ can form an aromatic ring, preferably an aromatic 6 membered ring, which is unsubstituted or substituted.
U represents NR⁴⁸, O, or S, preferably NR⁴⁸, or O, more preferably NR⁴⁸.
Rₐ and R_{b} each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted;
   or
Rₐ and R_{b} can form a ring which is unsubstituted or substituted;
preferably, Rₐ and R_{b} each independently represents hydrogen; an aryl group having from 6 to 18 ring carbon atoms which is unsubstituted or substituted; a heteroaryl group having from 5 to 18 ring atoms which is unsubstituted or substituted; an alkyl group having from 1 to 8 carbon atoms which is unsubstituted or substituted;
   or
Rₐ and R_{b} can form a 5 or 6 membered ring which is unsubstituted or substituted.
R⁵, R⁶, R⁷ and R⁸ each independently represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; preferably an aryl group having from 6 to 30 ring carbon atoms which is unsubstituted or substituted; or an alkyl group having from 1 to 20 carbon atoms which is unsubstituted or substituted;
   and/or
R⁵ and R⁶, R⁶ and R⁷, R⁷ and R⁸ and/or R⁵ and R⁸, preferably R⁵ and R⁸ and/or R⁶ and R⁷, can form a substituted or unsubstituted aliphatic ring;
preferably, R⁵, R⁶, R⁷ and R⁸ each independently represents an aryl group having from 6 to 18 ring carbon atoms which is unsubstituted or substituted; a heteroaryl group having from 5 to 18 ring atoms which is unsubstituted or substituted; an alkyl group having from 1 to 8 carbon atoms which is unsubstituted or substituted;
   and/or
R⁵ and R⁶, R⁶ and R⁷, R⁷ and R⁸ and/or R⁵ and R⁸, preferably R⁵ and R⁸ and/or R⁶ and R⁷, can form a substituted or unsubstituted aliphatic ring;
more preferably R⁵, R⁶, R⁷ and R⁸ each independently represents an aryl group having from 6 to 18 ring carbon atoms which is unsubstituted or substituted; or an alkyl group having from 1 to 8 carbon atoms which is unsubstituted or substituted;
   and/or
R⁵ and R⁸ and/or R⁶ and R⁷, can form a substituted or unsubstituted aliphatic ring.
Rᵤ, Rᵥ, R_{w} and R_{z} each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; an alkylhalide group having from 1 to 20 carbon atoms which is unsubstituted or substituted; a cycloalkyl group having from 3 to 20 ring carbon atoms which is unsubstituted or substituted; CN; NR⁴⁹R⁵⁰; OR⁵¹; SR⁵²; BR⁵³R⁵⁴; SiR⁵⁵R⁵⁶R⁵⁷ or halogen; preferably hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; NR⁴⁹R⁵⁰;
preferably, Rᵤ, Rᵥ, R_{w} and R_{z} each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; or NR⁴⁹R⁵⁰.
m, n, o and p each independently represents 0, 1, 2, or 3, preferably 0 or 1, more preferably 0;
wherein the further residues, indices and symbols are defined above.

Preferably, Z represents a group of formula (Ilaa), (IIba), (IIca), (Ilab), (Ilbb) or (lIcb), preferably a group of formula (Ilaa), (IIca), (Ilab), or (lIcb), more preferably a group of formula (Ilaa) or (IIab) 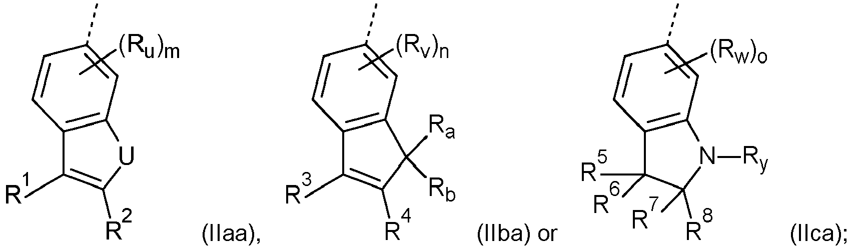 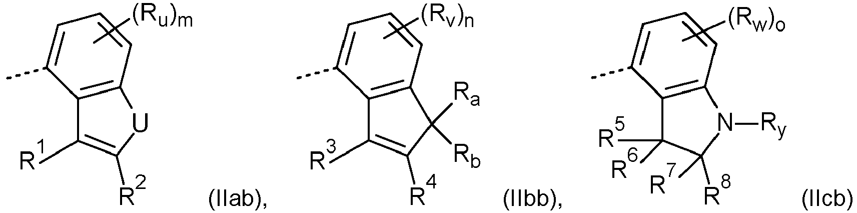 wherein the residues, indices and symbols are defined above, and the dotted lines are bonding sites. Preferably, m, n and o are 0 or 1, more preferably 0.

Preferably, U in the compound of formula (IIa), preferably in the compounds offormula (IIaa) and (Ilab), represents NR⁴⁸, wherein R⁴⁸ is defined above.

R¹ and R² in the group of formula (IIa), preferably in the compounds of formula (IIaa) and (Ilab), preferably together form a ring of formula (IX) 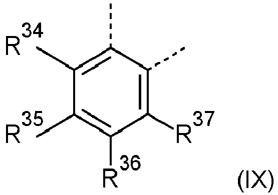
wherein R³⁴, R³⁵, R³⁶, and R³⁷ each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; an alkylhalide group having from 1 to 20 carbon atoms which is unsubstituted or substituted; a cycloalkyl group having from 3 to 20 ring carbon atoms which is unsubstituted or substituted; CN; NR⁴⁹R⁵⁰; OR⁵¹; SR⁵²; BR⁵³R⁵⁴; SiR⁵⁵R⁵⁶R⁵⁷ or halogen;
   and/or
two adjacent residues R³⁴, R³⁵, R³⁶ and/or R³⁷ together may form a ring which is unsubstituted or substituted;
preferably, R³⁴, R³⁵, R³⁶, and R³⁷ each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted;
more preferably, R³⁴, R³⁵, R³⁶, and R³⁷ each independently represents hydrogen; or an alkyl group having from 1 to 20 carbon atoms which is unsubstituted or substituted;
most preferably, R³⁴, R³⁶, and R³⁷ each independently represents hydrogen, and R³⁵ represents hydrogen; or an alkyl group having from 1 to 20 carbon atoms which is unsubstituted or substituted; preferably R³⁵ represents hydrogen; and
the dotted lines are bonding sites.

Most preferably, the group of formula (IX) is therefore represented by a group of formula (IXa) 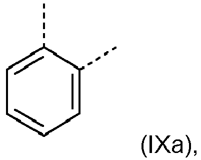 wherein the dotted lines are bonding sites.
R⁴⁹, R⁵⁰, R⁵¹, R⁵², R⁵³, and R⁵⁴ each independently represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted or a cycloalkyl group having from 3 to 20 ring carbon atoms which is unsubstituted or substituted;
   and/or
R⁴⁹ and R⁵⁰ and/or R⁵³ and R⁵⁴ can form a substituted or unsubstituted ring;
preferably, R⁴⁹, R⁵⁰, R⁵¹, R⁵², R⁵³, and R⁵⁴ each independently represents an aryl group having from 6 to 18 ring carbon atoms which is unsubstituted or substituted; a heteroaryl group having from 5 to 18 ring atoms which is unsubstituted or substituted; an alkyl group having from 1 to 8 carbon atoms which is unsubstituted or substituted or a cycloalkyl group having from 5 or 6 ring carbon atoms which is unsubstituted or substituted.
R⁵⁵, R⁵⁶ and R⁵⁷ each independently represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted or a cycloalkyl group having from 3 to 20 ring carbon atoms which is unsubstituted or substituted;
preferably, R⁵⁵, R⁵⁶ and R⁵⁷ each independently represents an aryl group having from 6 to 18 ring carbon atoms which is unsubstituted or substituted; a heteroaryl group having from 5 to 18 ring atoms which is unsubstituted or substituted; an alkyl group having from 1 to 8 carbon atoms which is unsubstituted or substituted or a cycloalkyl group having from 5 or 6 ring carbon atoms which is unsubstituted or substituted.

Preferably, the compound of formula (I) is represented by the following structures (Ia) and (Ib), more preferably by structure (Ia) 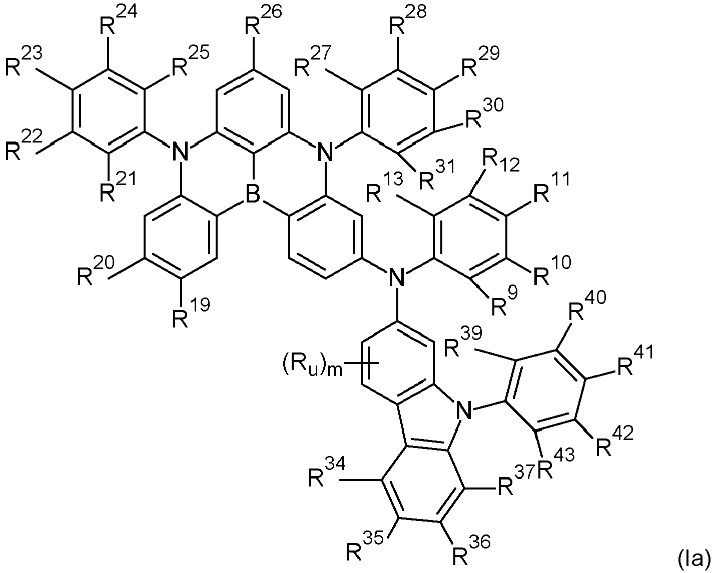 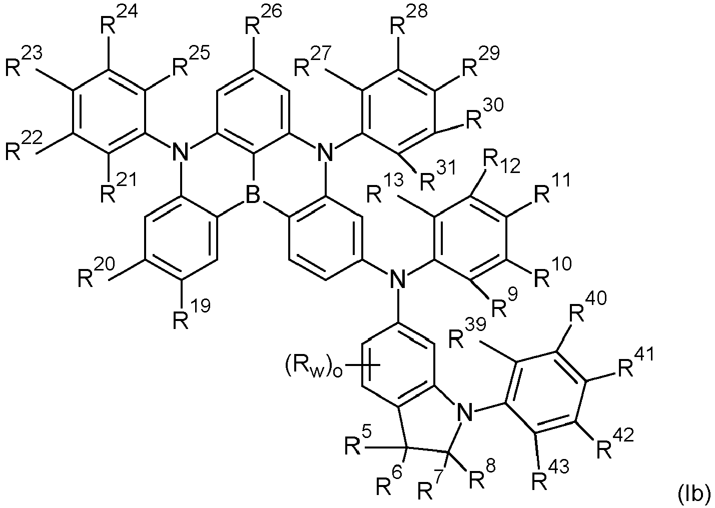 wherein the residues, indices and symbols are defined above.
Preferably, in the compounds of formula (Ia) and (Ib), preferably in the compound of formula (la),
R¹¹, R¹⁹, R²³, R²⁶ and R²⁹ each independently represent an alkyl group having from 1 to 20 carbon atoms which is unsubstituted or substituted; and
R⁹, R¹³, R²¹, R²⁵, R²⁷, R³¹ and R³⁵ each independently represent hydrogen or an alkyl group having from 1 to 20 carbon atoms which is unsubstituted or substituted;
   and/or
R¹⁰ and R¹¹, R¹⁹ and R²⁰, R²³ and R²⁴ and/or R²⁸ and R²⁹ together form an aliphatic ring which may be substituted or unsubstituted, preferably a 6 membered aliphatic ring which may be substituted or unsubstituted;
   and
all remaining residues are preferably hydrogen.

In a further preferred embodiment, the compound of formula (Ia) are represented by the following formulae (laa), (lab), (lac) and (lad), preferably (laa) and (lab): 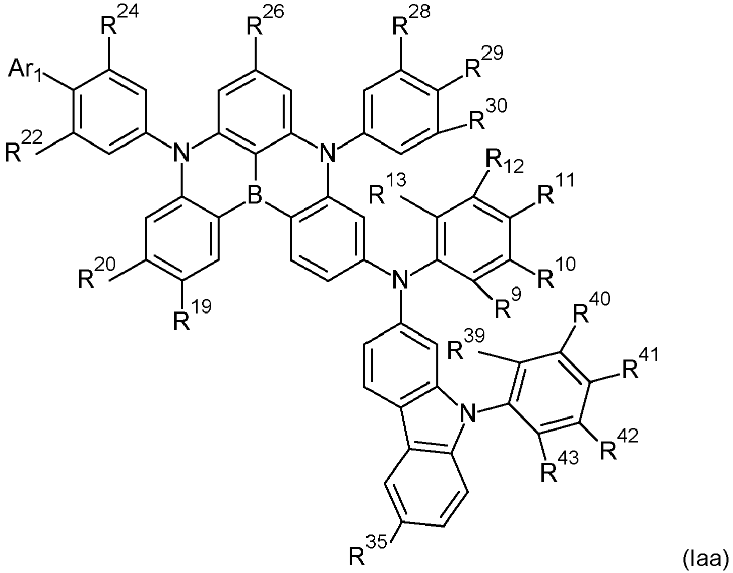 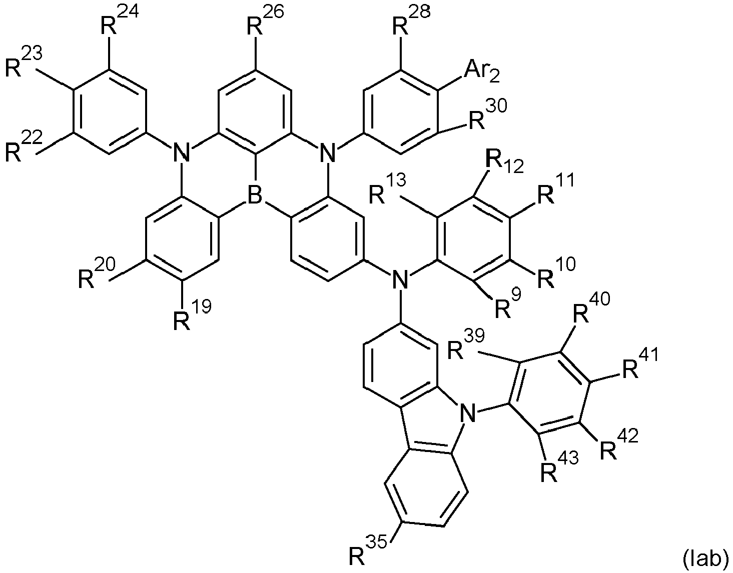 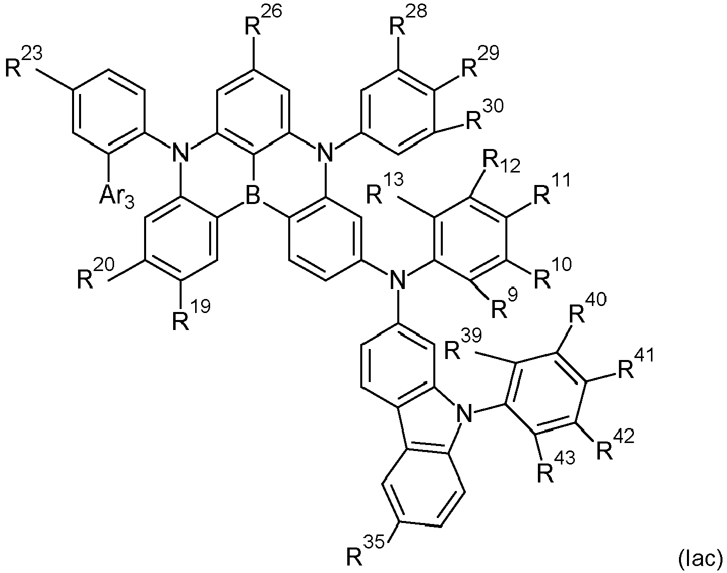 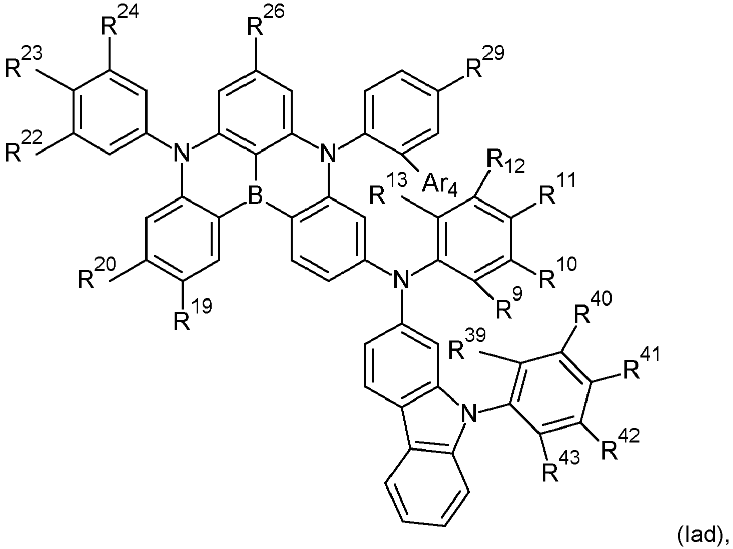 wherein the residues and symbols are defined above.

More preferred compounds of formulae (laa) and (lab) are the following compounds (laa1), (laa2), (laa3), (laa4), (laa5), (laa6), (laa7), (lab1), (lab2), (lab3), (lab4), (lab5), (lab6) and (lab7), preferably compounds (laa2), (laa3), (laa6), (laa7), (lab2), (lab3), (lab6) and (lab7) 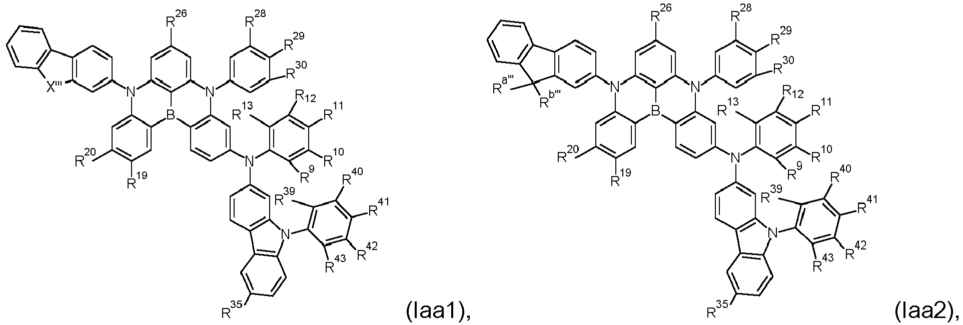 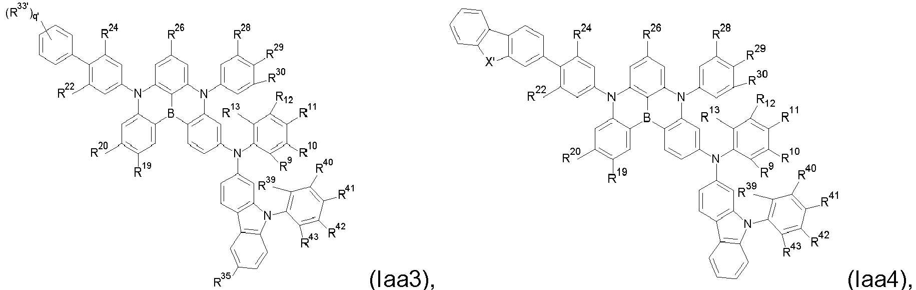 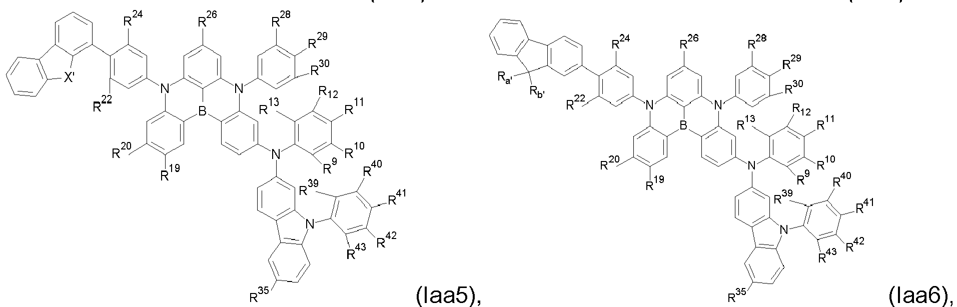 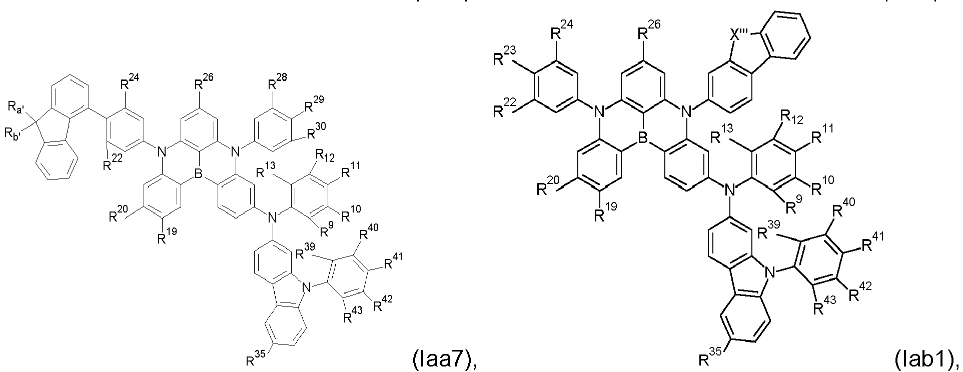 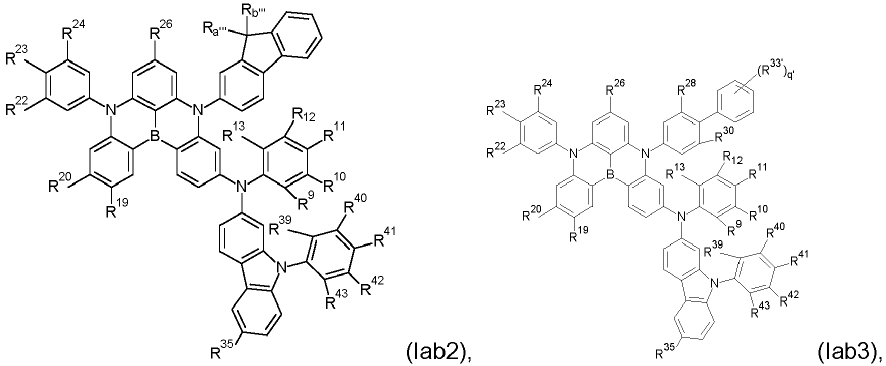 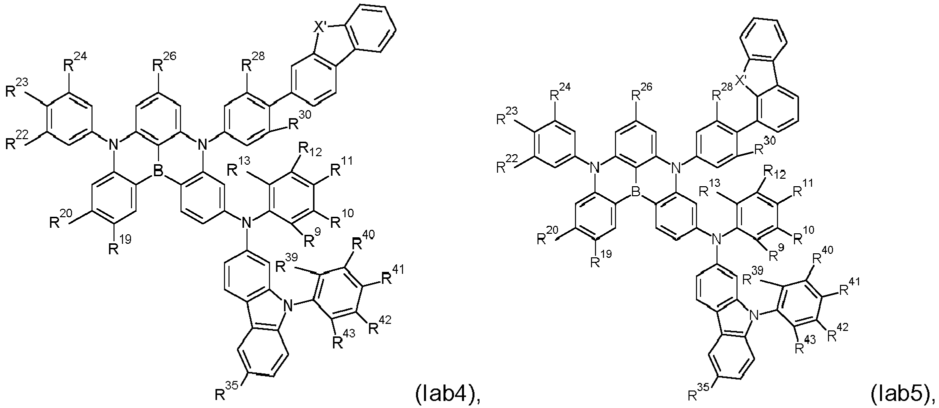 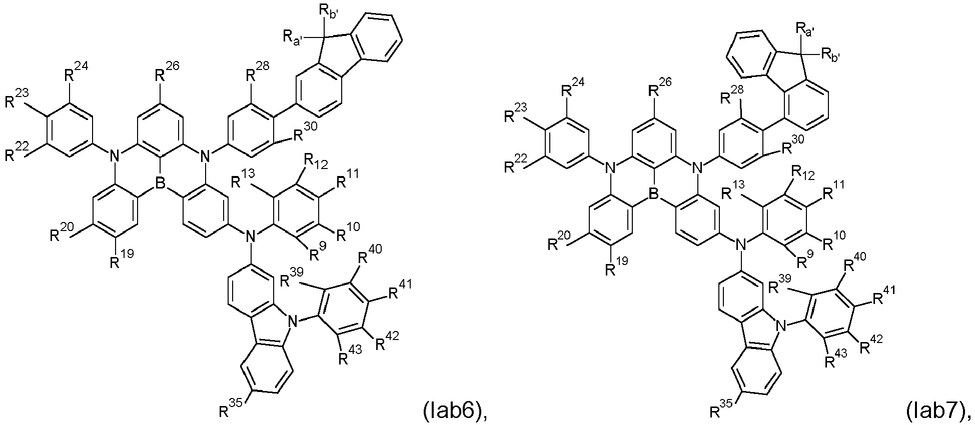 wherein
X‴ is O, S, NR^{34"}, preferably O;
Ra‴ and Rb‴ each independently represents hydrogen, an alkyl group having from 1 to 20 carbon atoms which is unsubstituted or substituted; an aryl group having from 6 to 30 ring carbon atoms which is unsubstituted or substituted; a heteroaryl group having from 5 to 30 ring atoms which is unsubstituted or substituted;
R_{a'} and R_{b'} together form a ring structure which is unsubstituted or substituted;
R^{34"} each independently represents an alkyl group having from 1 to 20 carbon atoms which is unsubstituted or substituted; a cycloalkyl group having from 3 to 20 ring carbon atoms which is unsubstituted or substituted; an aryl group having from 6 to 30 ring carbon atoms which is unsubstituted or substituted; or a heteroaryl group having from 5 to 30 ring atoms which is unsubstituted or substituted; and
the residues and symbols are defined above.

Below, examples for compounds of formula (I) are given:

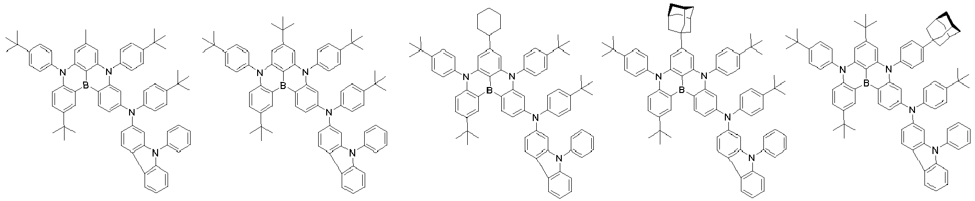

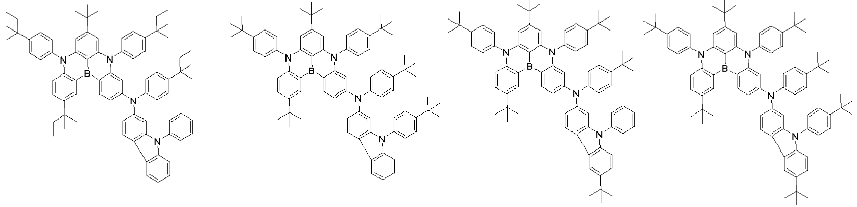

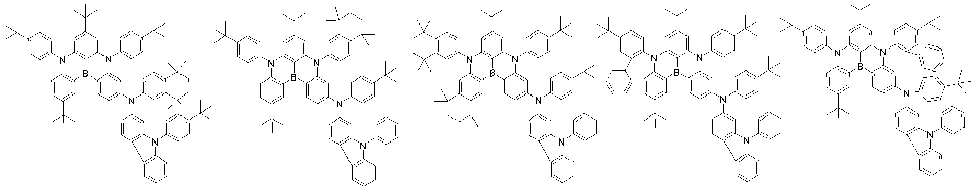

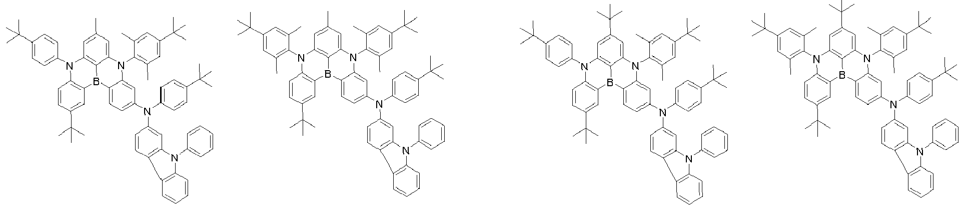

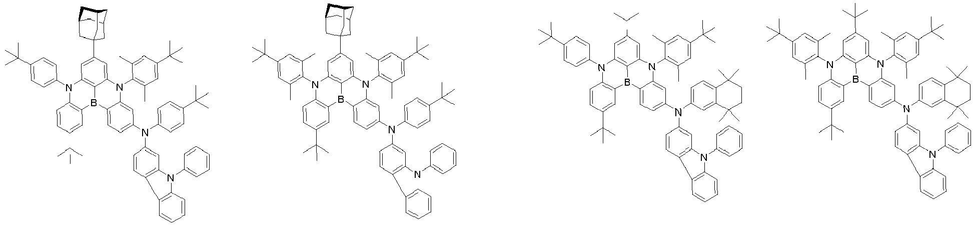

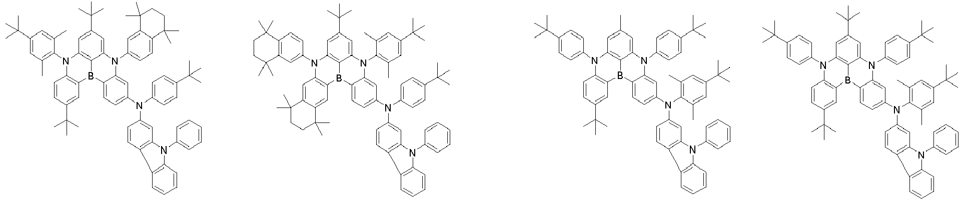

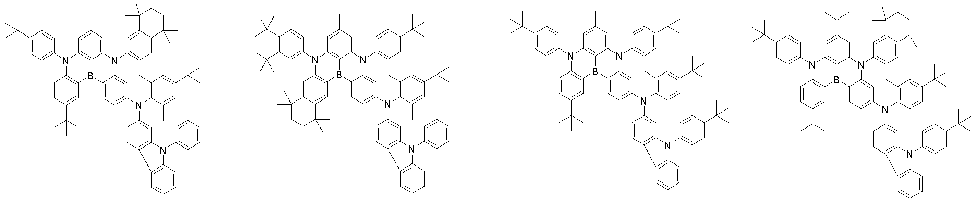

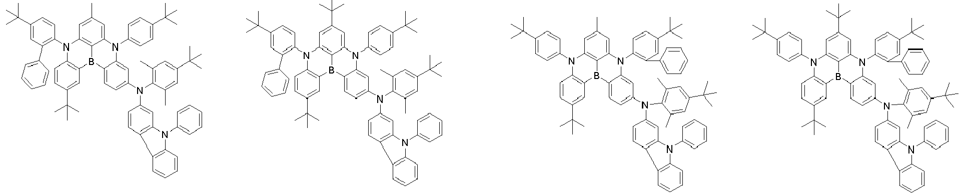

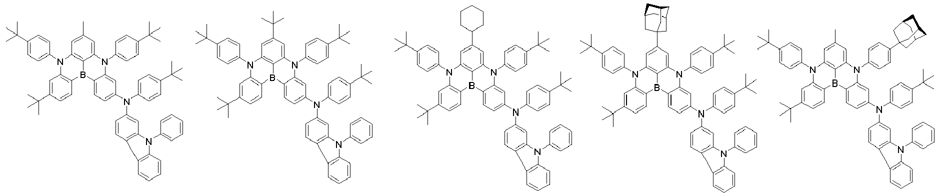

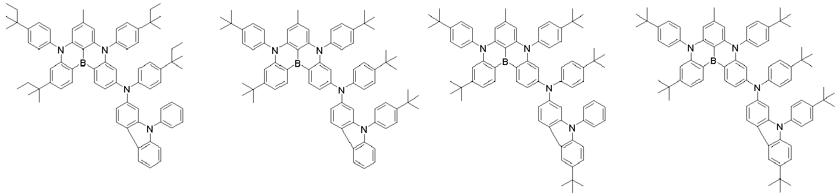

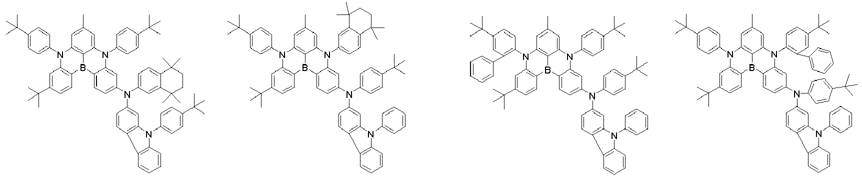

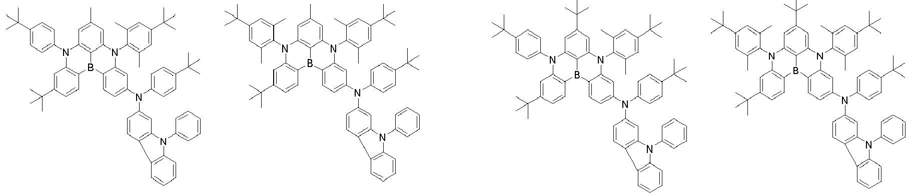

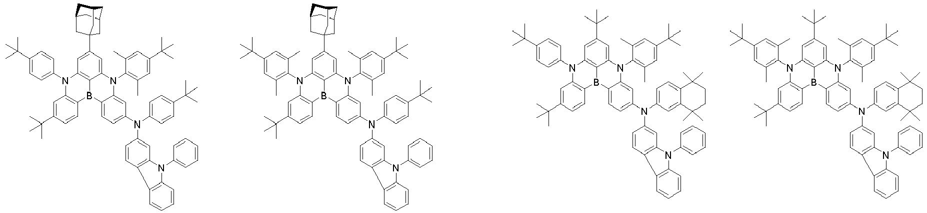

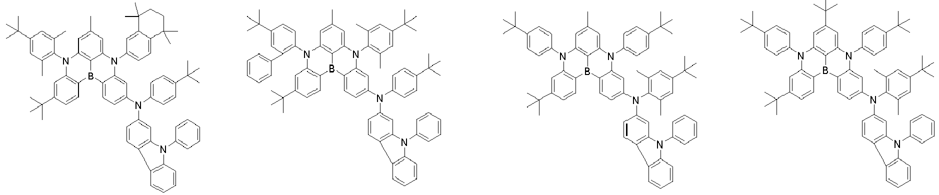

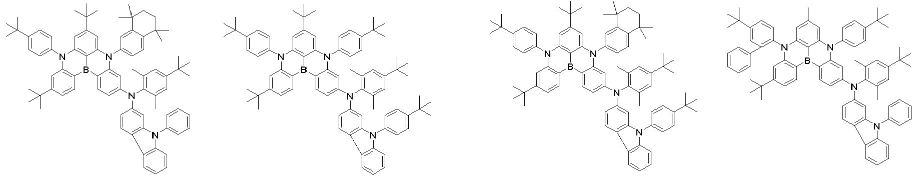

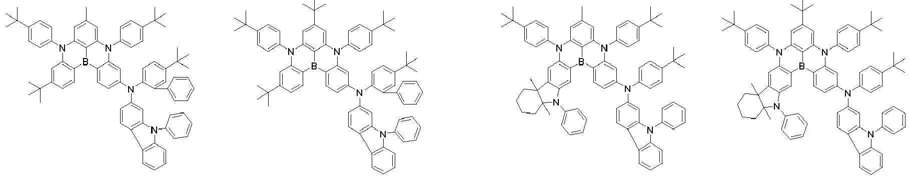

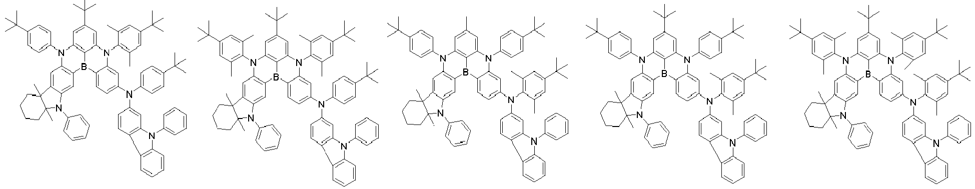

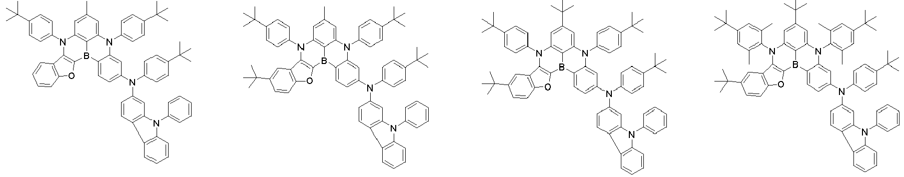

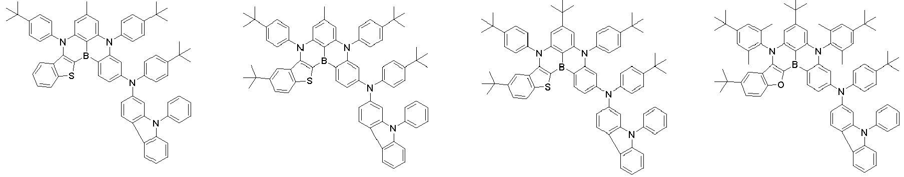

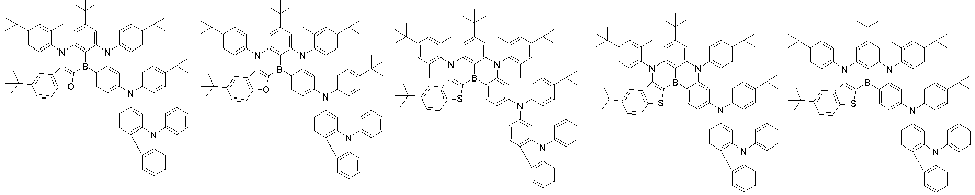

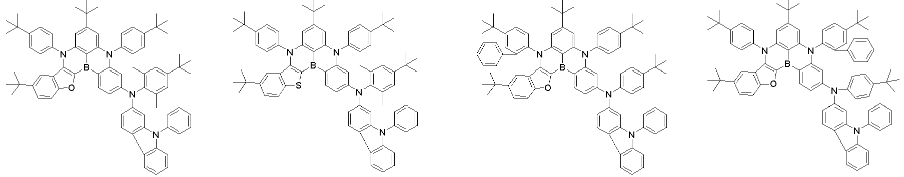

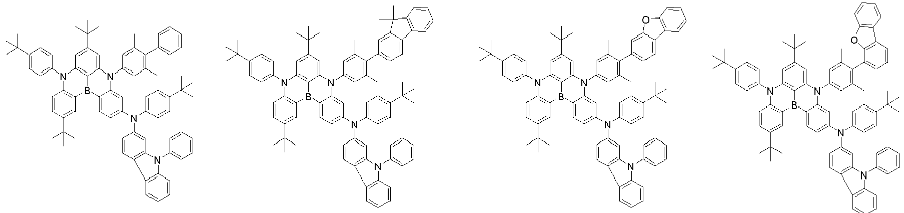

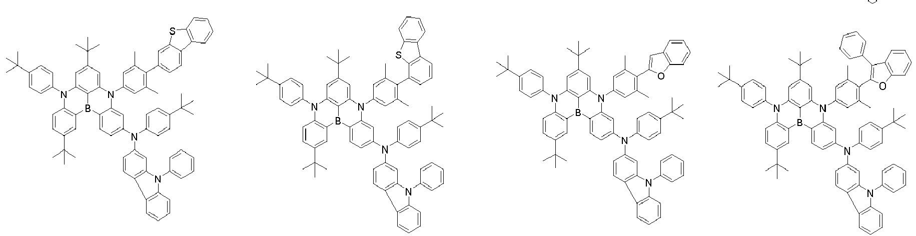

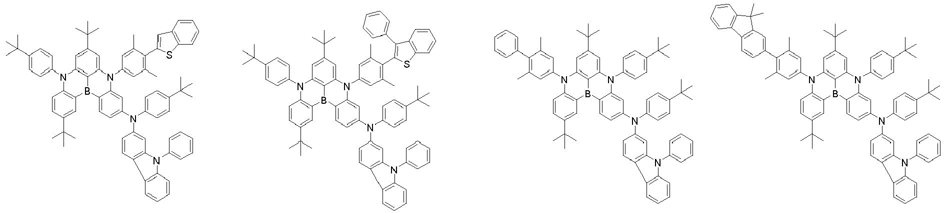

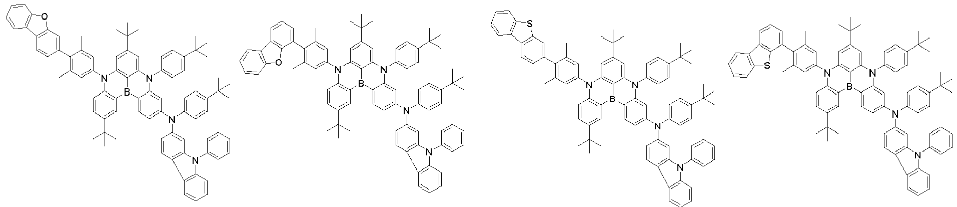

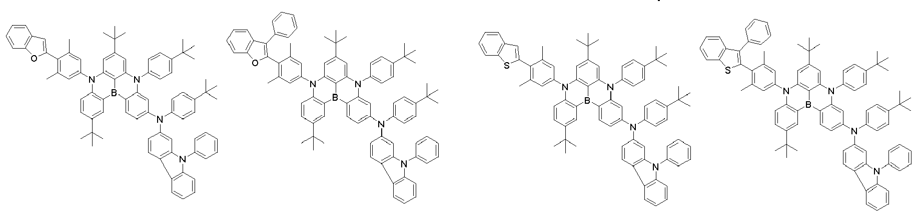

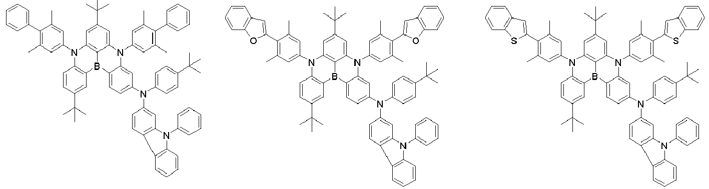

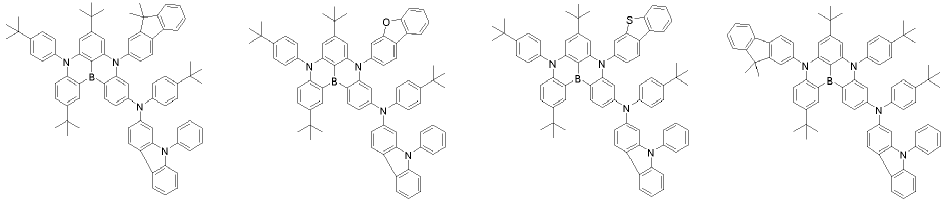

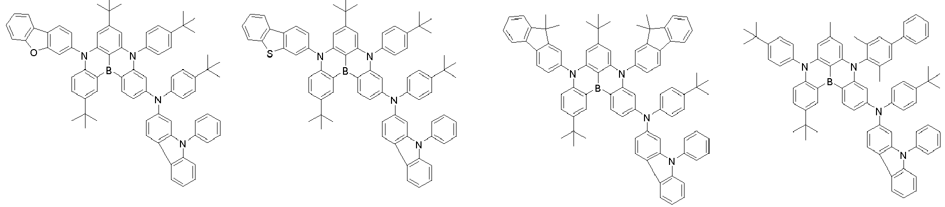

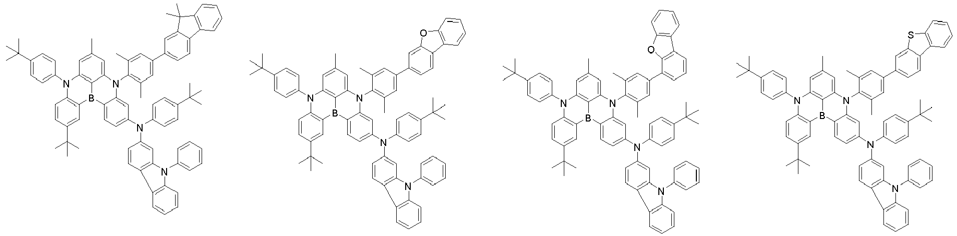

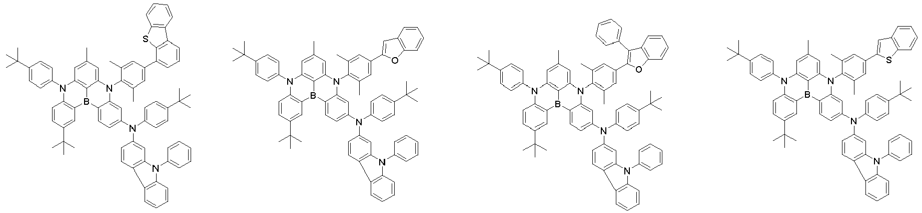

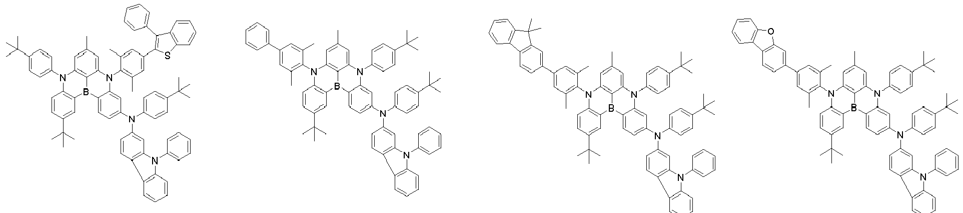

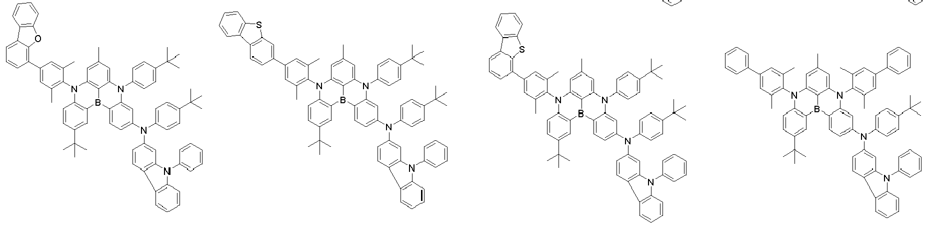

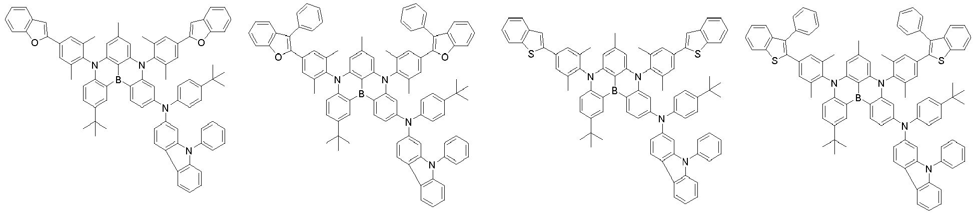

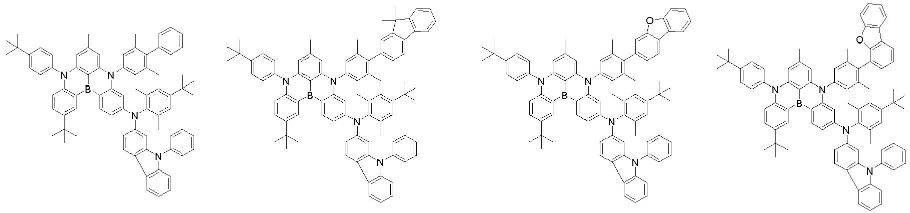

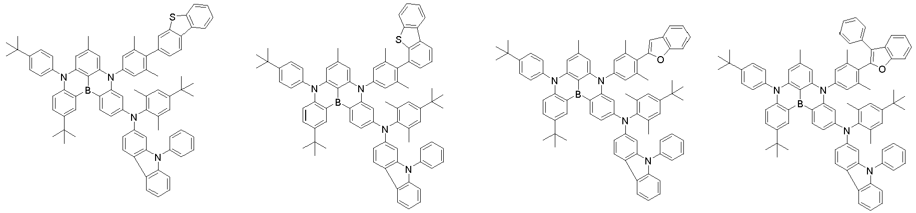

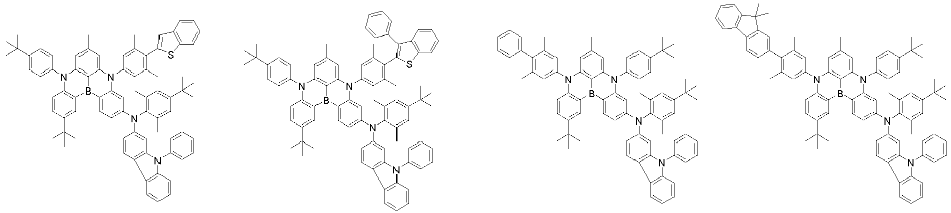

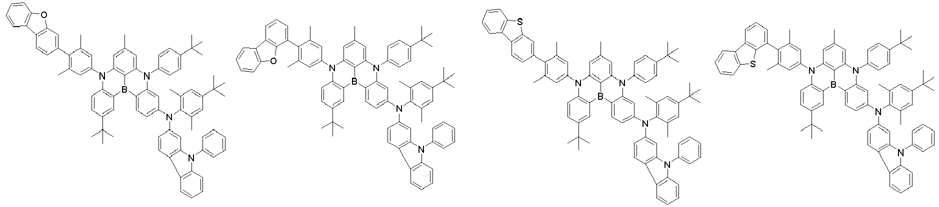

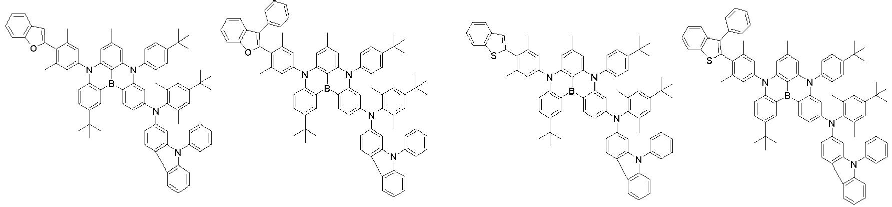

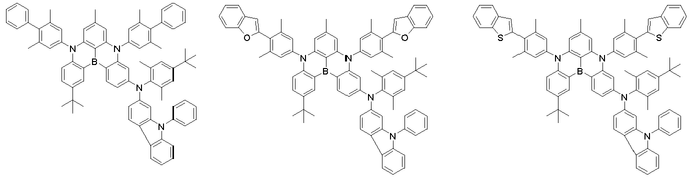

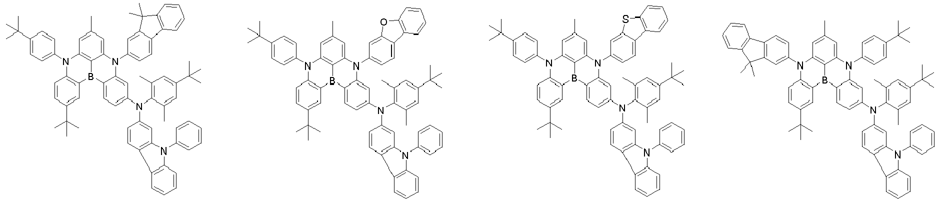

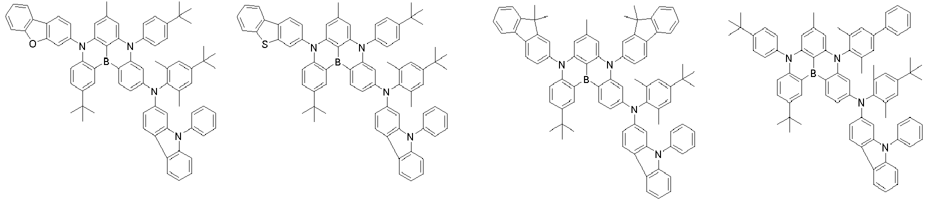

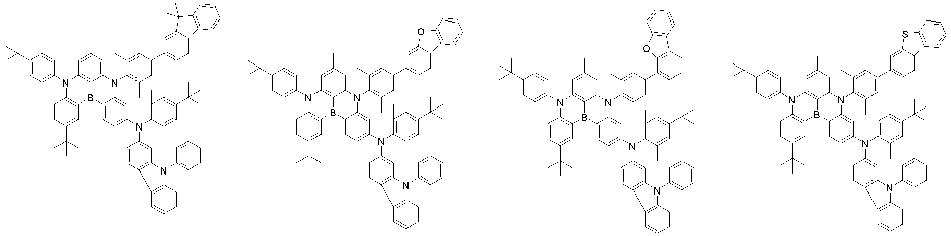

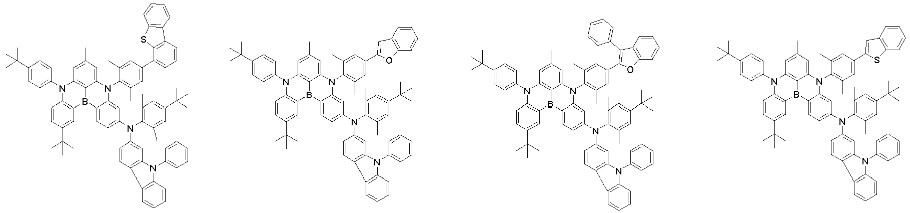

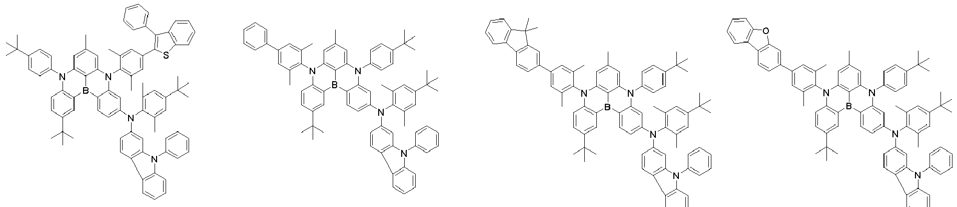

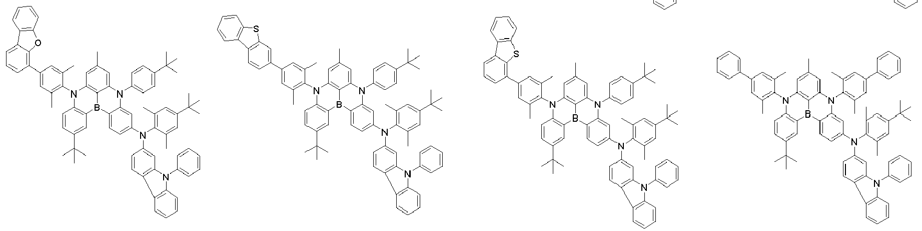

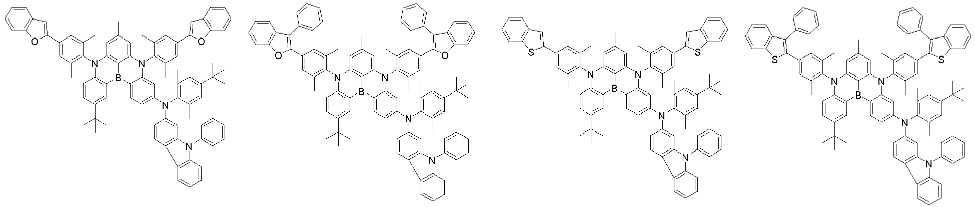

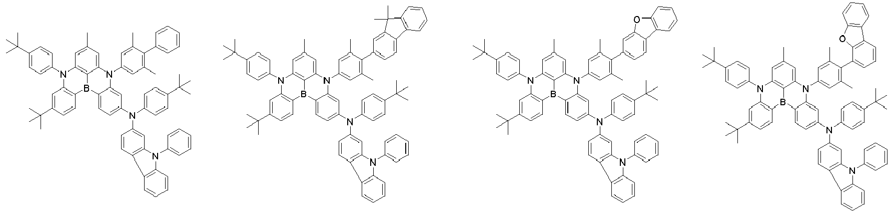

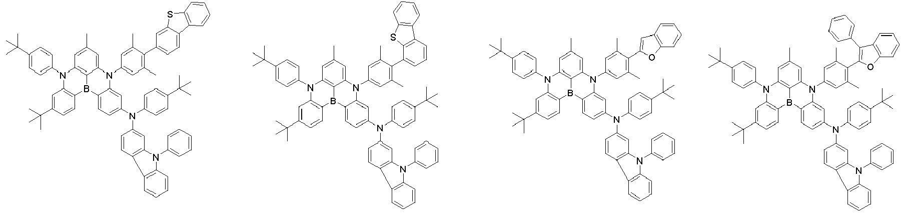

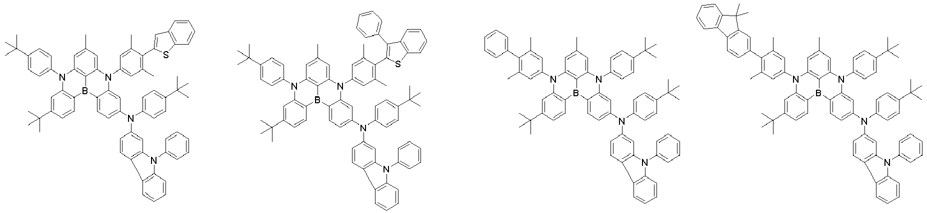

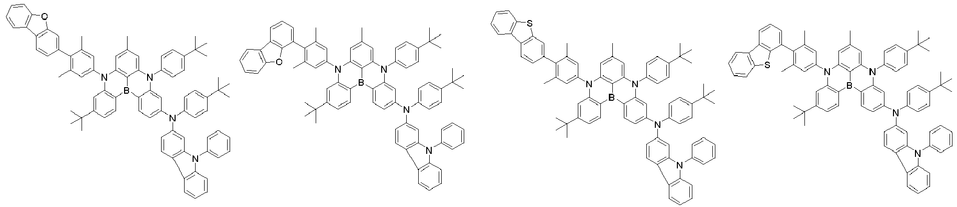

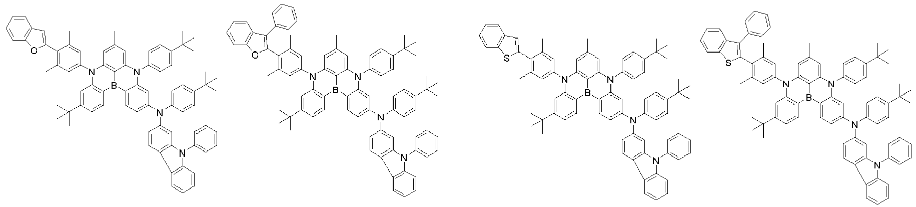

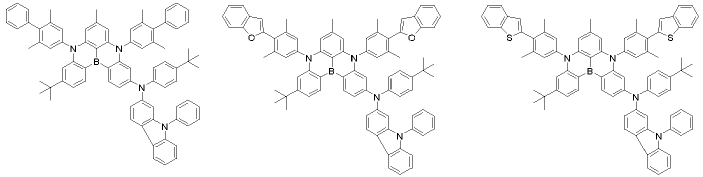

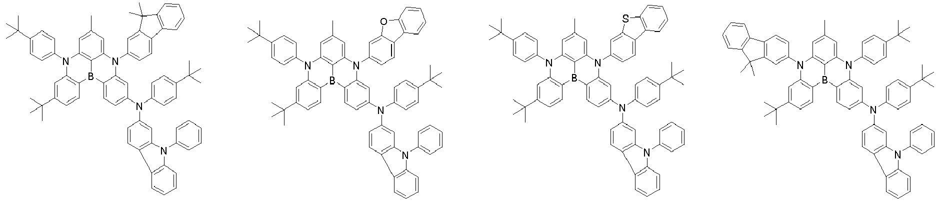

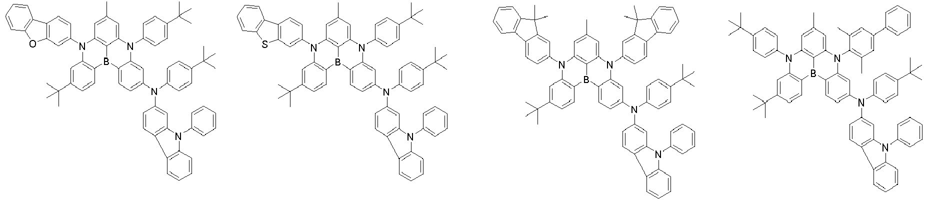

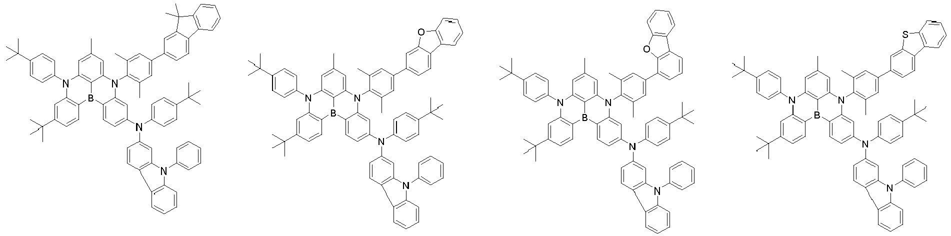

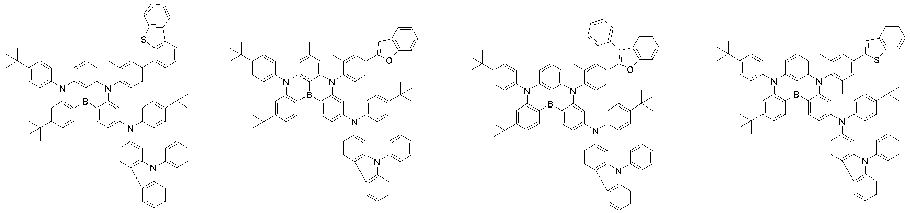

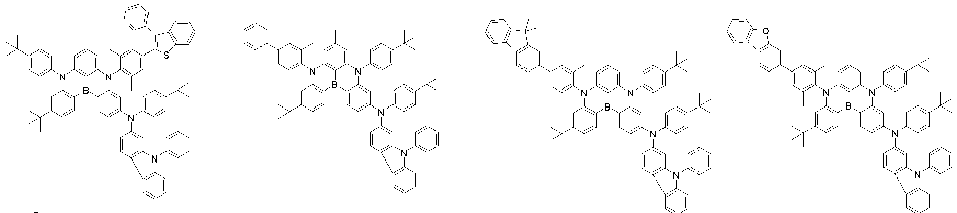

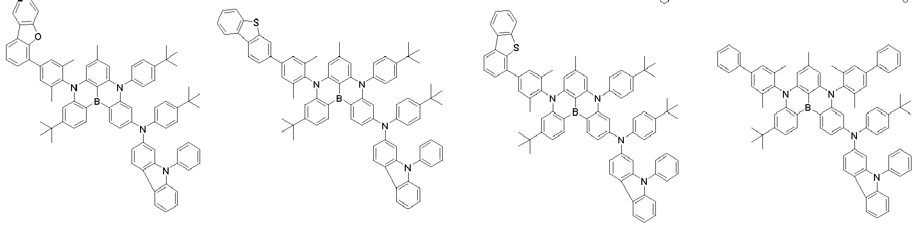

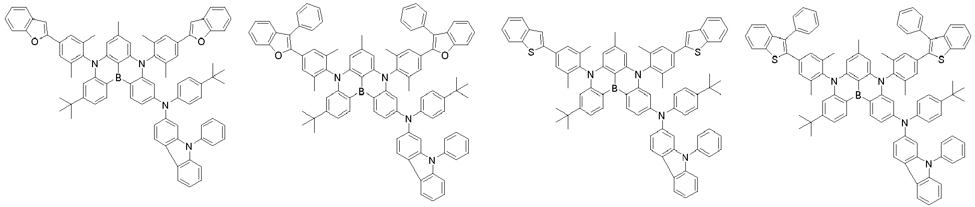

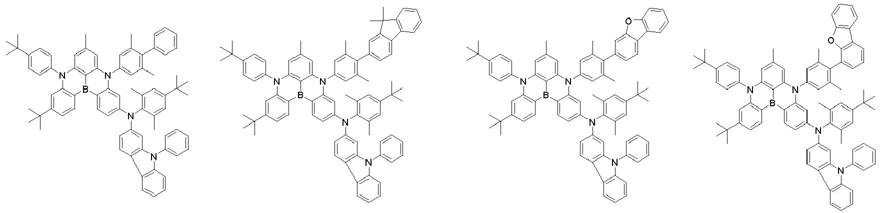

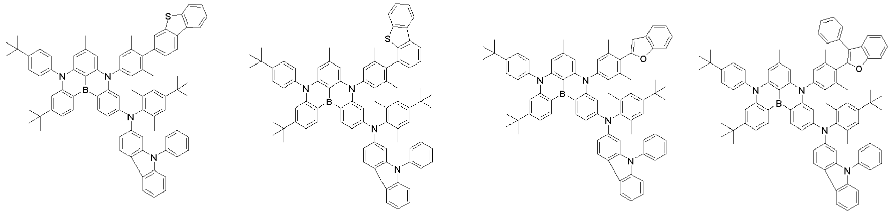

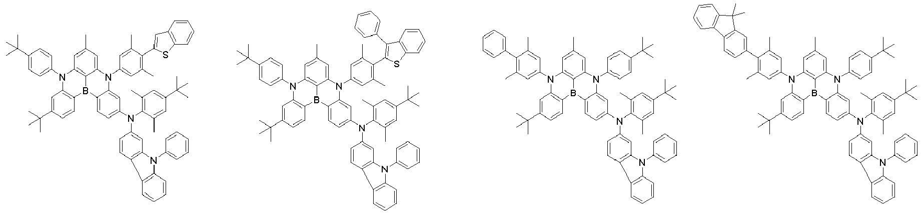

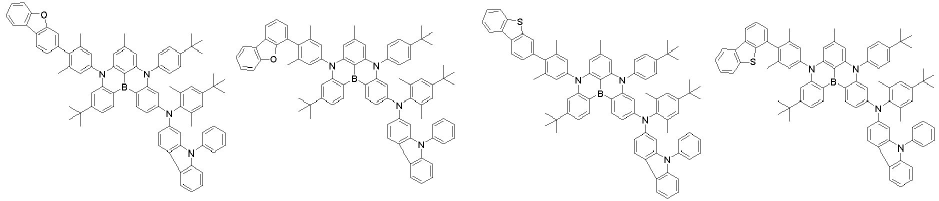

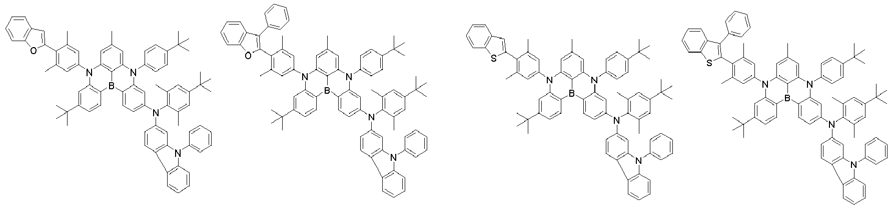

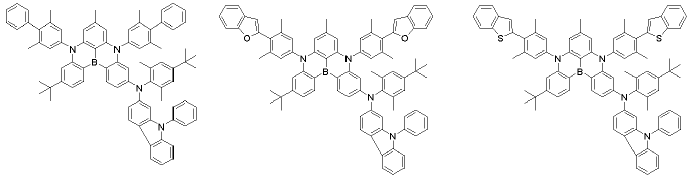

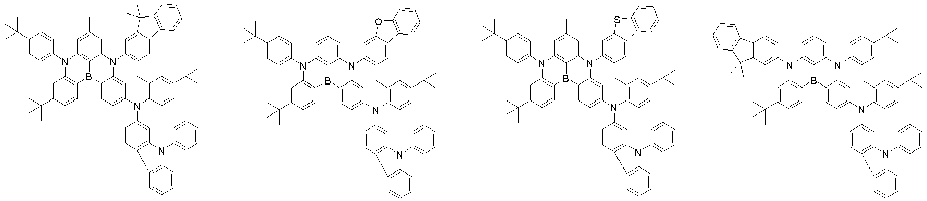

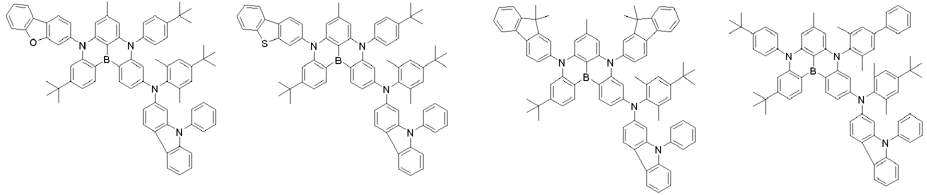

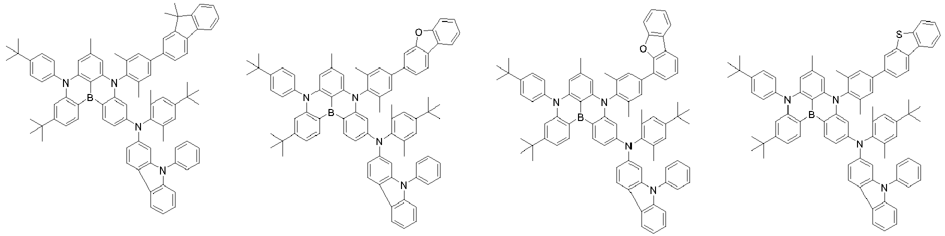

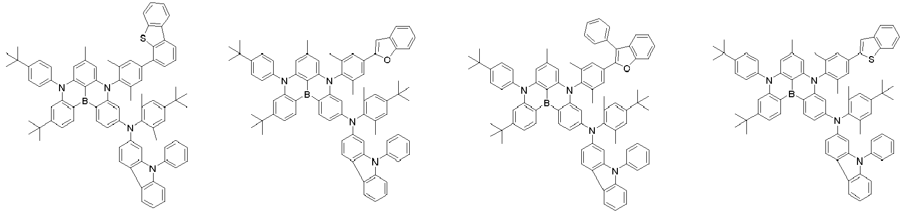

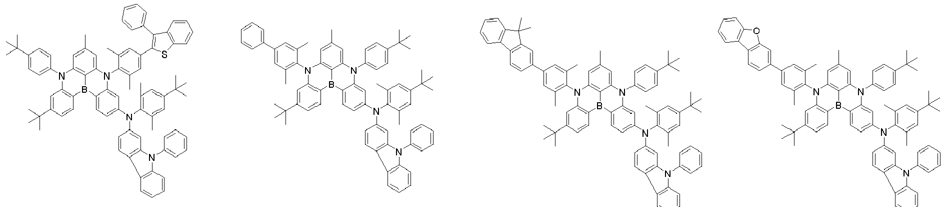

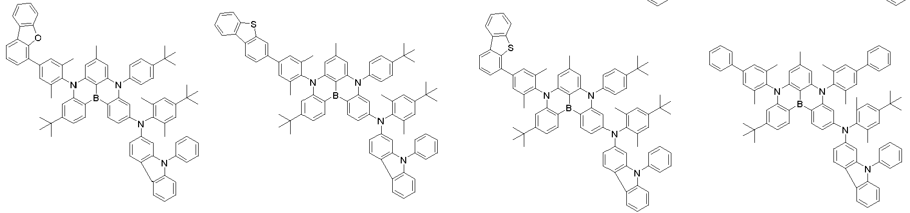

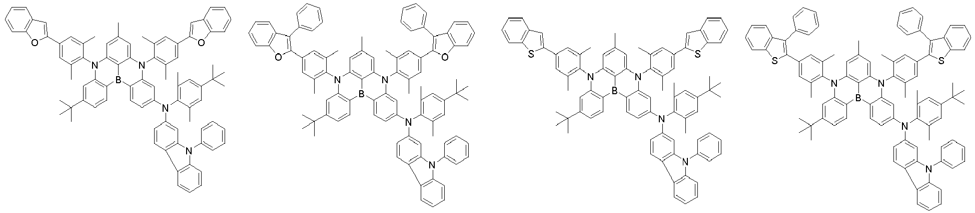

### Preparation of the compounds of formula (I)

The compounds represented by formula (I) can be synthesized in accordance with the reactions conducted in the examples of the present application, and by using alternative reactions or raw materials suited to an intended product, in analogy to reactions and raw materials known in the art.

The compounds of formula (I) are for example prepared by the following step:
Addition of BHal'₃ to the intermediate (XI), via Lithium halogen exchange with Li-alkyl before the addition of BHal'₃, whereby the compound of formula (I) is obtained: 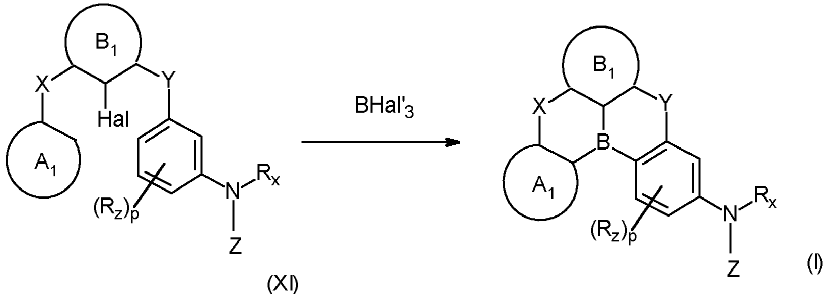 wherein
Hal represents halogen, preferably F, Cl, Br or I, more preferably Cl or Br and most preferably Cl;
Hal' represents halogen, preferably F, Cl, Br or I, more preferably Cl or Br and most preferably Br;
a preferred Li-alkyl is sec-butyl lithium or tert-butyl lithium;
all other residues and indices are as defined before.

The intermediate (XI) is for Y = NR_{EY} for example prepared by the following step: 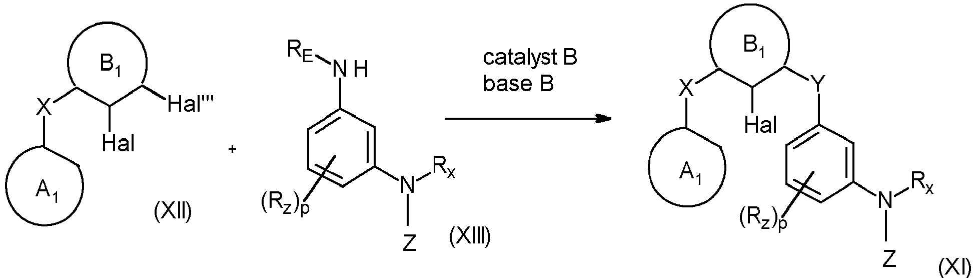 wherein
Hal‴ represents halogen, preferably F, Cl, Br or I, more preferably Cl or Br and most preferably Br;
base B is any suitable base; preferred bases are alkali metal *tert*-butoxides like KO*t*Bu and NaO*t*Bu);
catalyst B is any suitable catalyst; preferred catalysts are Pd catalysts;
all other residues and indices are as defined before.

Suitable Pd catalysts are for example Pd(0) complexes with bidentate ligands like dba (dibenzylideneacetone), or Pd(ll) salts like PdCl₂ or Pd(OAc)₂ in combination with bidentate phosphine ligands such as dppf ((diphenylphosphino)ferrocene), dppp ((diphenylphosphino)propane), BINAP (2,2'-Bis(diphenylphosphino)-1,1'-binaphthyl), Xantphos (4,5-Bis(diphenylphosphino)-9,9-dimethylxanthene), DPEphos (Bis[(2-diphenylphosphino)phenyl] ether) or Josiphos, or in combination with monodentate phosphine-ligands like di-*tert*.-butyl-(4-dimethylaminophenyl)-phosphine (Amphos), triphenylphosphine, tri-ortho-tolyl phosphine, tri-tertbutylphosphine, tricyclohexylphosphine, 2-Dicyclohexylphosphino-2',6'-dimethoxybiphenyl (SPhos), 2-Dicyclohexylphosphino-2',4',6'-triisopropylbiphenyl (XPhos), or N-heterocyclic carbenes such as 1,3-Bis(2,6-diisopropylphenyl)imidazol-2-ylidene (IPr), 1,3-Dimesitylimidazol-2-ylidene (Imes).

### Josiphos:

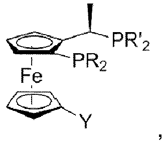

wherein R and R' are generally substituted or unsubstituted phenyl.

Suitable reaction conditions are known by a person skilled in the art.

Details of all reaction steps and process conditions are mentioned in the examples of the present application.

### Organic electroluminescence device

According to one aspect of the present invention a material for an organic electroluminescence device comprising at least one compound of formula (I) is provided.

According to another aspect of the present invention, an organic electroluminescence device comprising at least one compound of formula (I) is provided.

According to another aspect of the invention, the following organic electroluminescence device is provided: An organic electroluminescence device comprising a cathode, an anode, and one or more organic thin film layers comprising a light emitting layer disposed between the cathode and the anode, wherein at least one layer of the organic thin film layers comprises at least one compound of formula (I).

According to another aspect of the invention an organic electroluminescence device is provided, wherein the light emitting layer comprises at least one compound of formula (I).

According to another aspect of the invention an organic electroluminescence device is provided, wherein the light emitting layer comprises at least one compound of formula (I) as a dopant material and an anthracene compound as a host material.

According to another aspect of the invention an electronic equipment provided with the organic electroluminescence device according to the present invention is provided.

According to another aspect of the invention an emitter material is provided comprising at least one compound of formula (I).

According to another aspect of the invention a light emitting layer is provided comprising at least one host and at least one dopant, wherein the dopant comprises at least one compound of formula (I).

According to another aspect of the invention the use of a compound of formula (I) according to the present invention in an organic electroluminescence device is provided.

In one embodiment, the organic EL device comprises a hole-transporting layer between the anode and the emitting layer.

In one embodiment, the organic EL device comprises an electron-transporting layer between the cathode and the emitting layer.

In the present specification, regarding the "one or more organic thin film layers between the emitting layer and the anode", if only one organic layer is present between the emitting layer and the anode, it means that layer, and if plural organic layers are present, it means at least one layer thereof. For example, if two or more organic layers are present between the emitting layer and the anode, an organic layer nearer to the emitting layer is called the "hole-transporting layer", and an organic layer nearer to the anode is called the "hole-injecting layer". Each of the "hole-transporting layer" and the "hole-injecting layer" may be a single layer or may be formed of two or more layers. One of these layers may be a single layer and the other may be formed of two or more layers.

Similarly, regarding the "one or more organic thin film layers between the emitting layer and the cathode", if only one organic layer is present between the emitting layer and the cathode, it means that layer, and if plural organic layers are present, it means at least one layer thereof. For example, if two or more organic layers are present between the emitting layer and the cathode, an organic layer nearer to the emitting layer is called the "electron-transporting layer", and an organic layer nearer to the cathode is called the "electron-injecting layer". Each of the "electron-transporting layer" and the "electron-injecting layer" may be a single layer or may be formed of two or more layers. One of these layers may be a single layer and the other may be formed of two or more layers.

The "one or more organic thin film layers comprising an emitting layer" mentioned above, preferably the emitting layer, comprises a compound represented by formula (I). The compound represented by formula (I) preferably functions as an emitter material, more preferably as a fluorescent emitter material, most preferably as a blue fluorescent emitter material. By the presence of a compound of formula (I) in the organic EL device, preferably in the emitting layer, organic EL devices characterized by high external quantum efficiencies (EQE) and long lifetimes are provided.

According to another aspect of the invention, an emitting layer of the organic electroluminescence device is provided which comprises at least one compound of formula (I).

Preferably, the emitting layer comprises at least one emitting material (dopant material) and at least one host material, wherein the emitting material is at least one compound of formula (I).

In one embodiment, the host is not selected from CBP (4,4'-Bis-(N-carbazolyl)-biphenyl), mCP, mCBP Sif87 (dibenzo[b,d]thiophen-2-yltriphenylsilane), CzSi, Sif88 (dibenzo[b,d]thiophen-2-yl)diphenylsilane), DPEPO (bis[2-(diphenylphosphino)phenylj ether oxide), 9-[3- (dibenzofuran-2-yl)phenyl]-9H-carbazole, 9-[3-(dibenzofuran-2-yl)phenyl]-9H-carbazole, 9-[3- (dibenzothiophen-2-yl)phenyl]-9H-carbazole, 9-[3,5-bis(2-dibenzofuranyl)phenyl]-9H- carbazole, 9-[3,5-bis(2-dibenzothiophenyl)phenyl]-9H-carbazole, T2T (2,4,6-tris(biphenyl-3- yl)-1 ,3,5-triazine), T3T (2,4,6-tris(triphenyl-3-yl)-1 ,3,5-triazine) and/or TST (2,4,6-tris(9,9'- spirobifluorene-2-yl)-1,3,5-triazine).

Preferred host materials are substituted or unsubstituted polyaromatic hydrocarbon (PAH) compounds, substituted or unsubstituted polyheteroaromatic compounds, substituted or unsubstituted anthracene compounds, or substituted or unsubstituted pyrene compounds.

More preferably, the organic electroluminescence device according to the present invention comprises in the emitting layer at least one compound of formula (I) as a dopant material and at least one host material selected from the group consisting of substituted or unsubstituted polyaromatic hydrocarbon (PAH) compounds, substituted or unsubstituted polyheteroaromatic compounds, substituted or unsubstituted anthracene compounds, and substituted or unsubstituted pyrene compounds. Preferably, the at least one host is at least one substituted or unsubstituted anthracene compound.

In a further preferred embodiment, the organic electroluminescence device according to the present invention comprises in the emitting layer at least one compound of formula (I) as a dopant material and at least one host material selected from the group consisting of substituted or unsubstituted polyaromatic hydrocarbon (PAH) compounds, substituted or unsubstituted anthracene compounds, and substituted or unsubstituted pyrene compounds. Preferably, the at least one host is at least one substituted or unsubstituted anthracene compound.

According to another aspect of the invention, an emitting layer of the organic electroluminescence device is provided which comprises at least one compound of formula (I) as a dopant material and an anthracene compound as a host material.

Suitable anthracene compounds are represented by the following formula (10): 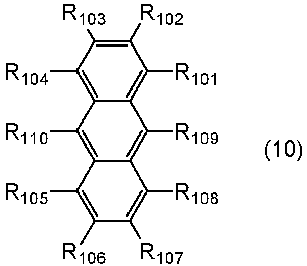 wherein
one or more pairs of two or more adjacent R₁₀₁ to R₁₁₀ may form a substituted or unsubstituted, saturated or unsaturated ring;
R₁₀₁ to R₁₁₀ that do not form the substituted or unsubstituted, saturated or unsaturated ring are independently a hydrogen atom, a substituted or unsubstituted alkyl group including 1 to 50 carbon atoms, a substituted or unsubstituted haloalkyl group including 1 to 50 carbon atoms, a substituted or unsubstituted alkenyl group including 2 to 50 carbon atoms, a substituted or unsubstituted alkynyl group including 2 to 50 carbon atoms, a substituted or unsubstituted cycloalkyl group including 3 to 50 ring carbon atoms, a substituted or unsubstituted alkoxy group including 1 to 50 carbon atoms, a substituted or unsubstituted alkylene group including 1 to 50 carbon atoms, a substituted or unsubstituted aryloxy group including 6 to 50 ring carbon atoms, a substituted or unsubstituted arylthio group including 6 to 50 ring carbon atoms, a substituted or unsubstituted aralkyl group including 7 to 50 carbon atoms, -Si(R₁₂₁)(R₁₂₂)(R₁₂₃), -C(=O)R₁₂₄, - COOR₁₂₅, -N(R₁₂₆)(R₁₂₇), a halogen atom, a cyano group, a nitro group, a substituted or unsubstituted aryl group including 6 to 50 ring carbon atoms, a substituted or unsubstituted monovalent heterocyclic group including 5 to 50 ring atoms, or a group represented by the following formula (31);
R₁₂₁ to R₁₂₇ are independently a hydrogen atom, a substituted or unsubstituted alkyl group including 1 to 50 carbon atoms, a substituted or unsubstituted cycloalkyl group including 3 to 50 ring carbon atoms, a substituted or unsubstituted aryl group including 6 to 50 ring carbon atoms or a substituted or unsubstituted monovalent heterocyclic group including 5 to 50 ring atoms; when each of R₁₂₁ to R₁₂₇ is present in plural, each of the plural R₁₂₁ to R₁₂₇ may be the same or different;
provided that at least one of R₁₀₁ to R₁₁₀ that do not form the substituted or unsubstituted, saturated or unsaturated ring is a group represented by the following formula (31). If two or more groups represented by the formula (31) are present, each of these groups may be the same or different;

   -L₁₀₁-Ar₁₀₁ (31)

   wherein in the formula (31),
L₁₀₁ is a single bond, a substituted or unsubstituted arylene group including 6 to 30 ring carbon atoms or a substituted or unsubstituted divalent heterocyclic group including 5 to 30 ring atoms; Ar₁₀₁ is a substituted or unsubstituted aryl group including 6 to 50 ring carbon atoms or a substituted or unsubstituted monovalent heterocyclic group including 5 to 50 ring atoms.

Specific examples of each substituent, substituents for "substituted or unsubstituted" and the halogen atom in the compound (10) are the same as those mentioned above.

An explanation will be given on "one or more pairs of two or more adjacent R₁₀₁ to R₁₁₀ may form a substituted or unsubstituted, saturated or unsaturated ring".

The "one pair of two or more adjacent R₁₀₁ to R₁₁₀" is a combination of R₁₀₁ and R₁₀₂, R₁₀₂ and R₁₀₃, R₁₀₃ and R₁₀₄, R₁₀₅ and R₁₀₆, R₁₀₆ and R₁₀₇, R₁₀₇ and R₁₀₈, R₁₀₈ and R₁₀₉, R₁₀₁ and R₁₀₂ and R₁₀₃ or the like, for example.

The substituent in "substituted" in the "substituted or unsubstituted" for the saturated or unsaturated ring is the same as those for "substituted or unsubstituted" mentioned in the formula (10).

The "saturated or unsaturated ring" means, when R₁₀₁ and R₁₀₂ form a ring, for example, a ring formed by a carbon atom with which R₁₀₁ is bonded, a carbon atom with which R₁₀₂ is bonded and one or more arbitrary elements. Specifically, when a ring is formed by R₁₀₁ and R₁₀₂, when an unsaturated ring is formed by a carbon atom with which R₁₀₁ is bonded, a carbon atom with R₁₀₂ is bonded and four carbon atoms, the ring formed by R₁₀₁ and R₁₀₂ is a benzene ring.

The "arbitrary element" is preferably a C element, a N element, an O element or a S element. In the arbitrary element (C element or N element, for example), atomic bondings that do not form a ring may be terminated by a hydrogen atom, or the like.

The "one or more arbitrary element" is preferably 2 or more and 15 or less, more preferably 3 or more and 12 or less, and further preferably 3 or more and 5 or less arbitrary elements.

For example, R₁₀₁ and R₁₀₂ may form a ring, and simultaneously, R₁₀₅ and R₁₀₆ may form a ring. In this case, the compound represented by the formula (10) is a compound represented by the following formula (10A), for example:

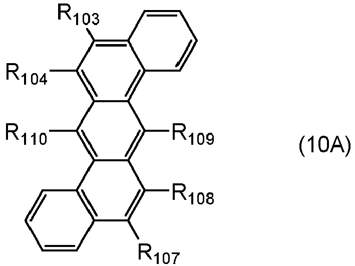

In one embodiment, R₁₀₁ to R₁₁₀ are independently a hydrogen atom, a substituted or unsubstituted alkyl group including 1 to 50 carbon atoms, a substituted or unsubstituted aryl group including 6 to 50 ring carbon atoms, a substituted or unsubstituted heterocyclic group including 5 to 50 ring atoms or a group represented by the formula (31).

Preferably, R₁₀₁ to R₁₁₀ are independently a hydrogen atom, a substituted or unsubstituted aryl group including 6 to 50 ring carbon atoms, a substituted or unsubstituted heterocyclic group including 5 to 50 ring atoms or a group represented by the formula (31).

More preferably, R₁₀₁ to R₁₁₀ are independently a hydrogen atom, a substituted or unsubstituted aryl group including 6 to 18 ring carbon atoms, a substituted or unsubstituted heterocyclic group including 5 to 18 ring atoms or a group represented by the formula (31).

Most preferably, at least one of R₁₀₉ and R₁₁₀ is a group represented by the formula (31).

Further most preferably, R₁₀₉ and R₁₁₀ are independently a group represented by the formula (31).

In one embodiment, the compound (10) is a compound represented by the following formula (10-1): 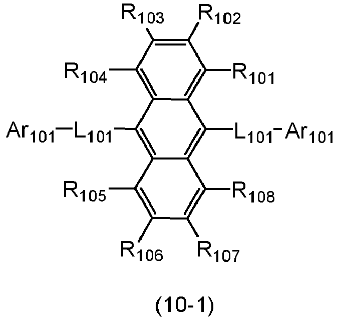 wherein in the formula (10-1), R₁₀₁ to R₁₀₈, L₁₀₁ and Ar₁₀₁ are as defined in the formula (10).

In one embodiment, the compound (10) is a compound represented by the following formula (10-2): 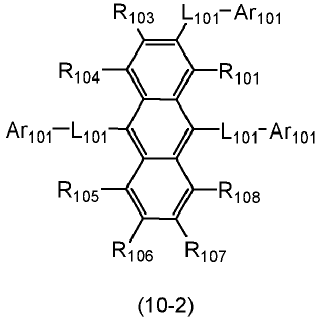 wherein in the formula (10-2), R₁₀₁, R₁₀₃ to R₁₀₈, L₁₀₁ and Ar₁₀₁ are as defined in the formula (10).

In one embodiment, the compound (10) is a compound represented by the following formula (10-3): 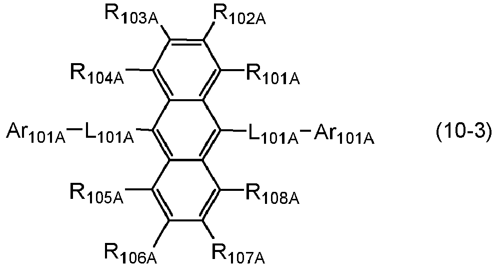 wherein in the formula (10-3),
R_{101A} to R_{108A} are independently a hydrogen atom or a substituted or unsubstituted aryl group including 6 to 50 ring carbon atoms;
L_{101A} is a single bond or a substituted or unsubstituted arylene group including 6 to 30 ring carbon atoms, and the two L_{101A}s may be the same or different;
Ar_{101A} is a substituted or unsubstituted aryl group including 6 to 50 ring carbon atoms, and the two Ar_{101A}s may be the same or different.

In one embodiment, the compound (10) is a compound represented by the following formula (10-4): 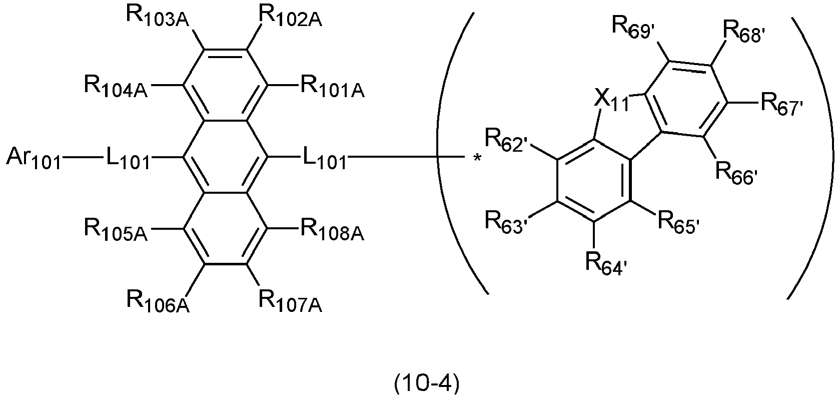 wherein in the formula (10-4),
L₁₀₁ and Ar₁₀₁ are as defined in the formula (10);
R_{101A} to R_{108A} are independently a hydrogen atom or a substituted or unsubstituted aryl group including 6 to 50 ring carbon atoms;
X₁₁ is O, S, or N(R_{61'});
R_{61'} is a hydrogen atom, a substituted or unsubstituted alkyl group including 1 to 50 carbon atoms or a substituted or unsubstituted aryl group including 6 to 50 ring carbon atoms;
one of R_{62'} to R_{69'} is an atomic bonding that is bonded with L₁₀₁;
one or more pairs of adjacent R_{62'} to R_{69'} that are not bonded with L₁₀₁ may be bonded with each other to form a substituted or unsubstituted, saturated or unsaturated ring; and R_{62'} to R_{69'} that are not bonded with L₁₀₁ and do not form the substituted or unsubstituted, saturated or unsaturated ring are independently a hydrogen atom, a substituted or unsubstituted alkyl group including 1 to 50 carbon atoms or a substituted or unsubstituted aryl group including 6 to 50 ring carbon atoms.

In one embodiment, the compound (10) is a compound represented by the following formula (10-4A): 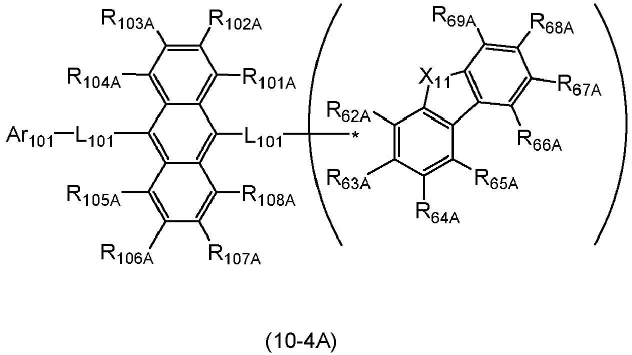 wherein in the formula (10-4A),
L₁₀₁ and Ar₁₀₁ are as defined in the formula (10);
R_{101A} to R_{108A} are independently a hydrogen atom or a substituted or unsubstituted aryl group including 6 to 50 ring carbon atoms;
X₁₁ is O, S or N(R₆₁);
R₆₁ is a hydrogen atom, a substituted or unsubstituted alkyl group including 1 to 50 carbon atoms or a substituted or unsubstituted aryl group including 6 to 50 ring carbon atoms;
one or more pairs of adjacent two or more of R_{52A} to R_{69A} may form a substituted or unsubstituted, saturated or unsaturated ring, and adjacent two of R_{62A} to R_{69A} form a ring represented by the following formula (10-4A-1); and
R_{62A} to R_{69A} that do not form a substituted or unsubstituted, saturated or unsaturated ring are independently a hydrogen atom, a substituted or unsubstituted alkyl group including 1 to 50 carbon atoms or a substituted or unsubstituted aryl group including 6 to 50 ring carbon atoms. 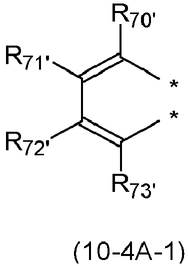 wherein in the formula (10-4A-1),
each of the two atomic bondings * is bonded with adjacent two of R_{62A} to R_{69A};
one of R_{70'} to R_{73'} is an atomic bonding that is bonded with L₁₀₁; and
R_{70'} to R_{73'} that are not bonded with L₁₀₁ are independently a hydrogen atom, a substituted or unsubstituted alkyl group including 1 to 50 carbon atoms or a substituted or unsubstituted aryl group including 6 to 50 ring carbon atoms.

In one embodiment, the compound (10) is a compound represented by the following formula (10-6): 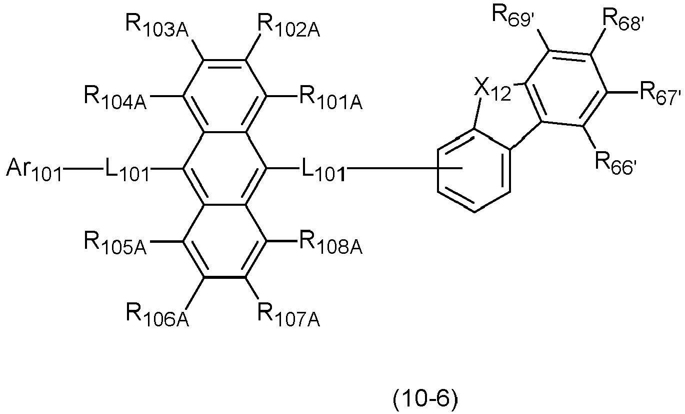 wherein in the formula (10-6),
L₁₀₁ and Ar₁₀₁ are as defined in the formula (10);
R_{101A} to R_{108A} are as defined in the formula (10-4);
R_{66'} to R_{69'} are as defined in the formula (10-4); and
X₁₂ is O or S.

In one embodiment, the compound represented by the formula (10-6) is a compound represented by the following formula (10-6H): 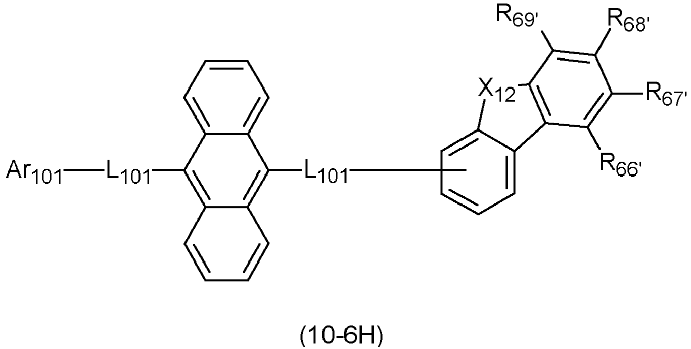 wherein in the formula (10-6H),
L₁₀₁ and Ar₁₀₁ are as defined in the formula (10);
R_{66'} to R_{69'} are as defined in the formula (10-4); and
X₁₂ is O or S.

In one embodiment, the compound represented by the formulae (10-6) and (10-6H) is a compound represented by the following formula (10-6Ha): 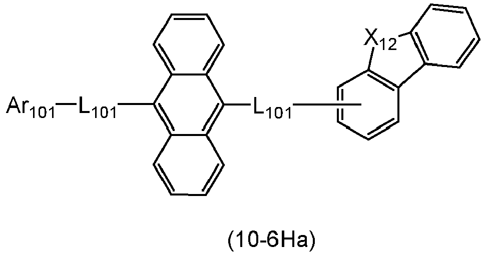 wherein in the formula (10-6Ha),
L₁₀₁ and Ar₁₀₁ are as defined in the formula (10); and
X₁₂ is O or S.

In one embodiment, the compound represented by the formulae (10-6), (10-6H) and (10-6Ha) is a compound represented by the following formula (10-6Ha-1) or (10-6Ha-2): 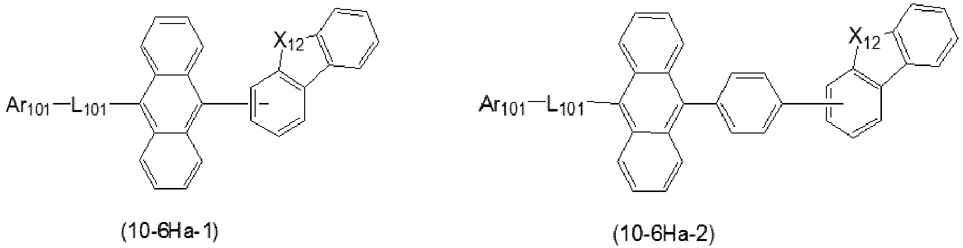 wherein in the formula (10-6Ha-1) and (10-6Ha-2),
L₁₀₁ and Ar₁₀₁ are as defined in the formula (10); and
X₁₂ is O or S.

In one embodiment, the compound (10) is a compound represented by the following formula (10-7): 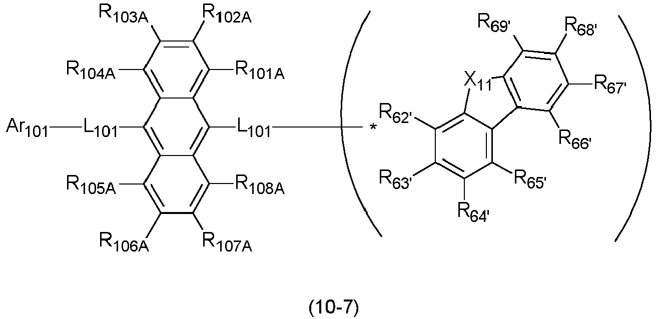 wherein in the formula (10-7),
L₁₀₁ and Ar₁₀₁ are as defined in the formula (10);
R_{101A} to R_{108A} are as defined in the formula (10-4);
X₁₁ is as defined in the formula (10-4); and
R_{62'} to R_{69'} are as defined in the formula (10-4), provided that any one pair of R_{66'} and R_{67'}, R_{67'} and R_{68'}, and R_{68'} and R_{69'} are bonded with each other to form a substituted or unsubstituted, saturated or unsaturated ring.

In one embodiment, the compound (10) is a compound represented by the following formula (10-7H): 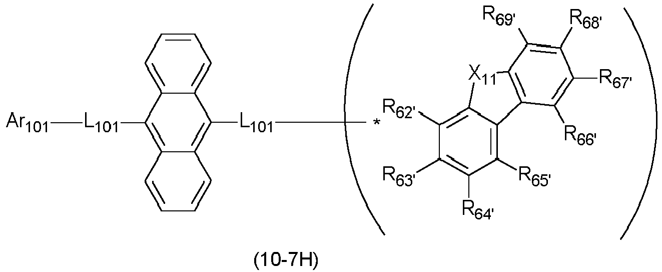 wherein in the formula (10-7H),
L₁₀₁ and Ar₁₀₁ are as defined in the formula (10);
X₁₁ is as defined in the formula (10-4); and
R_{62'} to R_{69'} are as defined in the formula (10-4), provided that any one pair of R_{66'} and R_{67'}, R_{67'} and R_{68'}, and R_{68'} and R_{69'} are bonded with each other to form a substituted or unsubstituted, saturated or unsaturated ring.

In one embodiment, the compound (10) is a compound represented by the following formula (10-8): 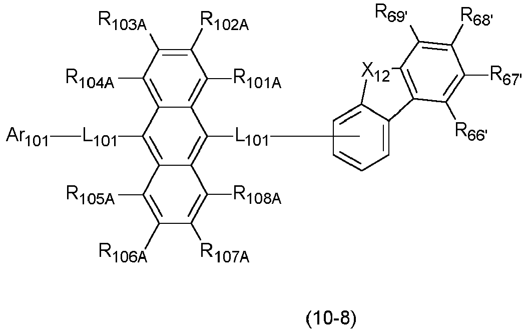 wherein in the formula (10-8),
L₁₀₁ and Ar₁₀₁ are as defined in the formula (10);
R_{101A} to R_{108A} are as defined in the formula (10-4);
X₁₂ is O or S; and
R_{66'} to R_{69'} are as defined in the formula (10-4), provided that any one pair of R_{66'} and R_{67'}, R_{67'} and R_{68'}, as well as R_{68'} and R_{69'} are bonded with each other to form a substituted or unsubstituted, saturated or unsaturated ring.

In one embodiment, the compound represented by the formula (10-8) is a compound represented by the following formula (10-8H): 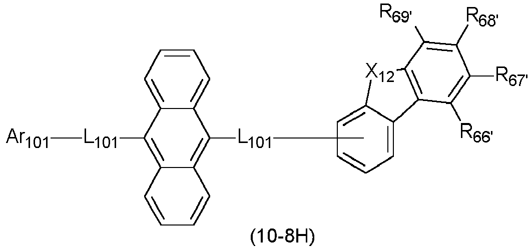 In the formula (10-8H), L₁₀₁ and Ar₁₀₁ are as defined in the formula (10).
R_{66'} to R_{69'} are as defined in the formula (10-4), provided that any one pair of R_{66'} and R_{67'}, R_{67'} and R_{68'}, as well as R_{68'} and R_{69'} are bonded with each other to form a substituted or unsubstituted, saturated or unsaturated ring. Any one pair of R_{66'} and R_{67'}, R_{67'} and R_{68'}, as well as R_{68'} and R_{69'} may preferably be bonded with each other to form an unsubstituted benzene ring; and X₁₂ is O or S.

In one embodiment, as for the compound represented by the formula (10-7), (10-8) or (10-8H), any one pair of R_{66'} and R_{67'}, R_{67'} and R_{68'}, as well as R_{68'} and R_{69'} are bonded with each other to form a ring represented by the following formula (10-8-1) or (10-8-2), and R_{66'} to R_{69'} that do not form the ring represented by the formula (10-8-1) or (10-8-2) do not form a substituted or unsubstituted, saturated or unsaturated ring. 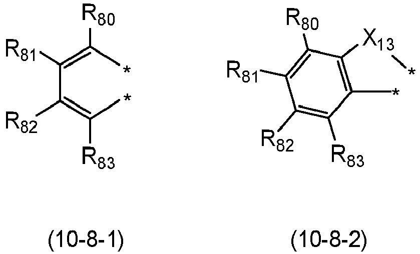 wherein in the formulae (10-8-1) and (10-8-2),
the two atomic bondings * are independently bonded with one pair of R_{66'} and R_{67'}, R_{67'} and R_{68'}, or R_{68'} and R_{69'};
R₈₀ to R₈₃ are independently a hydrogen atom, a substituted or unsubstituted alkyl group including 1 to 50 carbon atoms or a substituted or unsubstituted aryl group including 6 to 50 ring carbon atoms; and
X₁₃ is O or S.

In one embodiment, the compound (10) is a compound represented by the following formula (10-9): 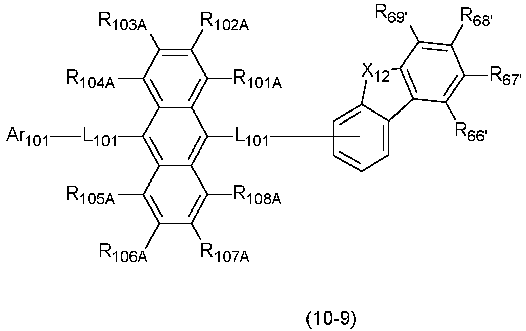 wherein in the formula (10-9),
L₁₀₁ and Ar₁₀₁ are as defined in the formula (10);
R_{101A} to R_{108A} are as defined in the formula (10-4);
R_{66'} to R_{69'} are as defined in the formula (10-4), provided that R_{66'} and R_{67'}, R_{67'} and R_{68'}, as well as R_{68'} and R_{69'} are not bonded with each other and do not form a substituted or unsubstituted, saturated or unsaturated ring; and
X₁₂ is O or S.

In one embodiment, the compound (10) is selected from the group consisting of compounds represented by the following formulae (10-10-1) to (10-10-4).

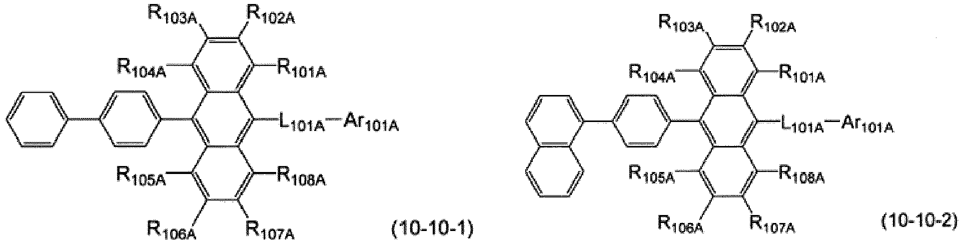

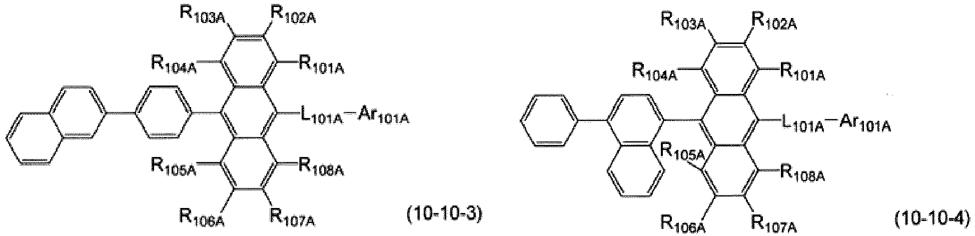

In the formulae (10-10-1H) to (10-10-4H), L_{101A} and Ar_{101A} are as defined in the formula (10-3). In one embodiment, in the compound represented by the formula (10-1), at least one Ar₁₀₁ is a monovalent group having a structure represented by the following formula (50). 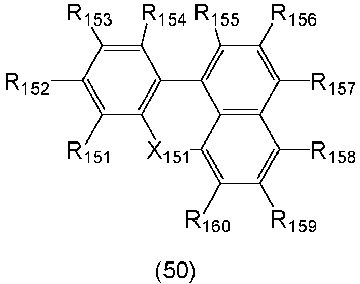 In the formula (50),
X₁₅₁ is O, S, or C(R₁₆₁)(R₁₆₂).
One of R₁₅₁ to R₁₆₀ is a single bond which bonds with L₁₀₁.
One or more sets of adjacent two or more of R₁₅₁ to R₁₅₄ and one or more sets of adjacent two or more of R₁₅₅ to R₁₆₀, which are not a single bond which bonds with L₁₀₁, form a substituted or unsubstituted, saturated or unsaturated ring by bonding with each other, or do not form a substituted or unsubstituted, saturated or unsaturated ring.
R₁₆₁ and R₁₆₂ form a substituted or unsubstituted, saturated or unsaturated ring by bonding with each other, or do not form a substituted or unsubstituted, saturated or unsaturated ring.
R₁₆₁ and R₁₆₂ which do not form the substituted or unsubstituted, saturated or unsaturated ring, and R₁₅₁ to R₁₆₀ which are not a single bond which bonds with L₁₀₁ and do not form the substituted or unsubstituted, saturated or unsaturated ring are independently a hydrogen atom, a substituted or unsubstituted alkyl group including 1 to 50 carbon atoms, a substituted or unsubstituted haloalkyl group including 1 to 50 carbon atoms, a substituted or unsubstituted alkenyl group including 2 to 50 carbon atoms, a substituted or unsubstituted alkynyl group including 2 to 50 carbon atoms, a substituted or unsubstituted cycloalkyl group including 3 to 50 ring carbon atoms, a substituted or unsubstituted alkoxy group including 1 to 50 carbon atoms, a substituted or unsubstituted alkylene group including 1 to 50 carbon atoms, a substituted or unsubstituted aryloxy group including 6 to 50 ring carbon atoms, a substituted or unsubstituted arylthio group including 6 to 50 ring carbon atoms, a substituted or unsubstituted aralkyl group including 7 to 50 carbon atoms, -Si(R121)(R122)(R123), -C(=O)R124, -COOR125, -N(R126)(R127), a halogen atom, a cyano group, a nitro group, a substituted or unsubstituted aryl group including 6 to 50 ring carbon atoms, or a substituted or unsubstituted monovalent heterocyclic group including 5 to 50 ring atoms.
Ar₁₀₁, which is not a monovalent group having the structure represented by the formula (50) is a substituted or unsubstituted aryl group including 6 to 50 ring carbon atoms, or a substituted or unsubstituted divalent heterocyclic group including 5 to 50 ring atoms.

The position to be the single bond which bonds with L₁₀₁ in the formula (50) is not particularly limited. In one embodiment, one of R₁₅₁ to R₁₆₀ in the formula (50) is a single bond which bonds with L₁₀₁.

In one embodiment, Ar₁₀₁ is a monovalent group represented by the following formula (50-R₁₅₂), (50-R₁₅₃), (50-R₁₅₄), (50-R₁₅₇), or (50-R₁₅₈).

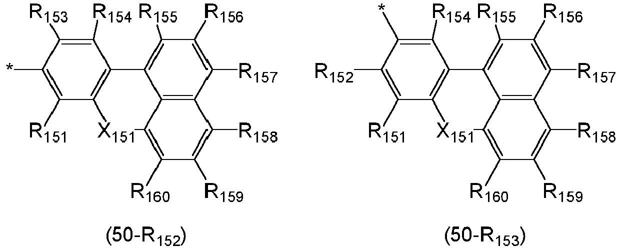

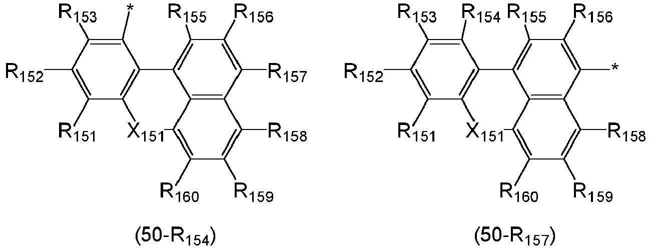

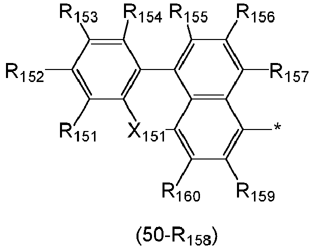

In the formulas (50-R₁₅₂), (50-R₁₅₃), (50-R₁₅₄), (50-R₁₅₇), and (50-R₁₅₈), X₁₅₁, R₁₅₁ to R₁₆₀ are as defined in the formula (50).
* is a single bond which bonds with L₁₀₁.

As for the compound represented by the formula (10), the following compounds can be given as specific examples. The compound represented by the formula (10) is not limited to these specific examples. In the following specific examples, "D" represents a deuterium atom.

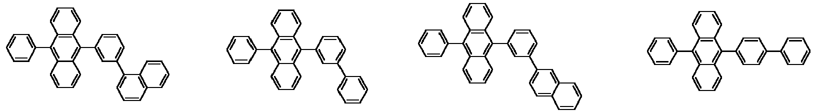

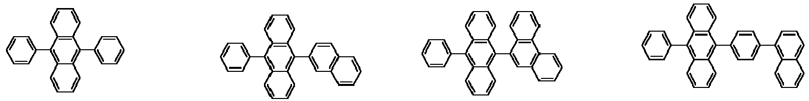

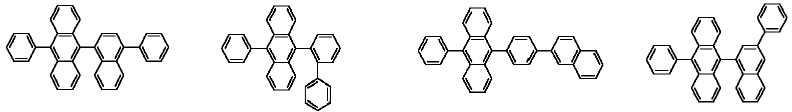

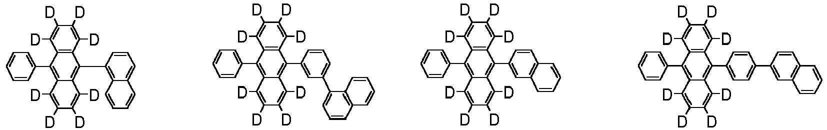

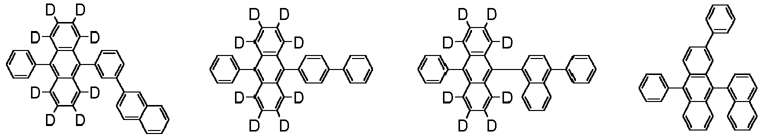

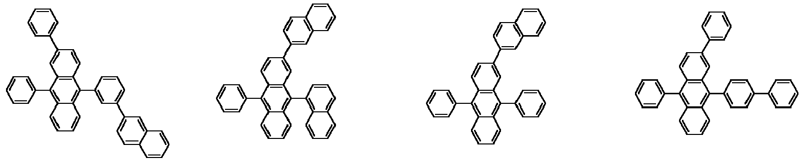

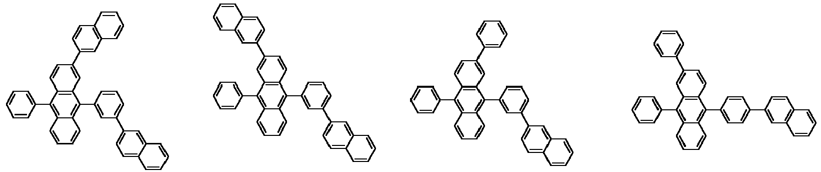

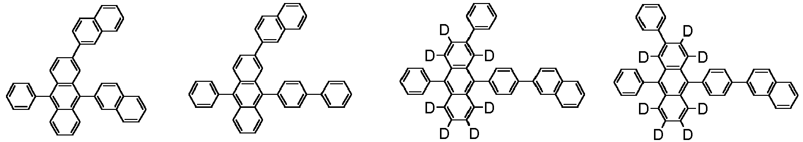

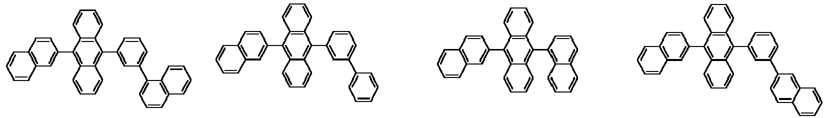

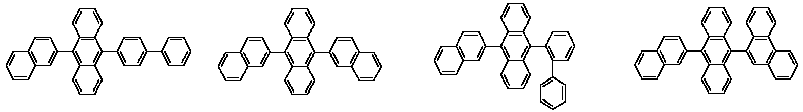

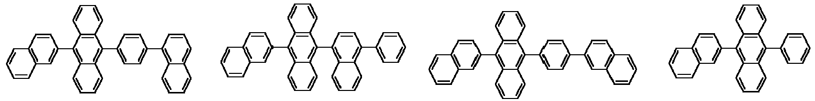

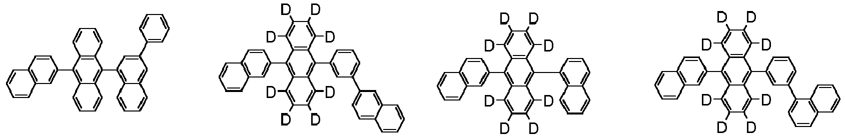

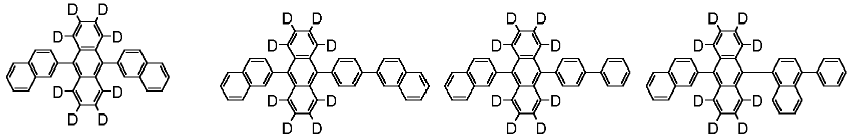

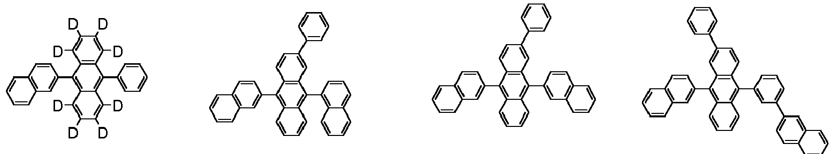

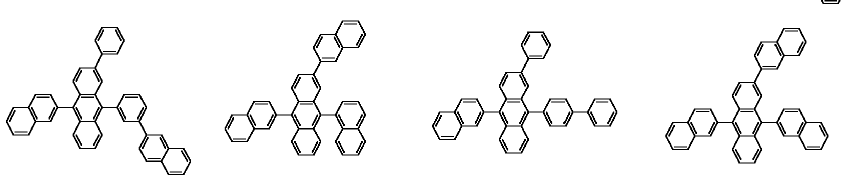

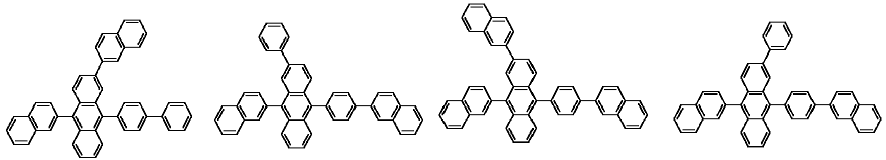

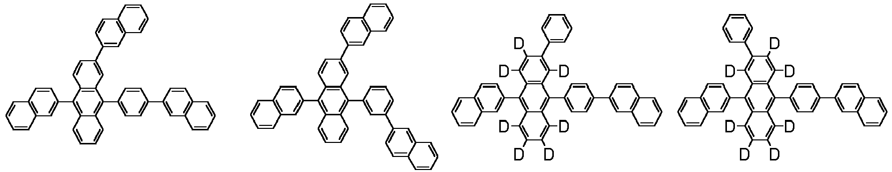

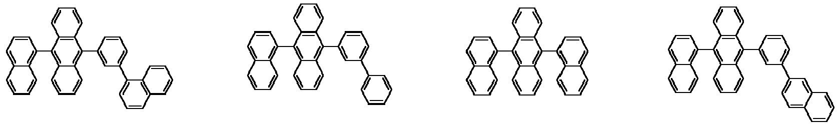

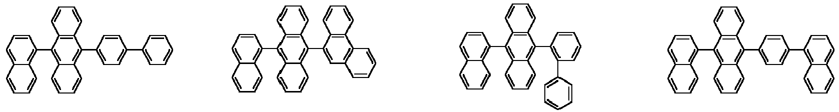

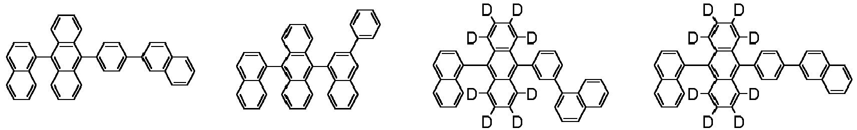

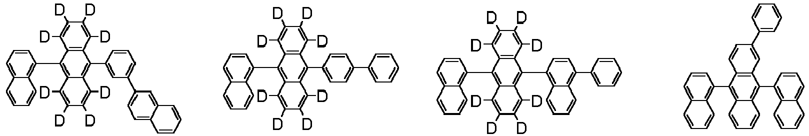

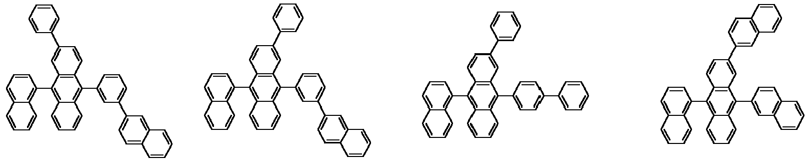

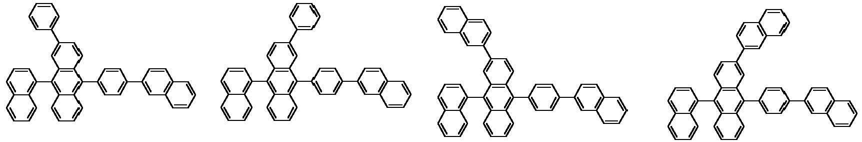

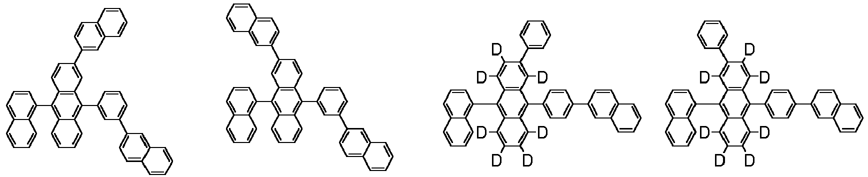

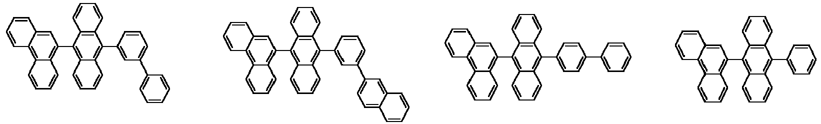

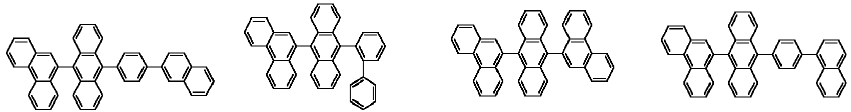

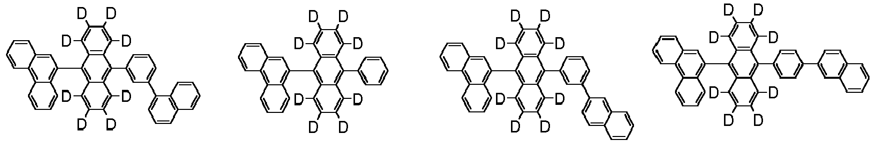

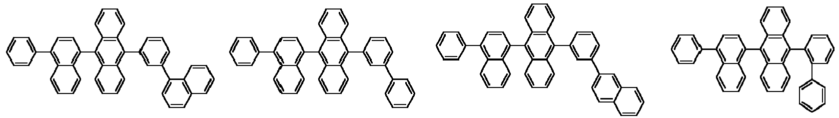

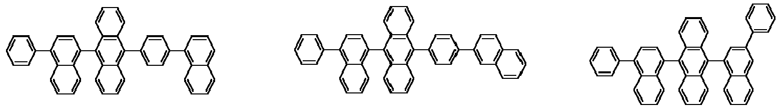

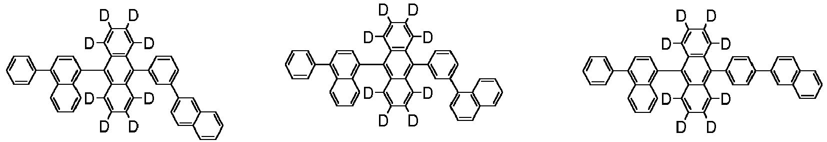

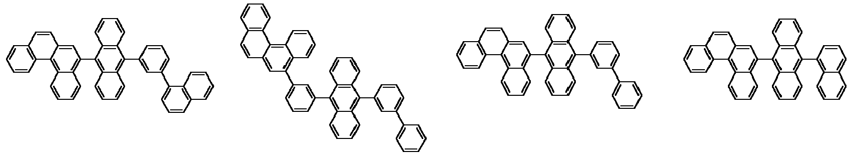

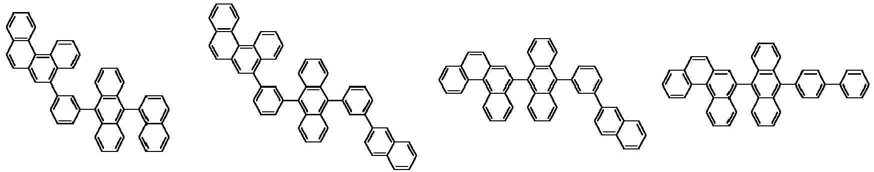

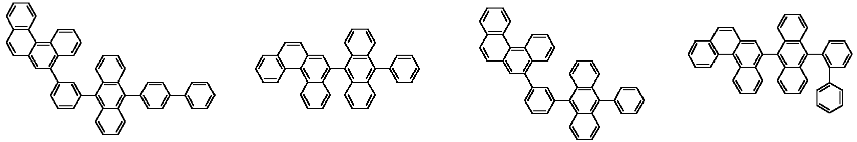

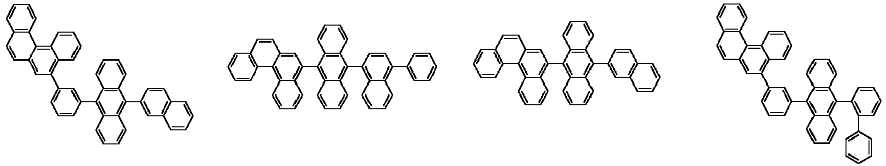

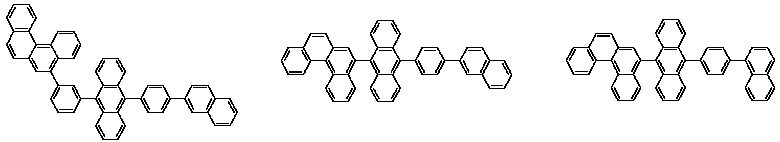

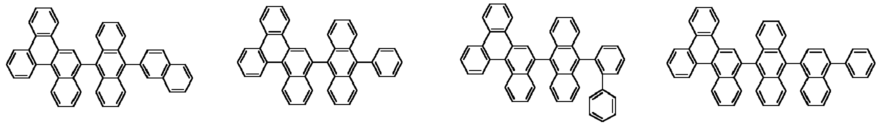

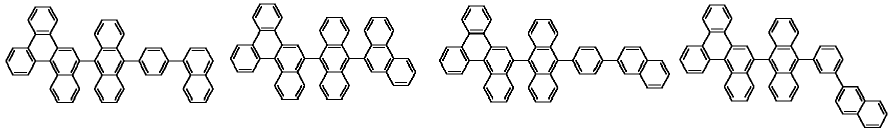

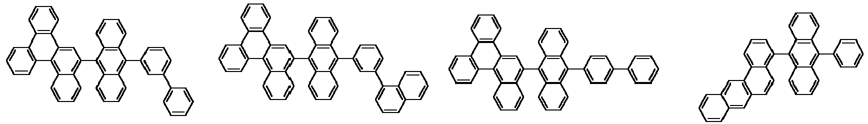

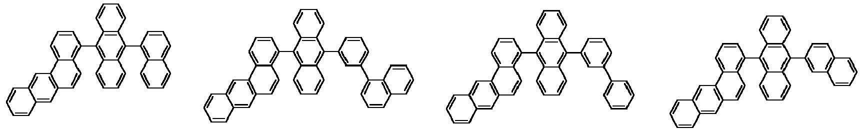

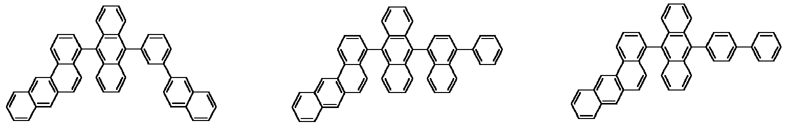

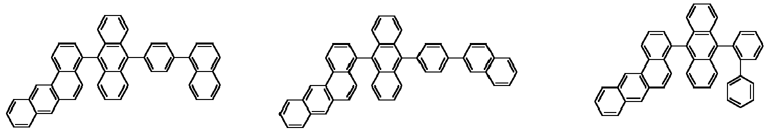

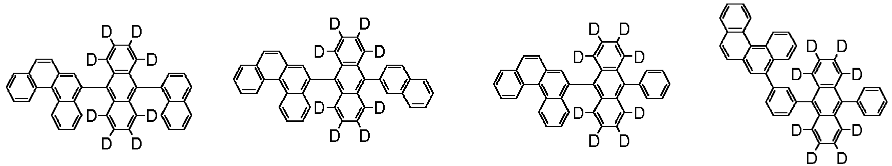

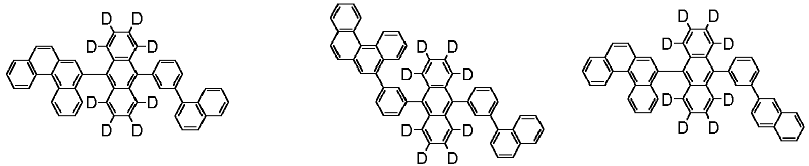

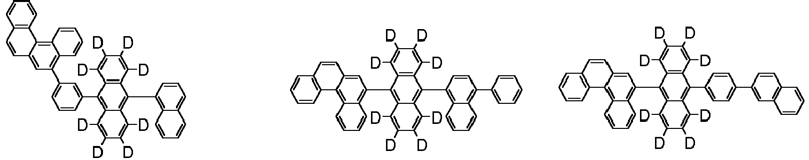

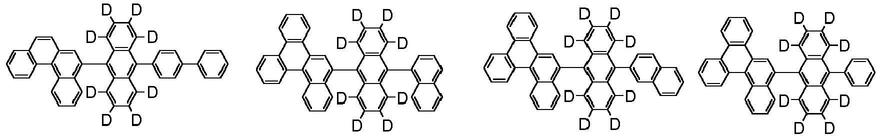

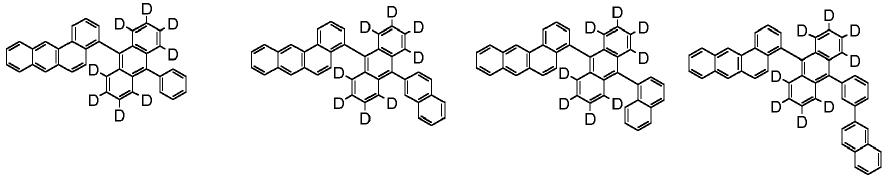

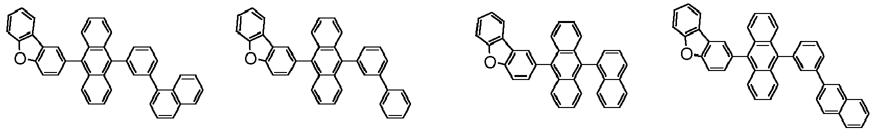

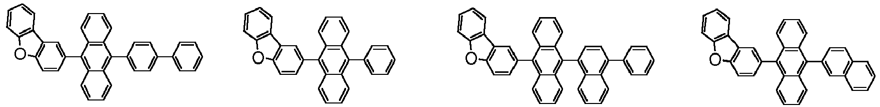

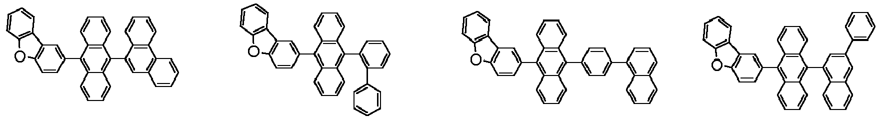

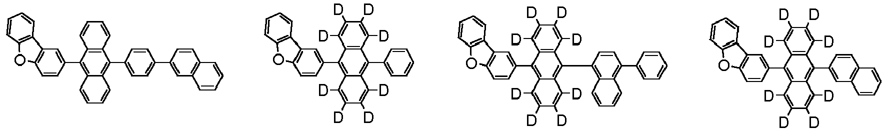

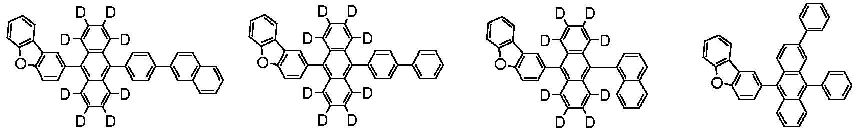

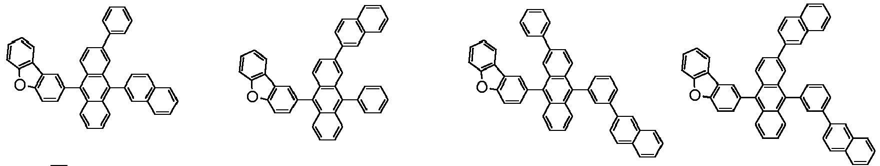

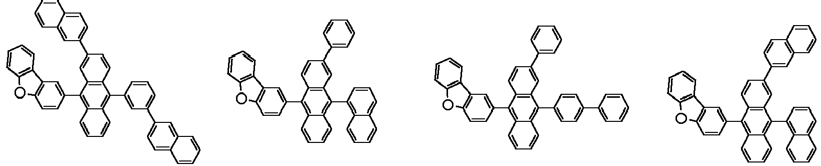

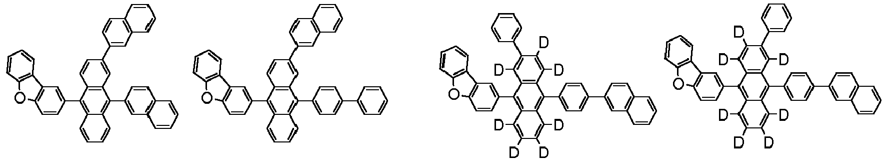

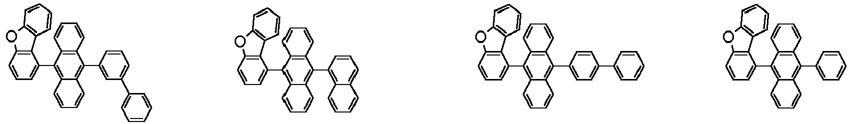

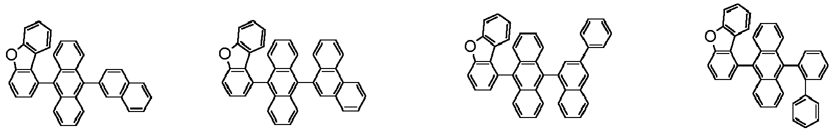

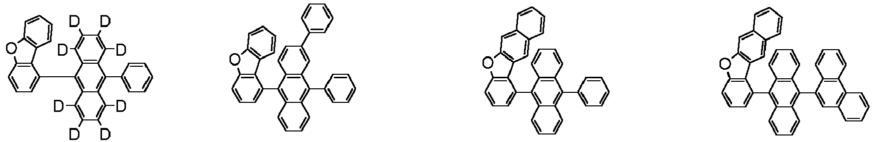

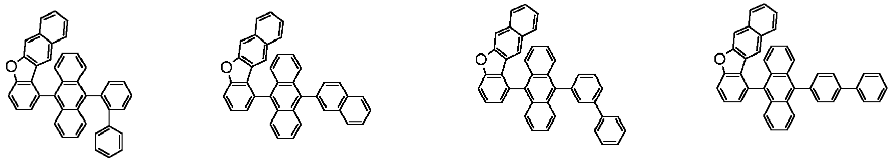

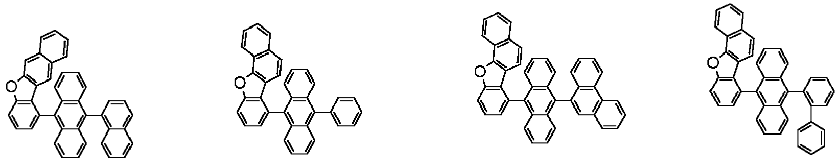

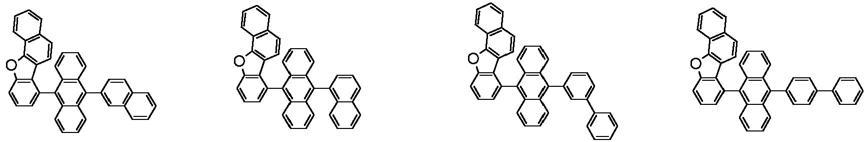

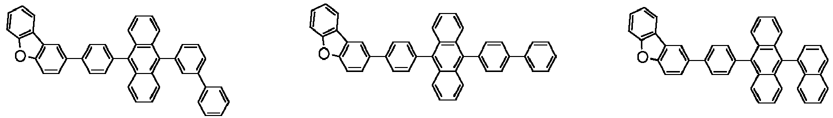

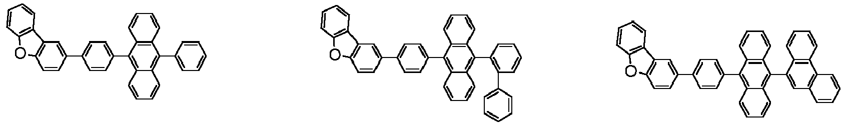

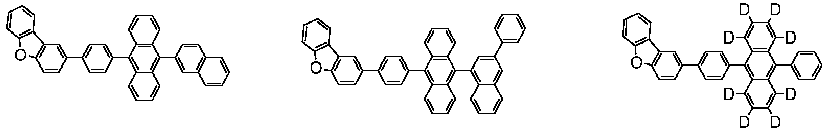

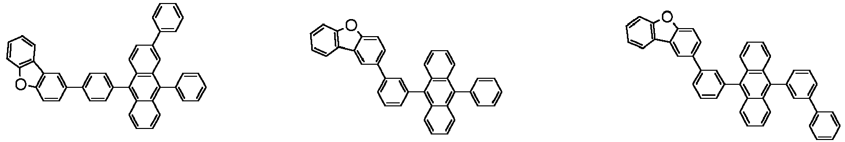

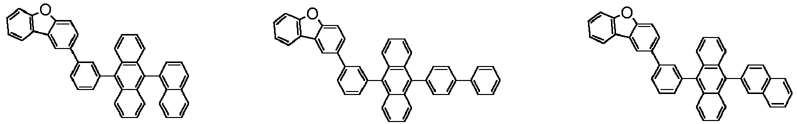

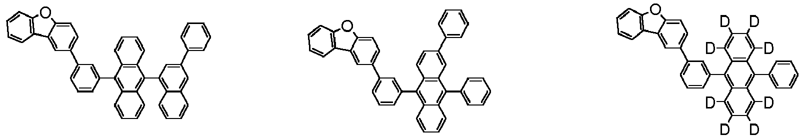

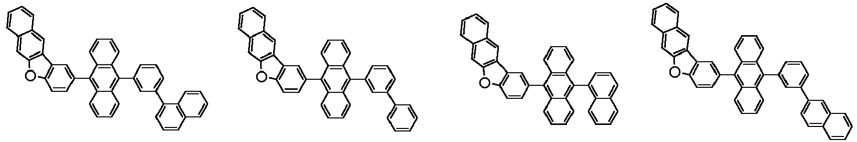

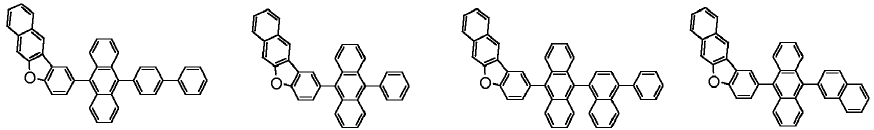

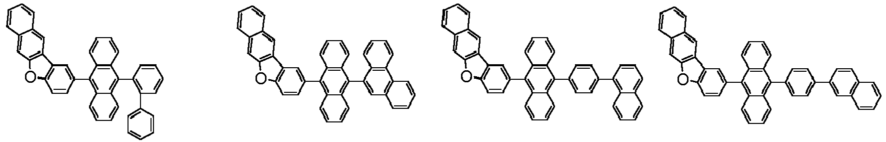

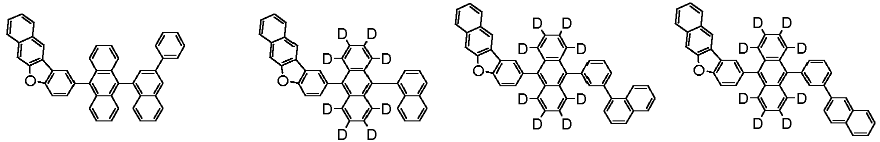

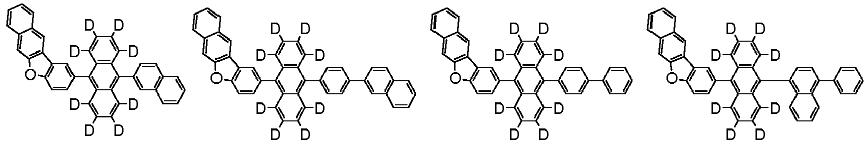

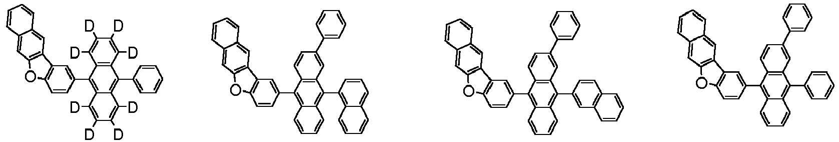

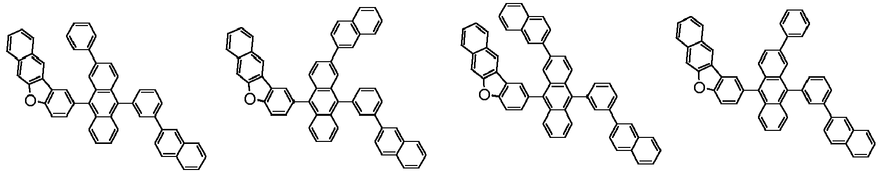

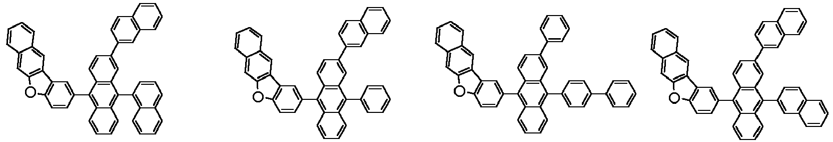

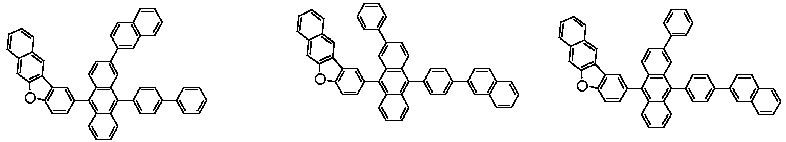

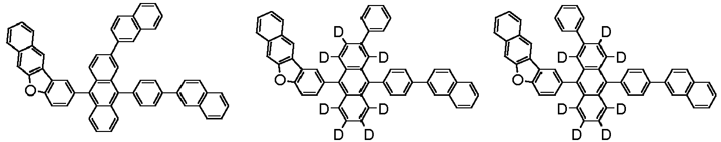

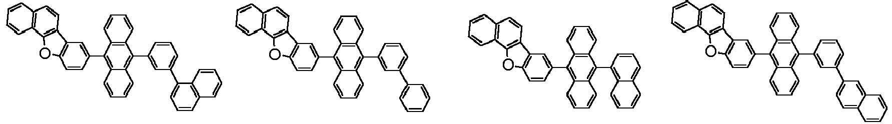

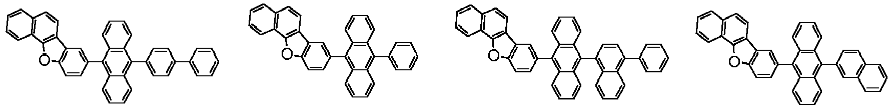

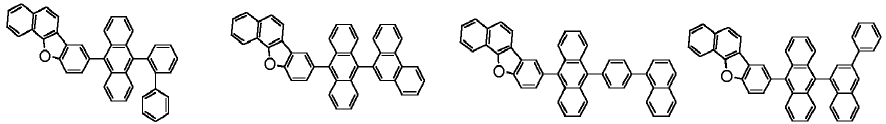

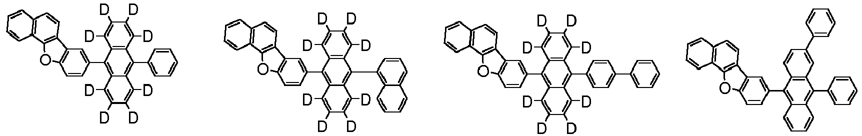

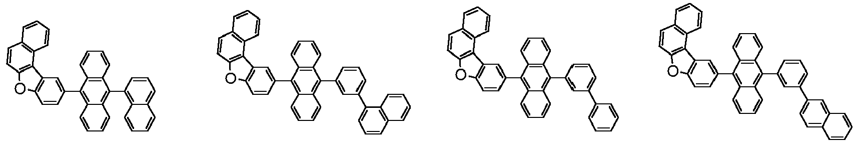

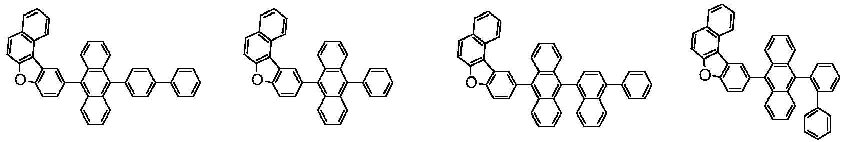

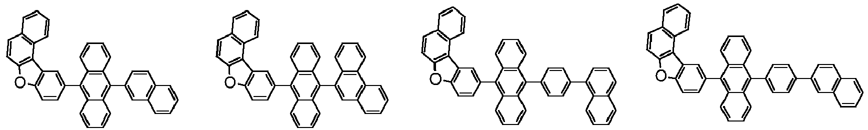

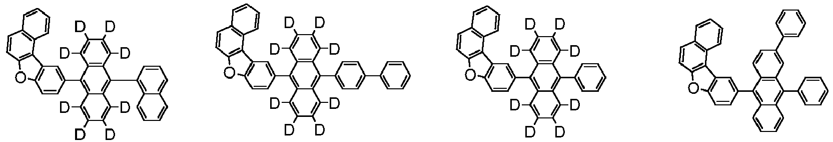

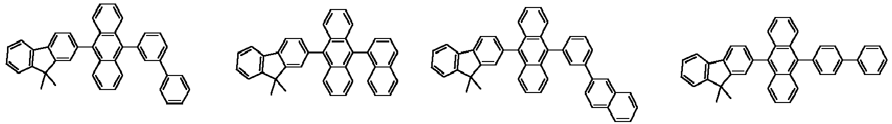

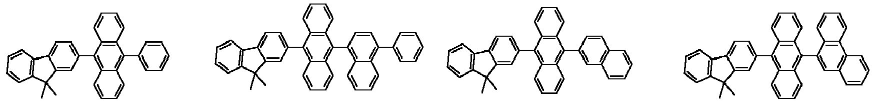

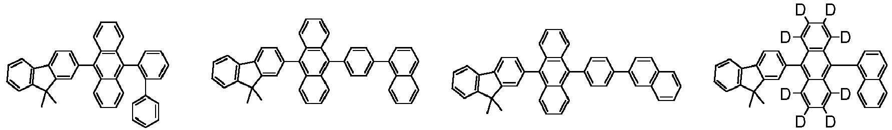

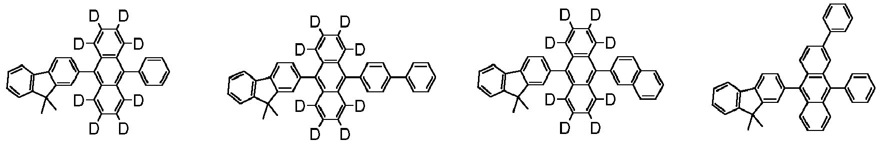

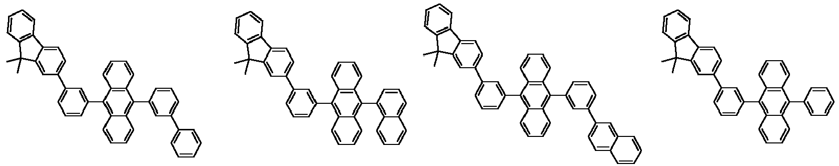

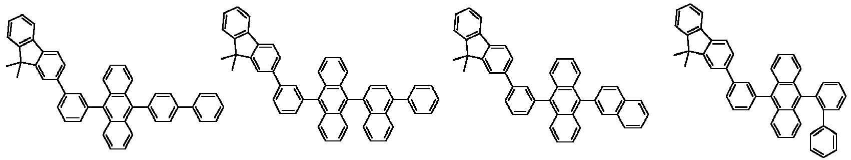

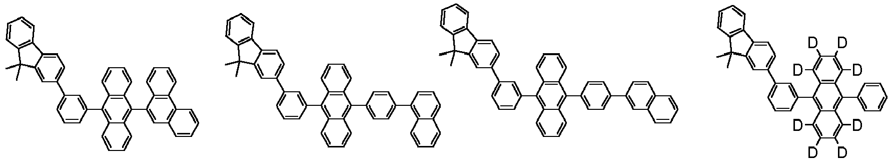

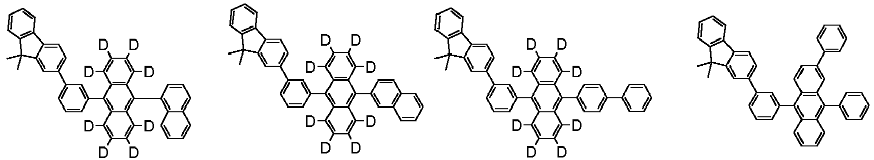

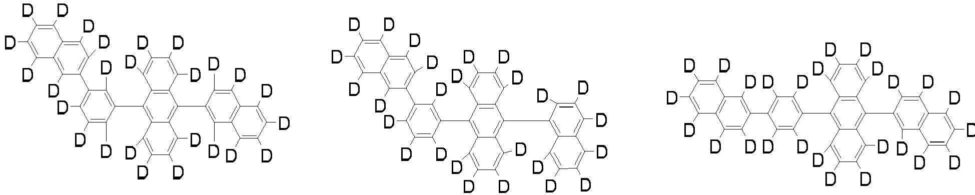

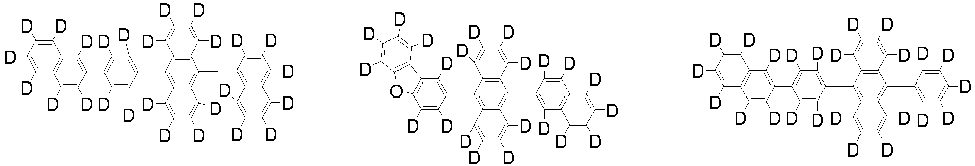

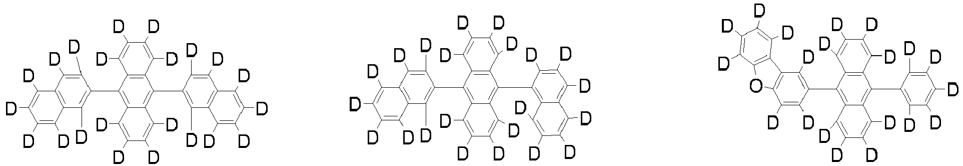

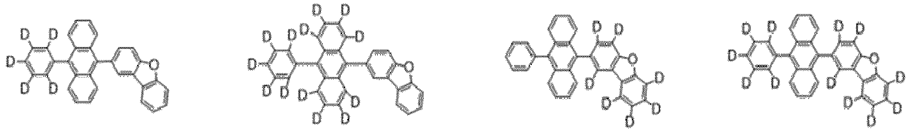

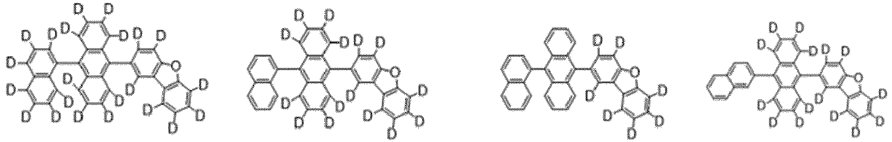

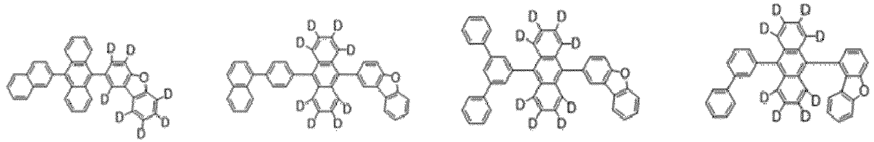

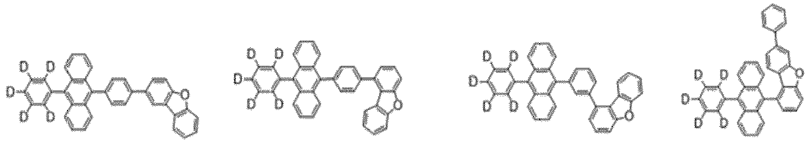

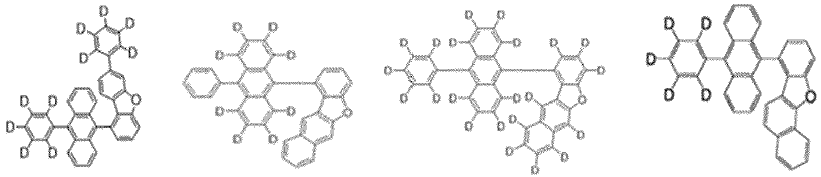

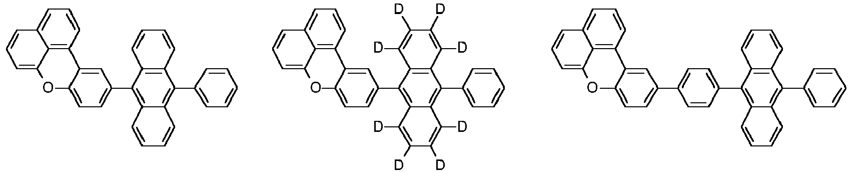

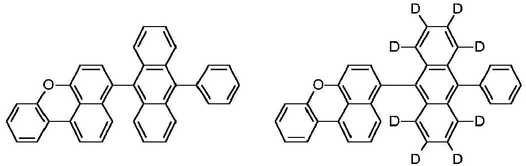

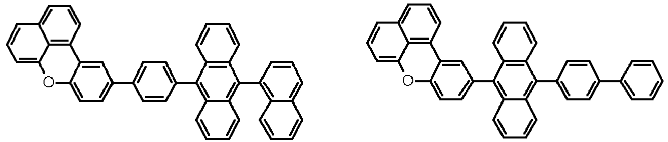

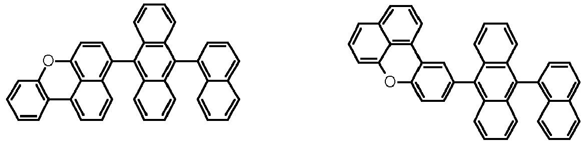

In the case that the emitting layer comprises the compound represented by formula (I) as a dopant and at least one host, wherein preferred hosts are mentioned above, and the host is more preferably at least one compound represented by formula (10), the content of the at least one compound represented by formula (I) is preferably 0.5 mass% to 70 mass%, more preferably 0.5 to 30 mass%, further preferably 1 to 30 mass%, still further preferably 1 to 20 mass%, and particularly preferably 1 to 10 mass%, further particularly preferably 1 to 5 mass%, relative to the entire mass of the emitting layer.

The content of the at least one host, wherein preferred hosts are mentioned above, preferably the at least one compound represented by formula (10) is preferably 30 mass% to 99.9 mass%, more preferably 70 to 99.5 mass%, further preferably 70 to 99 mass%, still further preferably 80 to 99 mass%, and particularly preferably 90 to 99 mass%, further particularly preferably 95 to 99 mass %, relative to the entire mass of the emitting layer.

**An explanation will be made on the layer configuration of the organic EL device according to one aspect of the invention.**

An organic EL device according to one aspect of the invention comprises a cathode, an anode, and one or more organic thin film layers comprising an emitting layer disposed between the cathode and the anode. The organic layer comprises at least one layer composed of an organic compound. Alternatively, the organic layer is formed by laminating a plurality of layers composed of an organic compound. The organic layer may further comprise an inorganic compound in addition to the organic compound.

At least one of the organic layers is an emitting layer. The organic layer may be constituted, for example, as a single emitting layer, or may comprise other layers which can be adopted in the layer structure of the organic EL device. The layer that can be adopted in the layer structure of the organic EL device is not particularly limited, but examples thereof include a hole-transporting zone (comprising at least one hole-transporting layer and preferably in addition at least one of a hole-injecting layer, an electron-blocking layer, an exciton-blocking layer, etc.), an emitting layer, a spacing layer, and an electron-transporting zone (comprising at least one electron-transporting layer and preferably in addition at least one of an electron-injecting layer, a hole-blocking layer, etc.) provided between the cathode and the emitting layer.

The organic EL device according to one aspect of the invention may be, for example, a fluorescent or phosphorescent monochromatic light emitting device or a fluorescent/phosphorescent hybrid white light emitting device. Preferably, the organic EL device is a fluorescent monochromatic light emitting device, more preferably a blue fluorescent monochromatic light emitting device or a fluorescent/phosphorescent hybrid white light emitting device. Blue fluorescence means a fluorescence at 400 to 500 nm (peak maximum), preferably at 430 nm to 490 nm (peak maximum).

Further, it may be a simple type device having a single emitting unit or a tandem type device having a plurality of emitting units.

The "emitting unit" in the specification is the smallest unit that comprises organic layers, in which at least one of the organic layers is an emitting layer and light is emitted by recombination of injected holes and electrons.

In addition, the "emitting layer" described in the present specification is an organic layer having an emitting function. The emitting layer is, for example, a phosphorescent emitting layer, a fluorescent emitting layer or the like, preferably a fluorescent emitting layer, more preferably a blue fluorescent emitting layer, and may be a single layer or a stack of a plurality of layers.

The emitting unit may be a stacked type unit having a plurality of phosphorescent emitting layers or fluorescent emitting layers. In this case, for example, a spacing layer for preventing excitons generated in the phosphorescent emitting layer from diffusing into the fluorescent emitting layer may be provided between the respective light-emitting layers.

As the simple type organic EL device, a device configuration such as anode/emitting unit/cathode can be given.

Examples for representative layer structures of the emitting unit are shown below. The layers in parentheses are provided arbitrarily.
(a) (Hole-injecting layer/) Hole-transporting layer/Fluorescent emitting layer (/Electron- transporting layer/Electron-injecting layer)
(b) (Hole-injecting layer/) Hole-transporting layer/Phosphorescent emitting layer (/Electron-transporting layer/Electron-injecting layer)
(c) (Hole-injecting layer/) Hole-transporting layer/First fluorescent emitting layer/Second fluorescent emitting layer (/Electron-transporting layer/Electron-injecting layer)
(d) (Hole-injecting layer/) Hole-transporting layer/First phosphorescent layer/Second phosphorescent layer (/Electron-transporting layer/Electron-injecting layer)
(e) (Hole-injecting layer/) Hole-transporting layer/Phosphorescent emitting layer/Spacing layer /Fluorescent emitting layer (/Electron-transporting layer/Electron-injecting layer)
(f) (Hole-injecting layer/) Hole-transporting layer/First phosphorescent emitting layer/Second phosphorescent emitting layer/Spacing layer/Fluorescent emitting layer (/Electron-transporting layer/Electron-injecting layer)
(g) (Hole-injecting layer/) Hole-transporting layer/First phosphorescent layer/Spacing layer/ Second phosphorescent emitting layer/Spacing layer/Fluorescent emitting layer (/Electron-transporting layer / Electron-injecting layer)
(h) (Hole-injecting layer/) Hole-transporting layer/Phosphorescent emitting layer/Spacing layer/First fluorescent emitting layer/Second fluorescent emitting layer (/Electron-transporting Layer/Electron-injecting Layer)
(i) (Hole-injecting layer/) Hole-transporting layer/Electron-blocking layer/Fluorescent emitting layer (/Electron-transporting layer/Electron-injecting layer)
(j) (Hole-injecting layer/) Hole-transporting layer/Electron-blocking layer/Phosphorescent emitting layer (/Electron-transporting layer /Electron-injecting layer)
(k) (Hole-injecting layer/) Hole-transporting layer/Exciton-blocking layer/Fluorescent emitting layer (/Electron-transporting layer/Electron-injecting layer)
(l) (Hole-injecting layer/) Hole-transporting layer/Exciton-blocking layer/Phosphorescent emitting layer (/Electron-transporting layer/Electron-injecting layer)
(m) (Hole-injecting layer/) First hole-transporting Layer/Second hole-transporting Layer/ Fluorescent emitting layer (/Electron-transporting layer/electron-injecting Layer)
(n) (Hole-injecting layer/) First hole-transporting layer/Second hole-transporting layer/ Fluorescent emitting layer (/First electron-transporting layer/Second electron-transporting layer /Electron-injection layer)
(o) (Hole-injecting layer/) First hole-transporting layer /Second hole-transporting layer/Phosphorescent emitting layer (/Electron-transporting layer /Electron-injecting Layer)
(p) (Hole-injecting layer/) First hole-transporting layer/Second hole-transporting layer /Phosphorescent emitting layer (/First electron-transporting Layer/Second electron-transporting layer /Electron-injecting layer)
(q) (Hole-injecting layer/) Hole-transporting layer/Fluorescent emitting layer/Hole-blocking layer (/Electron-transporting layer/Electron-injecting layer)
(r) (Hole-injecting layer /) Hole-transporting layer/Phosphorescent emitting layer/ Hole-blocking layer (/ Electron-transport layer/ Electron-injecting layer)
(s) (Hole-injecting layer/) Hole-transporting layer/Fluorescent emitting layer /Exciton-blocking layer (/Electron-transporting layer/Electron-injecting layer)
(t) (Hole-injecting layer/) Hole-transporting layer/Phosphorescent emitting layer /Exciton- blocking layer (/Electron-transporting layer/Electron-injecting layer)

The layer structure of the organic EL device according to one aspect of the invention is not limited to the examples mentioned above.

For example, when the organic EL device has a hole-injecting layer and a hole-transporting layer, it is preferred that a hole-injecting layer be provided between the hole-transporting layer and the anode. Further, when the organic EL device has an electron-injecting layer and an electron-transporting layer, it is preferred that an electron-injecting layer be provided between the electron-transporting layer and the cathode. Further, each of the hole-injecting layer, the hole-transporting layer, the electron-transporting layer and the electron-injecting layer may be formed of a single layer or be formed of a plurality of layers.

The plurality of phosphorescent emitting layer, and the plurality of the phosphorescent emitting layer and the fluorescent emitting layer may be emitting layers that emit mutually different colors. For example, the emitting unit (f) may include a hole-transporting layer/first phosphorescent layer (red light emission)/ second phosphorescent emitting layer (green light emission)/spacing layer/fluorescent emitting layer (blue light emission)/electron-transporting layer.

An electron-blocking layer may be provided between each light emitting layer and the hole-transporting layer or the spacing layer. Further, a hole-blocking layer may be provided between each emitting layer and the electron-transporting layer. By providing the electron-blocking layer or the hole-blocking layer, it is possible to confine electrons or holes in the emitting layer, thereby to improve the recombination probability of carriers in the emitting layer, and to improve light emitting efficiency.

As a representative device configuration of a tandem type organic EL device, for example, a device configuration such as anode/first emitting unit/intermediate layer/second emitting unit/cathode can be given.

The first emitting unit and the second emitting unit are independently selected from the above-mentioned emitting units, for example.

The intermediate layer is also generally referred to as an intermediate electrode, an intermediate conductive layer, a charge generating layer, an electron withdrawing layer, a connecting layer, a connector layer, or an intermediate insulating layer. The intermediate layer is a layer that supplies electrons to the first emitting unit and holes to the second emitting unit, and can be formed from known materials.

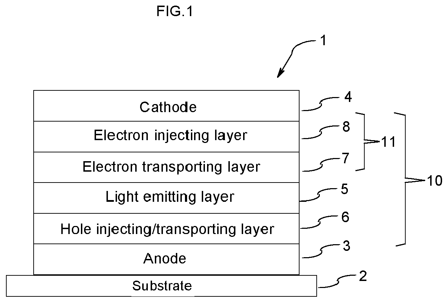

FIG. 1 shows a schematic configuration of one example of the organic EL device of the invention. The organic EL device 1 comprises a substrate 2, an anode 3, a cathode 4 and an emitting unit 10 provided between the anode 3 and the cathode 4. The emitting unit 10 comprises an emitting layer 5 preferably comprising a host material and a dopant. A hole injecting and transporting layer 6 or the like may be provided between the emitting layer 5 and the anode 3 and an electron injecting layer 8 and an electron transporting layer 7 or the like (electron injecting and transporting unit 11) may be provided between the emitting layer 5 and the cathode 4. An electron-barrier layer may be provided on the anode 3 side of the emitting layer 5 and a hole-barrier layer may be provided on the cathode 4 side of the emitting layer 5. Due to such configuration, electrons or holes can be confined in the emitting layer 5, whereby possibility of generation of excitons in the emitting layer 5 can be improved.

**Hereinbelow, an explanation will be made on function, materials, etc. of each layer constituting the organic EL device described in the present specification.**

### (Substrate)

The substrate is used as a support of the organic EL device. The substrate preferably has a light transmittance of 50% or more in the visible light region with a wavelength of 400 to 700 nm, and a smooth substrate is preferable. Examples of the material of the substrate include soda-lime glass, aluminosilicate glass, quartz glass, plastic and the like. As a substrate, a flexible substrate can be used. The flexible substrate means a substrate that can be bent (flexible), and examples thereof include a plastic substrate and the like. Specific examples of the material for forming the plastic substrate include polycarbonate, polyallylate, polyether sulfone, polypropylene, polyester, polyvinyl fluoride, polyvinyl chloride, polyimide, polyethylene naphthalate and the like. Also, an inorganic vapor deposited film can be used.

### (Anode)

As the anode, for example, it is preferable to use a metal, an alloy, a conductive compound, a mixture thereof or the like and having a high work function (specifically, 4.0 eV or more). Specific examples of the material of the anode include indium oxide-tin oxide (ITO: Indium Tin Oxide), indium oxide-tin oxide containing silicon or silicon oxide, indium oxide-zinc oxide, indium oxide containing tungsten oxide or zinc oxide, graphene and the like. In addition, it is also possible to use gold, silver, platinum, nickel, tungsten, chromium, molybdenum, iron, cobalt, copper, palladium, titanium, and nitrides of these metals (e.g. titanium oxide).

The anode is normally formed by depositing these materials on the substrate by a sputtering method. For example, indium oxide-zinc oxide can be formed by a sputtering method by using a target in which 1 to 10 mass% zinc oxide is added relative to indium oxide. Further, indium oxide containing tungsten oxide or zinc oxide can be formed by a sputtering method by using a target in which 0.5 to 5 mass% of tungsten oxide or 0.1 to 1 mass% of zinc oxide is added relative to indium oxide.

As other methods for forming the anode, a vacuum deposition method, a coating method, an inkjet method, a spin coating method or the like can be given. When silver paste or the like is used, it is possible to use a coating method, an inkjet method or the like.

The hole-injecting layer formed in contact with the anode is formed by using a material that allows easy hole injection regardless of the work function of the anode. For this reason, in the anode, it is possible to use a common electrode material, e.g. a metal, an alloy, a conductive compound and a mixture thereof. Specifically, a material having a small work function such as alkaline metals such as lithium and cesium; alkaline earth metals such as calcium and strontium; alloys containing these metals (for example, magnesium-silver and aluminum-lithium); rare earth metals such as europium and ytterbium; and an alloy containing rare earth metals.

### (Hole-transporting layer) / (Hole-injecting layer)

The hole-transporting layer is an organic layer that is formed between the emitting layer and the anode, and has a function of transporting holes from the anode to the emitting layer. If the hole-transporting layer is composed of plural layers, an organic layer that is nearer to the anode may often be defined as the hole-injecting layer. The hole-injecting layer has a function of injecting holes efficiently to the organic layer unit from the anode. Said hole injection layer is generally used for stabilizing hole injection from anode to hole transporting layer which is generally consist of organic materials. Organic material having good contact with anode or organic material with p-type doping is preferably used for the hole injection layer.

p-doping usually consists of one or more p-dopant materials and one or more matrix materials. Matrix materials preferably have shallower HOMO level and p-dopant preferably have deeper LUMO level to enhance the carrier density of the layer. Specific examples for p-dopants are the below mentioned acceptor materials. Suitable matrix materials are the hole transport materials mentioned below, preferably aromatic or heterocyclic amine compounds.

Acceptor materials, or fused aromatic hydrocarbon materials or fused heterocycles which have high planarity, are preferably used as p-dopant materials for the hole injection layer.

Specific examples for acceptor materials are, quinone compounds with one or more electron withdrawing groups, such as F₄TCNQ (2,3,5,6-tetrafluoro-7,7,8,8-tetracyanoquinodimethane), and 1,2,3-tris[(cyano)(4-cyano-2,3,5,6-tetrafluorophenyl)methylene]cyclopropane; hexa-azatriphenylene compounds with one or more electron withdrawing groups, such as hexa-azatriphenylene-hexanitrile; aromatic hydrocarbon compounds with one or more electron withdrawing groups; and aryl boron compounds with one or more electron withdrawing groups. Preferred p-dopants are quinone compounds with one or more electron withdrawing groups, such as F₄TCNQ, 1,2,3-Tris[(cyano)(4-cyano-2,3,5,6-tetrafluorophenyl)methylene]cyclopropane.

The ratio of the p-type dopant is preferably less than 20% of molar ratio, more preferably less than 10%, such as 1%, 3%, or 5%, related to the matrix material.

The hole transporting layer is generally used for injecting and transporting holes efficiently, and aromatic or heterocyclic amine compounds are preferably used.

Specific examples for compounds for the hole transporting layer are represented by the general formula (H), 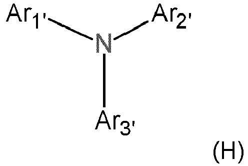 wherein
Ar_{1'} to Ar_{3'} each independently represents substituted or unsubstituted aryl group having 5 to 50 carbon atoms or substituted or unsubstituted heterocyclic group having 5 to 50 cyclic atoms, preferably phenyl group, biphenyl group, terphenyl group, naphthyl group, phenanthryl group, triphenylenyl group, fluorenyl group, spirobifluorenyl group, indenofluorenyl group, carbazolyl group, dibenzofuranyl group, dibenzothiophenyl group, carbazole substituted aryl group, dibenzofuran substituted aryl group or dibenzothiophene substituted aryl group; two or more substituents selected among Ar_{1'} to Ar_{3'} may be bonded to each other to form a ring structure, such as a carbazole ring structure, or a acridane ring structure.

Preferably, at least one of Ar_{1'} to Ar_{3'} have additional one aryl or heterocyclic amine substituent, more preferably Ar_{1'} has an additional aryl amino substituent, at the case of that it is preferable that Ar_{1'} represents substituted or unsubstituted biphenylene group, substituted or unsubstituted fluorenylene group. Specific examples for the hole transport material are 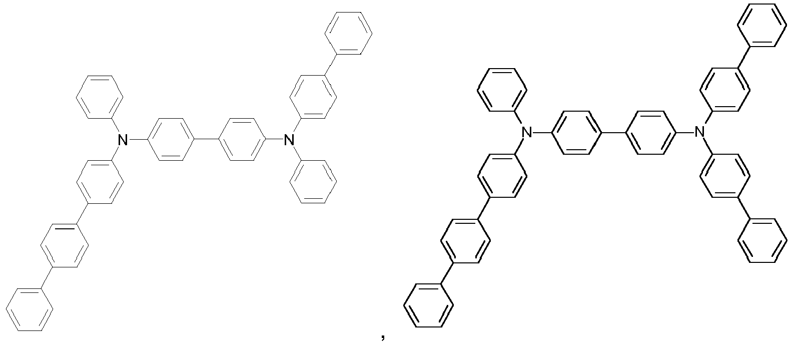 and 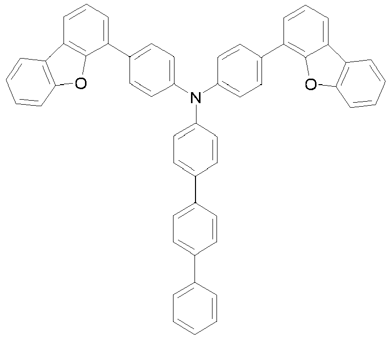 and the like.

A second hole transporting layer is preferably inserted between the first hole transporting layer and the emitting layer to enhance device performance by blocking excess electrons or excitons. Specific examples for second hole transporting layer are the same as for the first hole transporting layer. It is preferred that second hole transporting layer has higher triplet energy to block triplet excitons, especially for phosphorescent devices, such as bicarbazole compounds, biphenylamine compounds, triphenylenyl amine compounds, fluorenyl amine compounds, carbazole substituted arylamine compounds, dibenzofuran substituted arylamine compounds, and dibenzothiophene substituted arylamine compounds.

### (Emitting layer)

The emitting layer is a layer containing a substance having a high emitting property (emitter material or dopant material). As the dopant material, various materials can be used. For example, a fluorescent emitting compound (fluorescent dopant), a phosphorescent emitting compound (phosphorescent dopant) or the like can be used. A fluorescent emitting compound is a compound capable of emitting light from the singlet excited state, and an emitting layer containing a fluorescent emitting compound is called a fluorescent emitting layer. Further, a phosphorescent emitting compound is a compound capable of emitting light from the triplet excited state, and an emitting layer containing a phosphorescent emitting compound is called a phosphorescent emitting layer.

Preferably, the emitting layer in the organic EL device of the present application comprises a compound of formula (I) as a dopant material.

The emitting layer preferably comprises at least one dopant material and at least one host material that allows it to emit light efficiently. In some literatures, a dopant material is called a guest material, an emitter or an emitting material. In some literatures, a host material is called a matrix material.

A single emitting layer may comprise plural dopant materials and plural host materials. Further, plural emitting layers may be present.

In the present specification, a host material combined with the fluorescent dopant is referred to as a "fluorescent host" and a host material combined with the phosphorescent dopant is referred to as the "phosphorescent host". Note that the fluorescent host and the phosphorescent host are not classified only by the molecular structure. The phosphorescent host is a material for forming a phosphorescent emitting layer containing a phosphorescent dopant, but does not mean that it cannot be used as a material for forming a fluorescent emitting layer. The same can be applied to the fluorescent host.

In one embodiment, it is preferred that the emitting layer comprises the compound represented by formula (I) according to the present invention (hereinafter, these compounds may be referred to as the "compound (I)"). More preferably, it is contained as a dopant material. Further, it is preferred that the compound (I) be contained in the emitting layer as a fluorescent dopant. Even further, it is preferred that the compound (I) be contained in the emitting layer as a blue fluorescent dopant.

In one embodiment, no specific restrictions are imposed on the content of the compound (I) as the dopant material in the emitting layer. In respect of sufficient emission and concentration quenching, the content is preferably 0.5 to 70 mass%, more preferably 0.8 to 30 mass%, further preferably 1 to 30 mass%, still further preferably 1 to 20 mass%, and particularly preferably 1 to 10 mass%, further particularly preferably 1 to 5 mass%, even further particularly preferably 2 to 4 mass%, related to the mass of the emitting layer.

### (Fluorescent dopant)

As a fluorescent dopant other than the compound (I), a fused polycyclic aromatic compound, a styrylamine compound, a fused ring amine compound, a boron-containing compound, a pyrrole compound, an indole compound, a carbazole compound can be given, for example. Among these, a fused ring amine compound, a boron-containing compound, carbazole compound is preferable.

As the fused ring amine compound, a diaminopyrene compound, a diaminochrysene compound, a diaminoanthracene compound, a diaminofluorene compound, a diaminofluorene compound with which one or more benzofuro skeletons are fused, or the like can be given.

As the boron-containing compound, a pyrromethene compound, a triphenylborane compound or the like can be given.

As a blue fluorescent dopant, pyrene compounds, styrylamine compounds, chrysene compounds, fluoranthene compounds, fluorene compounds, diamine compounds, triarylamine compounds and the like can be given, for example. Specifically, N,N'-bis[4-(9H-carbazol-9-yl)phenyl]-N,N'-diphenylstilbene-4,4'-diamine (abbreviation: YGA2S), 4-(9H-carbazol-9-yl)-4'-(10-phenyl-9-anthryl)triphenyamine (abbreviation: YGAPA), 4-(10-phenyl-9-anthryl)-4'-(9-phenyl-9H-carbazole-3-yl)triphenylamine (abbreviation: PCBAPA) or the like can be given.

As a green fluorescent dopant, an aromatic amine compound or the like can be given, for example. Specifically, N-(9,10-diphenyl-2-anthryl)-N,9-diphenyl-9H-carbazole-3-amine (abbreviation: 2PCAPA), N-[9,10-bis(1,1'-biphenyl-2-yl)-2-anthryl]-N,9-diphenyl-9H-carbazole-3-amine (abbreviation: 2PCABPhA), N-(9,10-diphenyl-2-anthryl)-N,N',N'-triphenyl-1,4-phenylenediamine (abbreviation: 2DPAPA), N-[9,10-bis(1,1'-biphenyl-2-yl)-2-anthryl]-N,N',N'-triphenyl-1,4-phenylenediamine (abbreviation: 2DPABPhA), N-[9,10-bis(1,1'-biphenyl-2-yl)]-N-[4-(9H-carbazole-9-yl)phenyl]-N-phenylanthracene-2-amine (abbreviation: 2YGABPhA), N,N,9-triphenylanthracene-9-amine (abbreviation: DPhAPhA) or the like can be given, for example.

As a red fluorescent dopant, a tetracene compound, a diamine compound or the like can be given. Specifically, N,N,N',N'-tetrakis(4-methylphenyl)tetracene-5,11-diamine (abbreviation: p-mPhTD), 7,14-diphenyl-N,N,N',N'-tetrakis(4-methylphenyl)acenaphtho[1,2-a]fluoranthene-3,10-diamine (abbreviation: p-mPhAFD) or the like can be given.

### (Phosphorescent dopant)

As a phosphorescent dopant, a phosphorescent emitting heavy metal complex and a phosphorescent emitting rare earth metal complex can be given.

As the heavy metal complex, an iridium complex, an osmium complex, a platinum complex or the like can be given. The heavy metal complex is for example an ortho-metalated complex of a metal selected from iridium, osmium and platinum.

Examples of rare earth metal complexes include terbium complexes, europium complexes and the like. Specifically, tris(acetylacetonate)(monophenanthroline)terbium(III) (abbreviation: Tb(acac)₃(Phen)), tris(1,3-diphenyl-1,3-propandionate)(monophenanthroline)europium(III) (abbreviation: Eu(DBM)₃(Phen)), tris[1-(2-thenoyl)-3,3,3-trifluoroacetonate](monophenanthroline)europium(III) (abbreviation: Eu(TTA)₃(Phen)) or the like can be given. These rare earth metal complexes are preferable as phosphorescent dopants since rare earth metal ions emit light due to electronic transition between different multiplicity.

As a blue phosphorescent dopant, an iridium complex, an osmium complex, a platinum complex, or the like can be given, for example. Specifically, bis[2-(4',6'-difluorophenyl)pyridinate-N,C2']iridium(III) tetrakis(1-pyrazolyl)borate (abbreviation: Flr6), bis[2-(4',6'-difluorophenyl) pyridinato-N,C2']iridium(III) picolinate (abbreviation: Ir(CF₃ppy)₂(pic)), bis[2-(4',6'-difluorophenyl)pyridinato-N,C2']iridium(III) acetylacetonate (abbreviation: Flracac) or the like can be given.

As a green phosphorescent dopant, an iridium complex or the like can be given, for example. Specifically, tris(2-phenylpyridinato-N,C2') iridium(III) (abbreviation: Ir(ppy)₃), bis(1,2-diphenyl-1H-benzimidazolato)iridium(III) acetylacetonate (abbreviation: Ir(pbi)₂(acac)), bis(benzo[h]quinolinato)iridium(III) acetylacetonate (abbreviation: Ir(bzq)₂(acac)) or the like can be given.

As a red phosphorescent dopant, an iridium complex, a platinum complex, a terbium complex, a europium complex or the like can be given. Specifically, bis[2-(2'-benzo[4,5-α]thienyl)pyridinato-N,C3']iridium(III) acetylacetonate (abbreviation: Ir(btp)₂(acac)), bis(1-phenylisoquinolinato-N,C2')iridium(III) acetylacetonate (abbreviation: Ir(piq)₂(acac)), (acetylacetonato)bis[2,3-bis(4-fluorophenyl)quinoxalinato]iridium(III) (abbreviation: Ir(Fdpq)₂(acac)), 2,3,7,8,12,13,17,18-octaethyl-21H,23H-porphyrin platinum(II) (abbreviation PtOEP) or the like can be given.

As mentioned above, the emitting layer preferably comprises at least one compound (I) as a dopant.

### (Host material)

As host material, metal complexes such as aluminum complexes, beryllium complexes and zinc complexes; heterocyclic compounds such as indole compounds, pyridine compounds, pyrimidine compounds, triazine compounds, quinoline compounds, isoquinoline compounds, quinazoline compounds, dibenzofuran compounds, dibenzothiophene compounds, oxadiazole compounds, benzimidazole compounds, phenanthroline compounds; fused polyaromatic hydrocarbon (PAH) compounds such as a naphthalene compound, a triphenylene compound, a carbazole compound, an anthracene compound, a phenanthrene compound, a pyrene compound, a chrysene compound, a naphthacene compound, a fluoranthene compound; and aromatic amine compound such as triarylamine compounds and fused polycyclic aromatic amine compounds can be given, for example. Plural types of host materials can be used in combination.

As a **fluorescent** host, a compound having a higher singlet energy level than a fluorescent dopant is preferable. For example, a heterocyclic compound, a fused aromatic compound or the like can be given. As a fused aromatic compound, an anthracene compound, a pyrene compound, a chrysene compound, a naphthacene compound or the like are preferable. An anthracene compound is preferentially used as blue fluorescent host.

In the case that compound (I) is employed as at least one dopant material, preferred host materials are substituted or unsubstituted polyaromatic hydrocarbon (PAH) compounds, substituted or unsubstituted polyheteroaromatic compounds, substituted or unsubstituted anthracene compounds, or substituted or unsubstituted pyrene compounds, preferably substituted or unsubstituted anthracene compounds or substituted or unsubstituted pyrene compounds, more preferably substituted or unsubstituted anthracene compounds, most preferably anthracene compounds represented by formula (10), as mentioned above.

As a **phosphorescent host**, a compound having a higher triplet energy level as compared with a phosphorescent dopant is preferable. For example, a metal complex, a heterocyclic compound, a fused aromatic compound or the like can be given. Among these, an indole compound, a carbazole compound, a pyridine compound, a pyrimidine compound, a triazine compound, a quinolone compound, an isoquinoline compound, a quinazoline compound, a dibenzofuran compound, a dibenzothiophene compound, a naphthalene compound, a triphenylene compound, a phenanthrene compound, a fluoranthene compound or the like can be given.

### (Electron-transporting layer) / (Electron-injecting layer)

The electron-transporting layer is an organic layer that is formed between the emitting layer and the cathode and has a function of transporting electrons from the cathode to the emitting layer. When the electron-transporting layer is formed of plural layers, an organic layer or an inorganic layer that is nearer to the cathode is often defined as the electron injecting layer (see for example layer 8 in FIG. 1, wherein an electron injecting layer 8 and an electron transporting layer 7 form an electron injecting and transporting unit 11). The electron injecting layer has a function of injecting electrons from the cathode efficiently to the organic layer unit. Preferred electron injection materials are alkali metal, alkali metal compounds, alkali metal complexes, the alkaline earth metal complexes and the rare earth metal complexes.

According to one embodiment, it is preferred that the electron-transporting layer further comprises one or more layer(s) like a second electron-transporting layer, an electron injection layer to enhance efficiency and lifetime of the device, a hole blocking layer, an exciton blocking layer or a triplet blocking layer.

According to one embodiment, it is preferred that an electron-donating dopant be contained in the interfacial region between the cathode and the emitting unit. Due to such a configuration, the organic EL device can have an increased luminance or a long life. Here, the electron-donating dopant means one having a metal with a work function of 3.8 eV or less. As specific examples thereof, at least one selected from an alkali metal, an alkali metal complex, an alkali metal compound, an alkaline earth metal, an alkaline earth metal complex, an alkaline earth metal compound, a rare earth metal, a rare earth metal complex and a rare earth metal compound or the like can be mentioned.

As the alkali metal, Li (work function: 2.9 eV), Na (work function: 2.36 eV), K (work function: 2.28 eV), Rb (work function: 2.16 eV), Cs (work function: 1.95 eV) and the like can be given. One having a work function of 2.9 eV or less is particularly preferable. Among them, K, Rb and Cs are preferable. Rb or Cs is further preferable. Cs is most preferable. As the alkaline earth metal, Ca (work function: 2.9 eV), Sr (work function: 2.0 eV to 2.5 eV), Ba (work function: 2.52 eV) and the like can be given. One having a work function of 2.9 eV or less is particularly preferable. As the rare-earth metal, Sc, Y, Ce, Tb, Yb and the like can be given. One having a work function of 2.9 eV or less is particularly preferable.

Examples of the alkali metal compound include an alkali oxide such as Li₂O, Cs₂O or K₂O, and an alkali halide such as LiF, NaF, CsF and KF. Among them, LiF, Li₂O and NaF are preferable. Examples of the alkaline earth metal compound include BaO, SrO, CaO, and mixtures thereof such as BaₓSr₁₋ₓO (0<x<1) and BaₓCa₁₋ₓO (0<x<1). Among them, BaO, SrO and CaO are preferable. Examples of the rare earth metal compound include YbF₃, ScF₃, ScO₃, Y₂O₃, Ce₂O₃, GdF₃ and TbF₃. Among these, YbF₃, ScF₃ and TbF₃ are preferable.

The alkali metal complexes, the alkaline earth metal complexes and the rare earth metal complexes are not particularly limited as long as they contain, as a metal ion, at least one of alkali metal ions, alkaline earth metal ions, and rare earth metal ions. Meanwhile, preferred examples of the ligand include, but are not limited to, quinolinol, benzoquinolinol, acridinol, phenanthridinol, hydroxyphenyloxazole, hydroxyphenylthiazole, hydroxydiaryloxadiazole, hydroxydiarylthiadiazole, hydroxyphenylpyridine, hydroxyphenylbenzimidazole, hydroxybenzotriazole, hydroxyfluborane, bipyridyl, phenanthroline, phthalocyanine, porphyrin, cyclopentadiene, β-diketones, and azomethines.

Regarding the addition form of the electron-donating dopant, it is preferred that the electron-donating dopant be formed in a shape of a layer or an island in the interfacial region. A preferred method for the formation is a method in which an organic compound (a light emitting material or an electron-injecting material) for forming the interfacial region is deposited simultaneously with deposition of the electron-donating dopant by a resistant heating deposition method, thereby dispersing the electron-donating dopant in the organic compound.

In a case where the electron-donating dopant is formed into the shape of a layer, the light-emitting material or electron-injecting material which serves as an organic layer in the interface is formed into the shape of a layer. After that, a reductive dopant is solely deposited by the resistant heating deposition method to form a layer preferably having a thickness of from 0.1 nm to 15 nm. In a case where the electron-donating dopant is formed into the shape of an island, the emitting material or the electron-injecting material which serves as an organic layer in the interface is formed into the shape of an island. After that, the electron-donating dopant is solely deposited by the resistant heating deposition method to form an island preferably having a thickness of from 0.05 nm to 1 nm. As the electron-transporting material used in the electron-transporting layer other than a compound of the formula (I), an aromatic heterocyclic compound having one or more hetero atoms in the molecule may preferably be used. In particular, a nitrogen-containing heterocyclic compound is preferable.

According to one embodiment, it is preferable that the electron-transporting layer comprises a nitrogen-containing heterocyclic metal chelate.

According to the other embodiment, it is preferable that the electron-transporting layer comprises a substituted or unsubstituted nitrogen containing heterocyclic compound. Specific examples of preferred heterocyclic compounds for the electron-transporting layer are, 6-membered azine compounds; such as pyridine compounds, pyrimidine compounds, triazine compounds, pyrazine compounds, preferably pyrimidine compounds or triazine compounds; 6-membered fused azine compounds, such as quinolone compounds, isoquinoline compounds, quinoxaline compounds, quinazoline compounds, phenanthroline compounds, benzoquinoline compounds, benzoisoquinoline compounds, dibenzoquinoxaline compounds, preferably quinolone compounds, isoquinoline compounds, phenanthroline compounds; 5-membered heterocyclic compounds, such as imidazole compounds, oxazole compounds, oxadiazole compounds, triazole compounds, thiazole compounds, thiadiazole compounds; fused imidazole compounds, such as benzimidazole compounds, imidazopyridine compounds, naphthoimidazole compounds, benzimidazophenanthridine compounds, benzimidzobenzimidazole compounds, preferably benzimidazole compounds, imidazopyridine compounds or benzimidazophenanthridine compounds.

According to another embodiment, it is preferable the electron-transporting layer comprises a phosphine oxide compound represented as Arₚ₁Arₚ₂Ar_{P3}P=O.

Arₚ₁ to Arₚ₃ are the substituents of phosphor atom and each independently represent substituted or unsubstituted above mentioned aryl group or substituted or unsubstituted above mentioned heterocyclic group.

According to another embodiment, it is preferable that the electron-transporting layer comprises aromatic hydrocarbon compounds. Specific examples of preferred aromatic hydrocarbon compounds for the electron-transporting layer are, oligo-phenylene compounds, naphthalene compounds, fluorene compounds, fluoranthenyl group, anthracene compounds, phenanthrene compounds, pyrene compounds, triphenylene compounds, benzanthracene compounds, chrysene compounds, benzphenanthrene compounds, naphthacene compounds, and benzochrysene compounds, preferably anthracene compounds, pyrene compounds and fluoranthene compounds.

### (Cathode)

For the cathode, a metal, an alloy, an electrically conductive compound, and a mixture thereof, each having a small work function (specifically, a work function of 3.8 eV or less) are preferably used. Specific examples of a material for the cathode include an alkali metal such as lithium and cesium; an alkaline earth metal such as magnesium, calcium, and strontium; aluminum, an alloy containing these metals (for example, magnesium-silver, aluminum-lithium); a rare earth metal such as europium and ytterbium; and an alloy containing a rare earth metal.

The cathode is usually formed by a vacuum vapor deposition or a sputtering method. Further, in the case of using a silver paste or the like, a coating method, an inkjet method, or the like can be employed.

Moreover, various electrically conductive materials such as silver, ITO, graphene, indium oxide-tin oxide containing silicon or silicon oxide, selected independently from the work function, can be used to form a cathode. These electrically conductive materials are made into films using a sputtering method, an inkjet method, a spin coating method, or the like.

### (Insulating layer)

In the organic EL device, pixel defects based on leakage or a short circuit are easily generated since an electric field is applied to a thin film. In order to prevent this, it is preferred to insert an insulating thin layer between a pair of electrodes. Examples of materials used in the insulating layer include aluminum oxide, lithium fluoride, lithium oxide, cesium fluoride, cesium oxide, magnesium oxide, magnesium fluoride, calcium oxide, calcium fluoride, aluminum nitride, titanium oxide, silicon oxide, germanium oxide, silicon nitride, boron nitride, molybdenum oxide, ruthenium oxide, and vanadium oxide. A mixture thereof may be used in the insulating layer, and a laminate of a plurality of layers that include these materials can be also used for the insulating layer.

### (Spacing layer)

A spacing layer is a layer provided between a fluorescent emitting layer and a phosphorescent emitting layer when a fluorescent emitting layer and a phosphorescent emitting layer are stacked in order to prevent diffusion of excitons generated in the phosphorescent emitting layer to the fluorescent emitting layer or in order to adjust the carrier balance. Further, the spacing layer can be provided between the plural phosphorescent emitting layers.

Since the spacing layer is provided between the emitting layers, the material used for the spacing layer is preferably a material having both electron-transporting capability and hole-transporting capability. In order to prevent diffusion of the triplet energy in adjacent phosphorescent emitting layers, it is preferred that the spacing layer have a triplet energy of 2.6 eV or more. As the material used for the spacing layer, the same materials as those used in the above-mentioned hole-transporting layer can be given.

### (Electron-blocking layer, hole-blocking layer, exciton-blocking layer)

An electron-blocking layer, a hole-blocking layer, an exciton (triplet)-blocking layer, and the like may be provided in adjacent to the emitting layer.

The electron-blocking layer has a function of preventing leakage of electrons from the emitting layer to the hole-transporting layer. The hole-blocking layer has a function of preventing leakage of holes from the emitting layer to the electron-transporting layer. In order to improve hole blocking capability, a material having a deep HOMO level is preferably used. The exciton-blocking layer has a function of preventing diffusion of excitons generated in the emitting layer to the adjacent layers and confining the excitons within the emitting layer. In order to improve triplet block capability, a material having a high triplet level is preferably used.

### (Method for forming a layer)

The method for forming each layer of the organic EL device of the invention is not particularly limited unless otherwise specified. A known film-forming method such as a dry film-forming method, a wet film-forming method or the like can be used. Specific examples of the dry film-forming method include a vacuum deposition method, a sputtering method, a plasma method, an ion plating method, and the like. Specific examples of the wet film-forming method include various coating methods such as a spin coating method, a dipping method, a flow coating method, an inkjet method, and the like.

### (Film thickness)

The film thickness of each layer of the organic EL device of the invention is not particularly limited unless otherwise specified. If the film thickness is too small, defects such as pinholes are likely to occur to make it difficult to obtain a sufficient luminance. If the film thickness is too large, a high driving voltage is required to be applied, leading to a lowering in efficiency. In this respect, the film thickness is preferably 0.1 nm to 10 µm, and more preferably 5 nm to 0.2 µm.

### (Electronic apparatus (electronic equipment))

The present invention further relates to an electronic equipment (electronic apparatus) comprising the organic electroluminescence device according to the present application. Examples of the electronic apparatus include display parts such as an organic EL panel module; display devices of television sets, mobile phones, smart phones, and personal computer, and the like; and emitting devices of a lighting device and a vehicle lighting device.

### EXAMPLES

Next, the invention will be explained in more detail in accordance with the following synthesis examples, examples, and comparative examples, which should not be construed as limiting the scope of the invention.

The percentages and ratios mentioned in the examples below - unless stated otherwise - are % by weight and weight ratios.

### I Synthesis Examples

All experiments are carried out in protective gas atmosphere.

### Compound 1

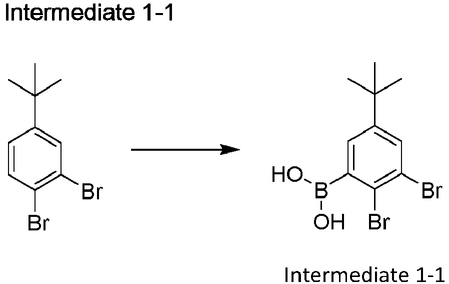

42.0 ml (249.0 mmol) of 2,2,6,6-tetramethylpiperidine was dissolved in 250 ml of THF, and the solution was cooled to -78 °C before 100 ml (250 mmol) of 2.5M n-butyllithium in hexane was added dropwise via a cannula for 30 min. The solution was stirred at -78 °C for 30 min. 67.0 ml (290.5 mmol) of triisopropyl borate was added slowly within 30 min, and the mixture was stirred at -78 °C for 1 hour before a solution of 24.24 g (83.0 mmol) of 1,2-dibromo-4-(*tert-*butyl)benzene in 50 ml of THF was added dropwise within 45 min at -78 °C. Then, the mixture was warmed to room temperature overnight. The reaction mixture was poured into 300 ml of ice-cold 1 N HCl, and the aqueous layer was extracted with ethylacetate. The organic layer was washed with brine, dried over magnesium sulfate, filtered and concentrated. The crude product was used for the next reaction without purification.

**¹H NMR** (300 MHz, DMSO-d₆) δ 8.44 (s, 2H), 7.62 (d, 1H), 7.27 (d, 1H), 1.25 (s, 9H).

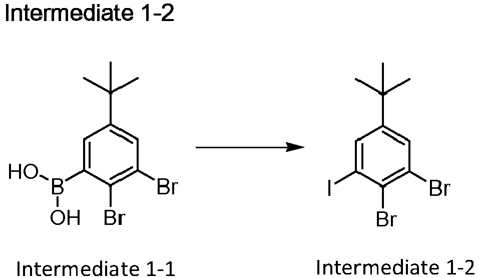

27.9 g (82.96 mmol) of Intermediate 1-1 and 1.63 g (16.6 mmol) of potassium acetate were suspended in 332 ml of acetonitrile. Then, 22.4 g (99.5 mmol) of N-iodosuccinimide was added to the suspension at room temperature, and the mixture was stirred overnight. The reaction mixture was quenched with 300 ml of 10% aqueous sodium sulfite solution. The aqueous layer was extracted with toluene, and the organic layer was washed with brine, dried over magnesium sulfate, filtered and concentrated. The crude product was purified by silica-gel column chromatography using heptane as eluent to give 22.1 g (61% yield) of Intermediate 1-2 as a white solid.

**¹H NMR** (300 MHz, CD₂Cl₂) δ 7.87 (d, 1H), 7.67 (d, 1H), 1.31 (s, 9H).

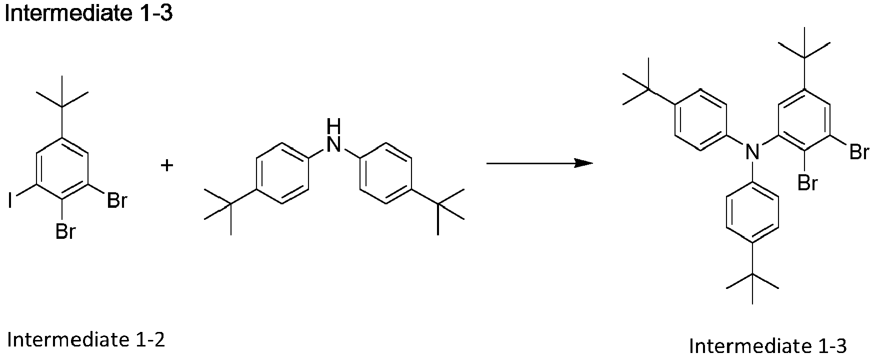

12.4 g (29.7 mmol) of Intermediate 1-2, 7.96 g (28.3 mmol) of bis(4-(*tert*-butyl)phenylamine, and 3.81 g (39.6 mmol) of sodium *tert-*butoxide were added to 190 ml of toluene. The suspension was degassed using 3 freeze-pump-thaw cycles, and 777 mg (0.85 mmol) of tris(dibenzylideneacetone)dipalladium(0) and 982 mg (1.70 mmol) of xantphos were added to the reaction mixture. After two additional freeze-pump-thaw cycles, the reaction mixture was heated to 90 °C for 19 hours. The reaction was cooled to room temperature and diluted with toluene. The organic extracts were washed with water and dried over magnesium sulfate, filtered, and the solution was concentrated. The residue was purified by silica-gel column chromatography using cyclohexane as eluent to give 8.62g (53% yield) of Intermediate 1-3 as a white solid.

**ESI-MS** (positive, m/z): exact mass of C₃₀H₃₇Br₂N = 569.13; found 570.2 [M+1]⁺.

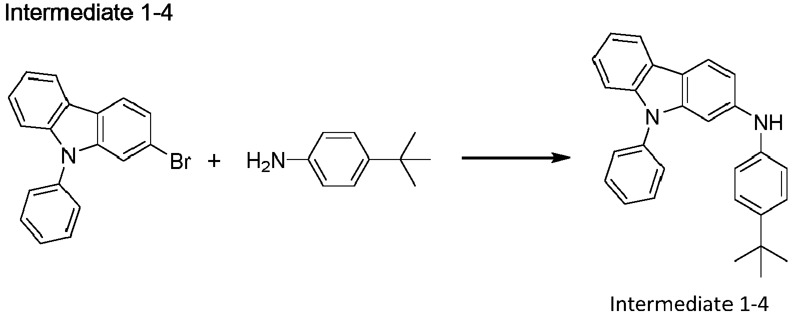

50.0 g (0.16 mol) of 2-bromo-9-phenyl-9H-carbazole, 28.0 g (0.19 mol) of 4-(*tert-*butyl)aniline, 1.42 g (1.55 mmol) of tris(dibenzylideneacetone)dipalladium(0), 1.94 g (3.10 mmol) of 2,2'-bis(diphenylphosphino)-1,1'-binaphthalene (BINAP), and 37.3 g (0.39 mol) of sodium *tert-*butoxide were suspended in 500 ml of toluene. The brown suspension was three times evacuated and backfilled with argon and heated at 104 °C during two hours. The reaction mixture was cooled down to room temperature and filtered through a 5 cm layer of silica gel, followed by rinsing the silica gel layer with 500 ml of dichloromethane. The collected eluents were concentrated under vacuum and the resulting brown resin dissolved in 500 ml of hot heptane. The solution was cooled down to room temperature and stirred until a suspension formed. The suspension was filtered and the solid washed with heptane. The solid was dissolved in 350 ml of heptane and 50 ml of dichloromethane. 150 ml of solvent were distilled off under vacuum. The remaining solution was stirred at room temperature during two hours until a suspension formed. The suspension was filtered and the solid was washed with 30 ml of heptane to give 42.1 g (69% yield) of Intermediate 1-4 as a beige solid.

**ESI-MS** (positive, m/z): exact mass of C₂₈H₂₆N₂ = 390.21; found 391.4 [M+1]⁺.

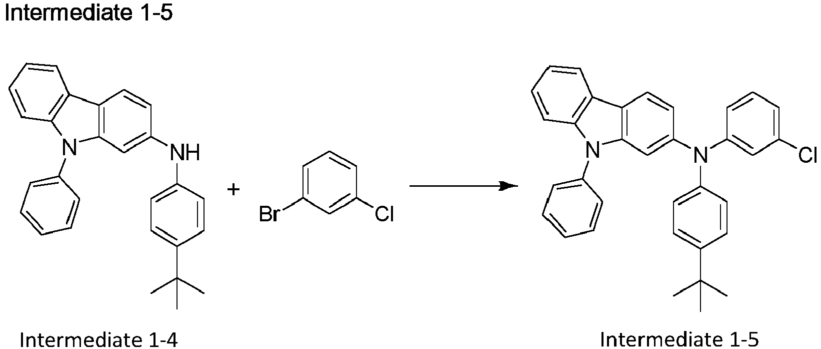

42.0 g (108 mmol) of Intermediate 1-4, 22.0 g (115 mmol) of 1-bromo-3-chlorobenzene, 0.25 g (0.27 mmol) of tris(dibenzylideneacetone)dipalladium(0), 0.32 g (1.08 mmol) of tri-*tert*-butyl¬phosphonium tetrafluoroborate, and 14.5 g (0.15 mol) of sodium *tert-*butoxide were suspended in 450 ml of toluene. The brown suspension was three times evacuated and backfilled with argon and heated at 89 °C during one hour. The orange suspension was diluted with 500 ml of heptane and filtered through a 4 cm layer of silica gel, followed by rinsing the silica gel layer with 500 ml of heptane. The collected eluents were concentrated under vacuum and the resulting resin stirred in 500 ml of 2-propanol at 80 °C until a suspension formed. The suspension was further stirred at room temperature overnight. The suspension was filtered and the solid washed with 30 ml of methanol to give 47 g (87% yield) of Intermediate 1-5 as a white solid.

**ESI-MS** (positive, m/z): exact mass of C₃₄H₂₉ClN₂ = 500.20; found 501.2 [M+1]⁺.

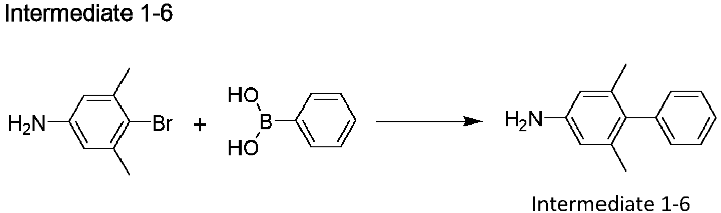

30.0 g (0.15 mol) of 4-bromo-3,5-dimethylaniline, 20.0 g (0.16 mol) of phenylboronic acid, 0.67 g (3 mmol) of palladium(II) acetate, 2.46 g (6.0 mmol) of 2-dicyclohexylphosphino-2',6'-dimethoxybiphenyl (SPhos), and 127 g (0.6 mol) of tribasic potassium phosphate were dissolved in a solvent mixture of 300 ml of toluene, 200 ml of 1,4-dioxane and 100 ml of water. The light orange reaction mixture was three times evacuated and backfilled with argon and heated at 82 °C during three hours. The reaction mixture was cooled down to room temperature and 100 ml of concentrated hydrochloric acid solution were added, followed by vigorous stirring during 15 minutes. The suspension was filtered and the solid washed with 100 ml of water and 100 ml of heptane. The solid was stirred in 500 ml of ethanol and 20 g of sodium hydroxide were added. The resulting solution was filtered and the remaining solid washed with 50 ml of ethanol. The collected filtrates were diluted with 500 ml of water and stirred until a beige suspension formed. The suspesnion was filtered and the solid washed with 90 ml of a 2:1-mixture of water and ethanol. The isolated product was further purified by MPLC with the *CombiFlash Companion* (silica gel, heptane/0-100% gradient of dichloromethane) to give 21.1 g (71% yield) of Intermediate 1-6 as a beige solid.

**¹H NMR** (300 MHz, CD₂Cl₂) δ 7.50 - 7.38 (m, 2H), 7.39 - 7.28 (m, 1H), 7.24 - 7.08 (m, 2H), 6.48 (s, 2H), 3.64 (br. s, 2H), 1.97 (s, 6H).

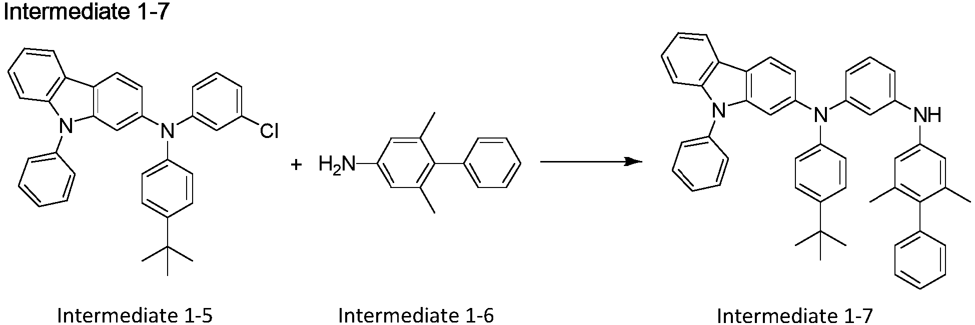

20.0 g (39.9 mmol) of Intermediate 1-5, 9.45 g (47.9 mmol) of Intermediate 1-6, 0.18 g (0.20 mmol) of tris(dibenzylideneacetone)dipalladium(0), 0.23 g (0.80 mmol) of tri-*tert*-butyl¬phosphonium tetrafluoroborate, and 9.70 g (0.10 mol) of sodium *tert-*butoxide were suspended in 200 ml of toluene. The dark reaction mixture was three times evacuated and backfilled with argon and heated at 98 °C during three hours. 0.18 g (0.20 mmol) of tris(dibenzylideneacetone)dipalladium(0) and 0.23 g (0.80 mmol) of tri-*tert*-butyl¬phosphonium tetrafluoroborate were added, and heating continued at 98 °C during three hours. 0.36 g of Pd-catalyst and 0.46 g of ligand was added, and heating continued at 98 °C during 16 hours. 0.18g of Pd-catalyst and 0.23 g of ligand was added and heating continued at 108 °C during 5 hours. The reaction mixture was treated with 2 g of activated charcoal and 1 g of thiocyanuric acid and left stirring during one hour. The mixture was diluted with 500 ml of heptane and filtered through a 10 cm layer of silica gel. The silica gel layer was rinsed with a mixture of heptane and dichloromethane. The collected eluents were concentrated under vacuum and diluted with 1 liter of ethanol and 700 ml of acetone. The solution was concentrated to a volume of 700 ml. The formed precipitate was filtered off. The filtrate was treated in several portions with a total amount of 300 ml of water until precipitation of a solid occurred. The suspension was filtered and the solid further purified by MPLC with the *CombiFlash Companion* (silica gel, heptane/10-30% gradient of dichloromethane) to give 13.1 g (49% yield) of Intermediate 1-7 as a white solid.

**ESI-MS** (positive, m/z): exact mass of C₄₈H₄₃N₃ = 661.35; found 662.7 [M+1]⁺.

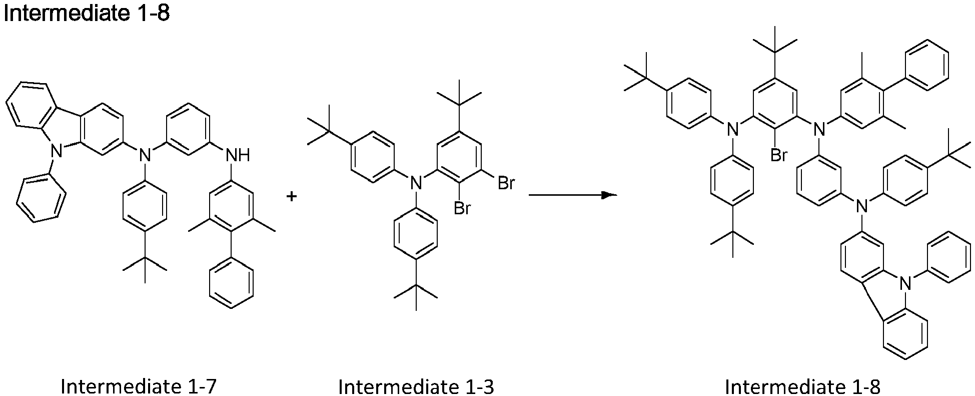

12.8 g (19.3 mmol) of Intermediate 1-7, 13.2 g (23.1 mmol) of Intermediate 1-3, 176 mg (0.19 mmol) of tris(dibenzylideneacetone)dipalladium(0), 223 mg (0.77 mmol) of tri-*tert*-butyl¬phosphonium tetrafluoroborate, and 4.60 g (48.0 mmol) of sodium *tert-*butoxide were suspended in 130 ml of toluene. The dark reaction mixture was three times evacuated and backfilled with argon and heated at 82 °C during 8 hours. The reaction mixture was treated with 200 ml of water. 1 g of activated charcoal and 0.5 g of thiocyanuric acid were added and stirring continued without heating during two hours. The organic layer was separated, then washed with 100 ml of water, and concentrated under vacuum. The remaining resin was further purified by MPLC with the *CombiFlash Companion* (silica gel, heptane/0-20% gradient of dichloromethane) to give 18.1 g (81% yield) of Intermediate 1-8 as a colorless resin.

**ESI-MS** (positive, m/z): exact mass of C₇₈H₇₉BrN₄ = 1150.55; found 1151.9 [M+1]⁺.

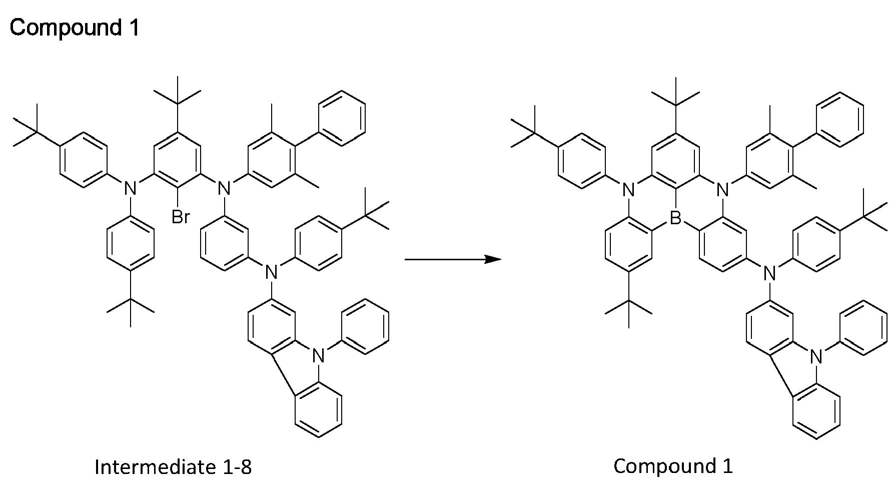

12.0 g (10.4 mmol) of Intermediate 1-8 were dissolved in 180 ml of water-free *tert-*butyl benzene. 11 ml of *tert*-butyl lithium (1.9 M solution in pentane) were slowly added at -30 °C, and the solution stirred up to room temperature during one hour. The light orange suspension was cooled down to -30 °C and 21 ml of tribromoborane (1 M solution in heptane) were added. The dark brown suspension was warmed up to 15 °C during 10 minutes. 7.2 ml (41 mmol) of *N,N-*diisopropylethylamine were slowly added and the reaction mixture heated up to 152 °C during 3 hours. The yellow suspension was cooled down to room temperature and treated with 50 ml of 10% aqueous sodium acetate solution. The organic layer was separated and washed with 50 ml of 10% aqueous sodium acetate first, followed by washing with 50 ml of water, and two times 50 ml of 10% aqueous solution of sodium hydroxide. The organic layer was diluted with ethanol up to a volume of 1 liter and stirred until a suspension formed. The suspension was filtered and the solid stirred in a mixture of 150 ml of ethanol and 100 ml of dichloromethane. Dichloromethane was removed under vacuum and the suspension cooled down to room temperature. The suspension was filtered and the solid washed three times with 40 ml of ethanol. The solid was dissolved in 150 ml of dichloromethane and 150 ml of heptane. Dichloromethane was removed under vacuum and the solution stirred at room temperature overnight. The suspension was filtered and the solid washed with 30 ml of heptane. The solid was further purified by MPLC with the *CombiFlash Companion* (silica gel, heptane/10-100% gradient of dichloromethane) to give 2.2 g (19% yield) of Compound 1 as a yellow solid.

**ESI-MS** (positive, m/z): exact mass of C₇₈H₇₇BN₄ = 1080.62; found 1081.8 [M+1]⁺.

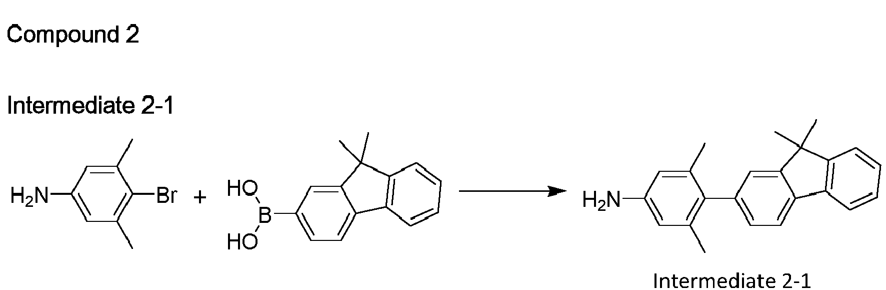

10.1 g (50.5 mmol) of 4-bromo-3,5-dimethylaniline, 13.5 g (56.7 mmol) of (9,9-dimethyl-9*H*-fluoren-2-yl)boronic acid, 224 mg (1.0 mmol) of palladium(II) acetate, 820 mg (2.0 mmol) of 2-dicyclohexylphosphino-2',6'-dimethoxybiphenyl (SPhos), and 42.5 g (0.20 mol) of tribasic potassium phosphate were dissolved in a solvent mixture of 120 ml of toluene, 80 ml of 1 ,4-dioxane and 40 ml of water. The orange reaction mixture was three times evacuated and backfilled with argon and heated at 85 °C during one hour. The reaction mixture was filtered through a 3 cm layer of Hyflo^{®} filter aid. The organic layer was separated and washed three times with 300 ml of water, dried over sodium sulfate, filtered and concentrated under vacuum. The remaining resin was dissolved in 500 ml of hot ethanol. The volume was reduced under vacuum to 300 ml, and a total of 60 ml of water were added dropwise until a suspension formed. The suspension was filtered and the solid dissolved in 300 ml of methanol and 100 ml of dichloromethane. The solution was concentrated under vacuum until a suspension formed. The suspension was filtered to give 10.5 g (66% yield) of Intermediate 2-1 as a beige solid.

**ESI-MS** (positive, m/z): exact mass of C₂₃H₂₃N = 313.18; found 314.4 [M+1]⁺.

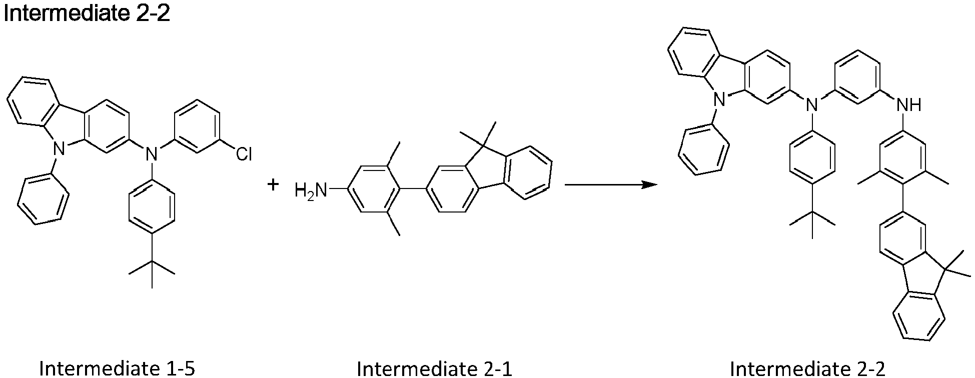

10.0 g (20.0 mmol) of Intermediate 1-5, 6.90 g (22.0 mmol) of Intermediate 2-1, 91 mg (0.10 mmol) of tris(dibenzylideneacetone)dipalladium(0), 116 mg (0.40 mmol) of tri-*tert*-butyl¬phosphonium tetrafluoroborate, and 4.80 g (49.9 mmol) of sodium *tert-*butoxide were suspended in 100 ml of o-xylene. The brown suspension was three times evacuated and backfilled with argon and heated at 105 °C during 18 hours. The reaction mixture was further purified by MPLC with the *CombiFlash Companion* (silica gel, heptane/0-100% gradient of dichloromethane). The product was stirred in 300 ml of ethanol until a suspension formed. 50 ml of water were slowly added under stirring. The suspension was filtered to give 12.8 g (80% yield) of Intermediate 2-2 as a white solid.

**ESI-MS** (positive, m/z): exact mass of C₅₇H₅₁N₃ = 777.41; found 778.6 [M+1]⁺.

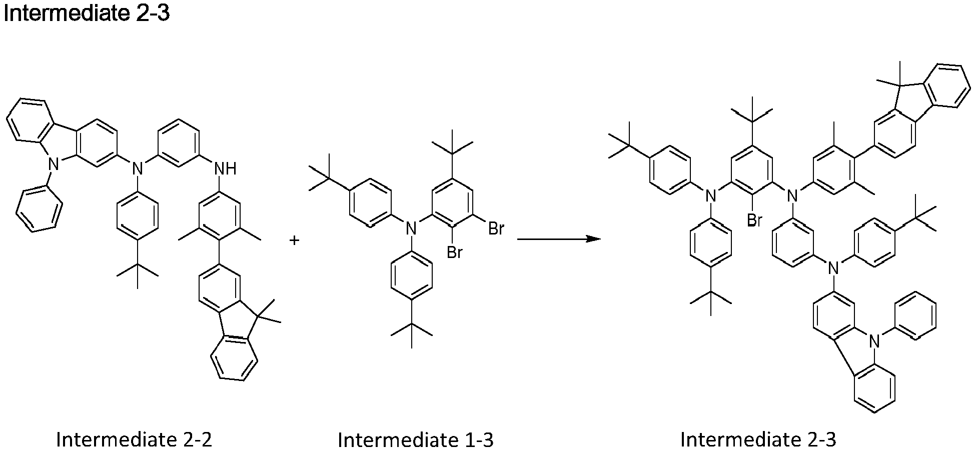

6.1 g (7.8 mmol) of Intermediate 2-2, 4.4 g (7.7 mmol) of Intermediate 1-3, 71 mg (0.08 mmol) of tris(dibenzylideneacetone)dipalladium(0), 90 mg (0.31 mmol) of tri-*tert-*butyl¬phosphonium tetrafluoroborate, and 2.0 g (20.8 mmol) of sodium *tert-*butoxide were suspended in 60 ml of o-xylene. The dark reaction mixture was three times evacuated and backfilled with argon and heated at 103 °C during 80 minutes. The dark reaction mixture was filtered over a 3 cm layer of Hyflo^{®} filter aid and diluted with 600 ml of ethanol. The resulting suspension was filtered and the solid washed with ethanol. The solid was further purified by MPLC with the *CombiFlash Companion* (silica gel, heptane/0-20% gradient of dichloromethane), followed by an additional MPLC purification (silica gel, heptane/20-40% gradient of dichloromethane). The isolated product was dissolved in 20 ml of heptane, and 150 ml of ethanol were slowly added under vigorous stirring. The resulting suspension was filtered and the solid washed with ethanol to give 4.5 g (46% yield) of Intermediate 2-3 as a white solid.

**ESI-MS** (positive, m/z): exact mass of C₈₇H₈₇BrN₄ = 1266.61; found 1267.8 [M+1]⁺.

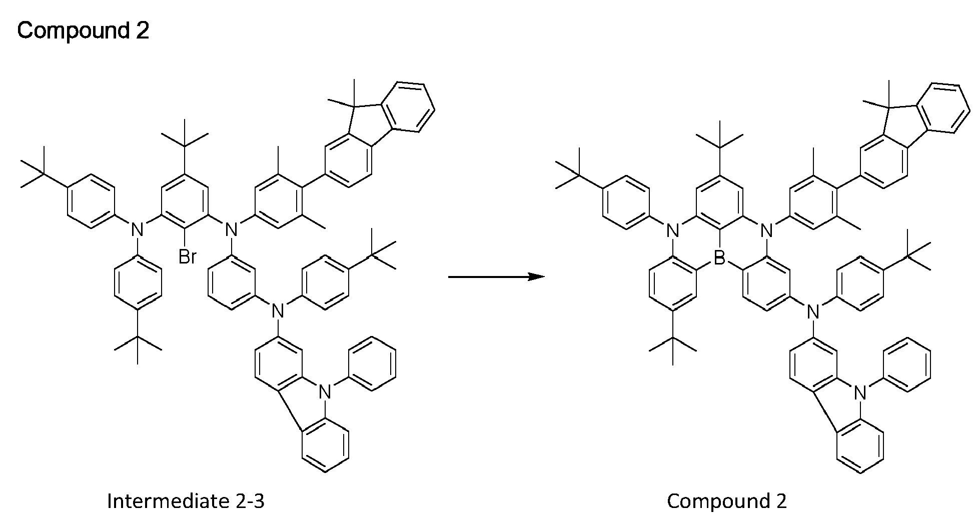

4.50 g (3.55 mmol) of Intermediate 2-3 were dissolved in 150 ml of water-free *tert*-butyl benzene. 3.8 ml of *tert*-butyl lithium (1.9 M solution in pentane) were slowly added at a maximum temperature of -30 °C, and the solution stirred up to 30 °C during one hour. The light orange solution was cooled down to -30 °C and 7 ml of tribromoborane (1 M solution in heptane) were added. The reaction mixture was warmed up to room temperature during 10 minutes. 2.5 ml (14 mmol) of *N*,*N*-diisopropylethylamine were slowly added and the reaction mixture heated up to 137 °C during 3 hours. The reaction mixture was poured into 500 ml of ethanol and cooled to 0 °C. The suspension was filtered and the solid further purified by MPLC with the *CombiFlash Companion* (silica gel, heptane/0-100% gradient of dichloromethane). The isolated product was dissolved in heptane and stirred at 50 °C during 30 minutes, followed by stirring at room temperature during one hour. The suspension was filtered and the solid dissolved in 20 ml of dichloromethane and 20 ml of heptane. Dichloromethane was removed under vacuum and additional heptane was added. The solution was stirred until a suspension formed. The suspension was filtered and the solid washed with a small amount of heptane to give 0.68 g (16% yield) of Compound 2 as a yellow solid.

**ESI-MS** (positive, m/z): exact mass of C₈₇H₈₅BN₄ = 1196.69; found 1198.2 [M+1]⁺.

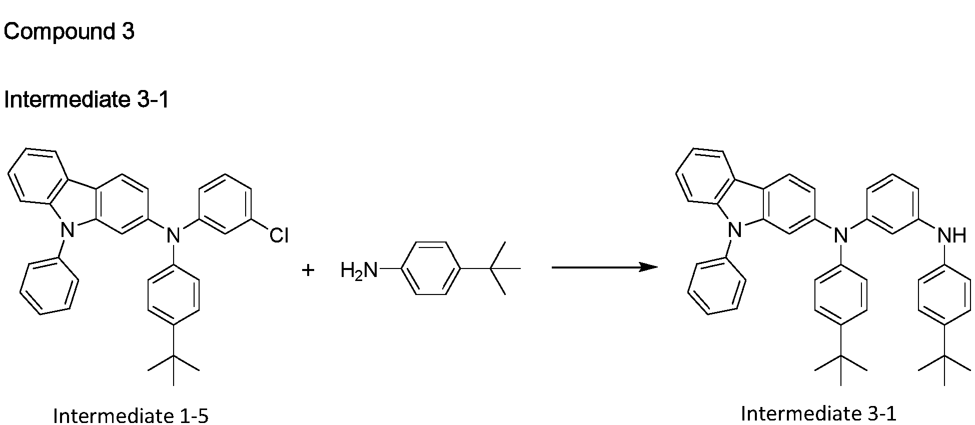

13.3 g (26.5 mmol) of Intermediate 1-5, 4.4 g (29.2 mmol) of 4-(*tert*-butyl)aniline, 0.49 g (0.53 mmol) of tris(dibenzylideneacetone)dipalladium(0), 0.62 g (2.12 mmol) of tri-*tert*-butyl¬phosphonium tetrafluoroborate, and 6.38 g (66.4 mmol) of sodium *tert*-butoxide were suspended in 150 ml of o-xylene. The dark suspension was three times evacuated and backfilled with argon and heated at 116 °C during 5 hours. The brown suspension was cooled down to room temperature and further purified by MPLC with the *CombiFlash Companion* (silica gel, heptane/dichloromethane 9:1). The isolated product was stirred in 200 ml of methanol and vigorously stirred at room temperature during 30 minutes. The resulting suspension was filtered and the solid washed with a small amount of methanol. The filtrate was treated with 100 ml of water and stirred until a suspension formed. The suspension was filtered and the solid washed with a small amount of a 1:1-mixture of methanol and water to give 6.6 g (39% yield) of Intermediate 3-1 as a light yellow solid.

**ESI-MS** (positive, m/z): exact mass of C₄₄H₄₃N₃ = 613.35; found 614.5 [M+1]⁺.

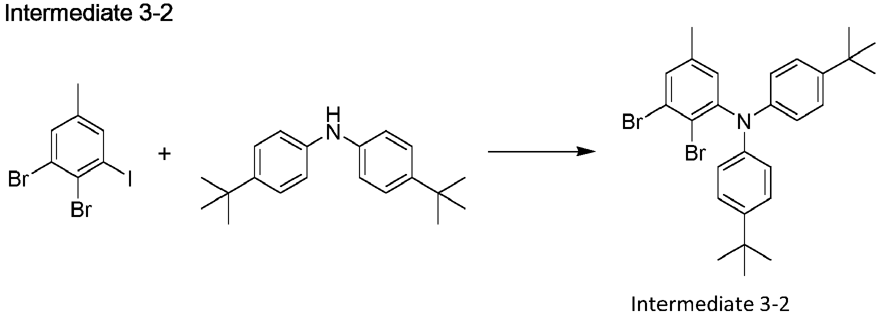

40.2 g (106 mmol) of 1,2-dibromo-3-iodo-5-methylbenzene (prepared in the same way as Intermediate 1-2, using 3,4-dibromotoluene as starting material), 28.6 g (101 mmol) of bis(4-(*tert*-butyl)phenylamine, and 26.0 g (0.27 mol) of sodium *tert-*butoxide were suspended in 400 ml of toluene. The yellow suspension was three times evacuated and backfilled with argon. The temperature was raised to 91 °C followed by the addition of 3.20 g (5.53 mmol) of 4,5-bis(di-phenylphosphino)-9,9-dimethylxanthene (Xantphos) and 2.50 g (2.73 mmol) of tris(dibenzylideneacetone)dipalladium(0). The dark reaction mixture was three times evacuated and backfilled with argon followed by heating at 87 °C during 32 hours. The reaction mixture was cooled down to room temperature and filtered, and the filtrate concentrated under vacuum. The dark brown powder was further purified by MPLC with the *CombiFlash Companion* (silica gel, heptane/0-100% gradient of toluene). The product was dissolved in 400 ml of dichloromethane and 300 ml of methanol. The solution was concentrated under vacuum until a suspension formed. The suspension was diluted with 100 ml of ethanol and stirred at room temperature during 30 minutes. The suspension was filtered and the solid washed with ethanol to give 39.2 g (69% yield) of Intermediate 3-2 as a white solid.

**ESI-MS** (positive, m/z): exact mass of C₂₇H₃₁Br₂N = 527.08; found 528.2 [M+1]⁺.

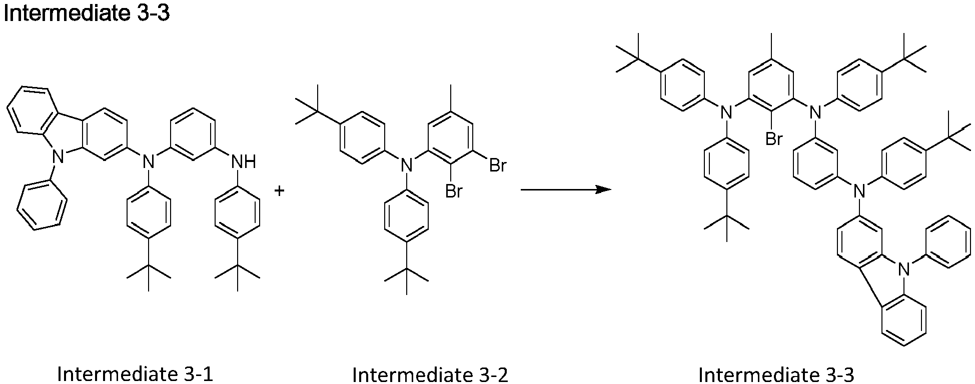

3.50 g (5.70 mmol) of Intermediate 3-1, 3.02 g (5.70 mmol) of Intermediate 3-2, 26 mg (0.03 mmol) of tris(dibenzylideneacetone)dipalladium(0), 33 mg (0.11 mmol) of tri-*tert*-butyl¬phosphonium tetrafluoroborate, and 1.40 g (14.6 mmol) of sodium *tert*-butoxide were suspended in 35 ml of toluene. The dark orange suspension was three times evacuated and backfilled with argon and heated at 66 °C during 29 hours. 26 mg (0.03 mmol) of tris(dibenzylideneacetone)dipalladium(0), 35 mg (0.12 mmol) of tri-*tert*-butyl¬phosphonium tetrafluoroborate were added. The brown suspension was heated at 68 °C during one hour. The reaction mixture was cooled down to room temperature and filtered through a 4 cm layer of silica gel. The silica gel layer was rinsed with toluene and the collected eluents concentrated under vacuum. The yellow resin was stirred with 300 ml of ethanol and 100 ml of dichloromethane and the resulting suspension heated at reflux until a solution formed. The solution was concentrated to a volume of 100 ml and the resulting suspension diluted with 300 ml of ethanol. The volume was concentrated to 200 ml and further stirred at room temperature during one hour. The light yellow suspension was filtered and the solid washed with ethanol to give 5.10 g (84% yield) of Intermediate 3-3 as a white solid.

**ESI-MS** (positive, m/z): exact mass of C₇₁H₇₃BrN₄ = 1060.50; found 1061.6 [M+1]⁺.

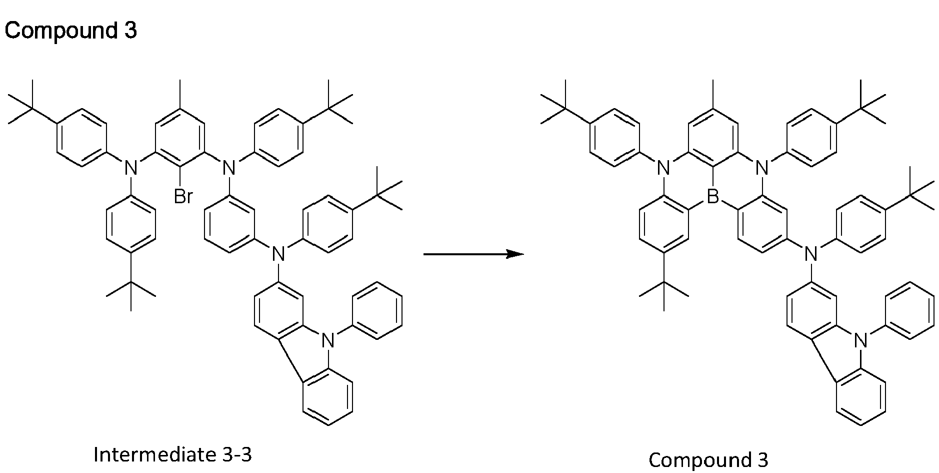

5.10 g (4.80 mmol) of Intermediate 3-3 were dissolved in 100 ml of water-free *tert*-butyl benzene. 5.1 ml of *tert*-butyl lithium (1.9 M solution in pentane) were slowly added at -78 °C, and the solution stirred up to room temperature during 45 minutes. The solution was cooled down to -78 °C and 9.6 ml of tribromoborane (1 M solution in heptane) were added. The dark red suspension was warmed up to 5 °C during 5 minutes. 3.5 ml (20 mmol) of *N*,*N*-diisopropylethylamine were slowly added and the reaction mixture heated at 129 °C during 80 minutes, followed by heating at 161 °C during three hours. The yellow suspension was cooled down to room temperature and treated with 15 ml of 10% aqueous sodium acetate solution. The mixture was poured into 800 ml of ethanol followed by vigorous stirring during 20 minutes. The suspension was filtered and the solid washed with water and twice with ethanol. The solid was purified by MPLC with the *CombiFlash Companion* (silica gel, heptane/0-100% gradient of dichloromethane). The isolated product was stirred in 50 ml of ethanol at 70 °C during 15 minutes. The suspension was cooled down to room temperature and the solid washed with ethanol to give 1.0 g (21% yield) of Compound 3 as a yellow solid.

**ESI-MS** (positive, m/z): exact mass of C₇₁H₇₁BN₄ = 990.58; found 998.1 [M+1]⁺.

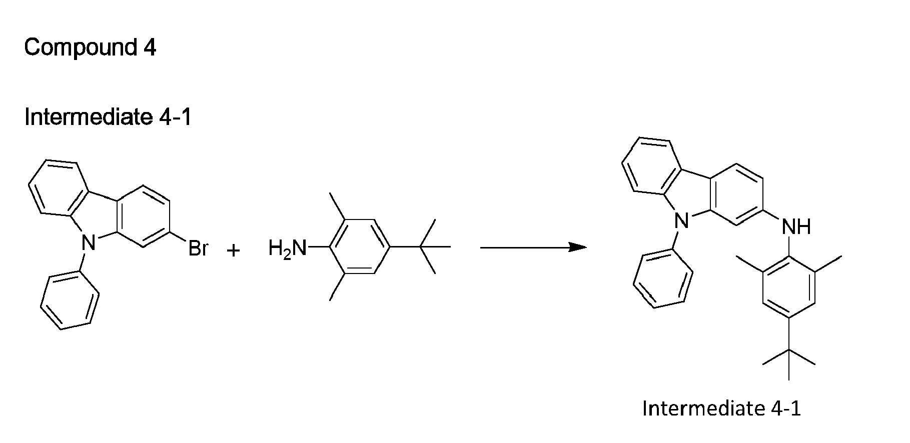

30.0 g (93.0 mmol) of 3-bromo-9-phenyl-9*H*-carbazole, 19.9 g (112 mmol) of 4-(*tert-*butyl)-2,6-dimethylaniline, 0.85 g (0.93 mmol) of tris(dibenzylideneacetone)dipalladium(0), 1.16 g (1.86 mmol) of 2,2'-bis(diphenylphosphino)-1,1'-binaphthalene (BINAP), and 22.4 g (0.23 mol) of sodium *tert-*butoxide were suspended in 300 ml of toluene. The dark suspension was three times evacuated and backfilled with argon and heated atm104 °C during one hour. The reaction mixture was cooled down to room temperature and filtered. The remaining solid was washed with toluene and kept for later purification (= product fraction 1). The combined filtrates were concentrated under vacuum and further purified by MPLC with the *CombiFlash Companion* (silica gel, heptane/0 to 100% gradient of dichloromethane). The product fractions were collected and concentrated to a volume of 200 ml. The solution was stirred at room temperature until a suspension formed. The suspension was filtered and the solid washed with 25 ml of heptane, giving 9.4 g of the product (= product fraction 2). Product fraction 1 was stirred in 500 ml of water and 200 ml of heptane. The grey suspension was filtered and washed with 100 ml of water and 100 ml of heptane. The grey solid was suspended in 300 ml of methanol and stirred at room temperature during 10 minutes. The grey suspension was filtered and the solid combined with product fraction 2. The combined solids were nearly dissolved in 1.3 liters of dichloromethane. The slight suspension was filtered and the solid washed with 400 ml of dichloromethane. 400 ml of heptane were added. The orange suspension was concentrated to a volume of 250 ml under vacuum, and cooled down to room temperature under stirring. The suspension was filtered and the solid washed with heptane to give 38.0 g (83% yield) of Intermediate 4-1 a light orange solid.

**ESI-MS** (positive, m/z): exact mass of C₃₀H₃₀N₂ = 418.24; found 419.3 [M+1]⁺.

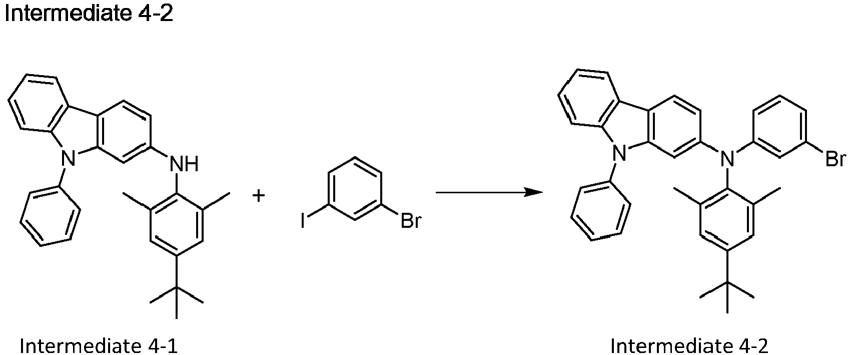

22.9 g (54.7 mmol) of Intermediate 4-1, 16.3 g (57.4 mmol) of 1-bromo-3-iodobenzene, 250 mg (0.27 mmol) of tris(dibenzylideneacetone)dipalladium(0), 320 mg (0.55 mmol) of tri-*tert-*butyl¬phosphonium tetrafluoroborate, and 13.1 g (137 mmol) of sodium *tert-*butoxide were suspended in 250 ml of toluene. The dark reaction mixture was three times evacuated and backfilled with argon and heated at 82 °C during 3 hours. The temperature was raised to 92 °C and heating continued during 30 minutes. 250 mg of tris(dibenzylideneacetone)dipalladium(0) and 320 mg of tri-*tert-*butyl¬phosphonium tetrafluoroborate wered added and heating continued during 17 hours. 50 mg of tris(dibenzylideneacetone)dipalladium(0) and 110 mg of tri-*tert-*butyl¬phosphonium tetrafluoroborate wered added and heating continued at 92 °C during 8 hours. The dark reaction mixture was cooled down to room temperature and exctracted with 100 ml of water. The organic layer was filtered over a 3 cm layer of silica gel and the silica gel layer washed with 100 ml of toluene. The combined eluents were concentrated under vacuum and the resulting brown resin heated in 200 ml of ethanol under reflux. Ethanol was removed under vacuum. Stirring in 200 ml of ethanol was repeated twice until a solid formed. The isolated solid was stirred in 500 ml of ethanol at 50 °C during one hour. The suspension was cooled to room temperature and filtered. The remaining solid was suspended in 1 liter of ethanol and heated under reflux during 30 minutes. 500 ml of ethanol were removed under vacuum and stirred at 50 °C during 30 minutes. The suspension was cooled down to room temperature and filtered. The solid was washed with 50 ml of ethanol and dissolved in 400 ml of hot 2-propanol. The solution was cooled down to room temperature and stirred during one hour until a suspension formed. The suspension was treated under stirring with 100 ml of water. The suspension was filtered to give 17.0 g (53% yield) of Intermediate 4-2 as a white solid.

**ESI-MS** (positive, m/z): exact mass of C₃₆H₃₃BrN₂ = 572.18; found 573.5 [M+1]⁺.

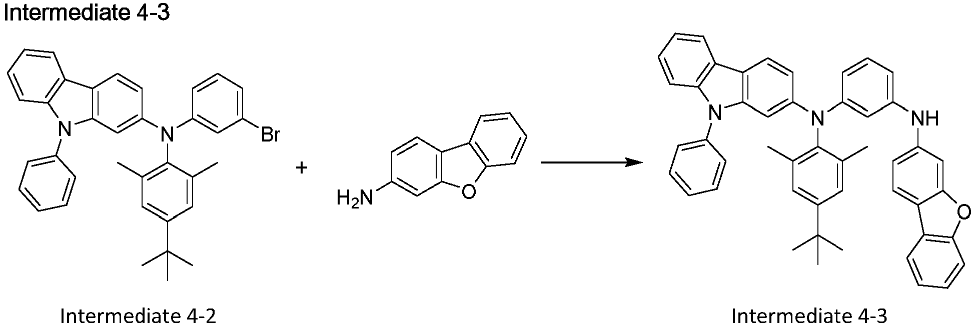

17.0 g (29.6 mmol) of Intermediate 4-2, 5.70 g of 3-dibenzofuranamine, 136 mg (0.15 mmol) of tris(dibenzylideneacetone)dipalladium(0), 185 g (0.30 mmol) of 2,2'-bis(diphenylphosphino)-1,1'-binaphthalene (BINAP), and 7.20 g (74.9 mmol) of sodium *tert-*butoxide were suspended in 170 ml of toluene. The dark suspension was three times evacuated and backfilled with argon and heated at 92 °C during two hours. The dark reaction mixture was cooled down to room temperature, diluted with 100 ml of heptane and washed twice with 100 ml of water. The organic layer was dried over magnesium sulfate and filtered over a 4 cm layer of silica gel. The silica gel layer was rinsed with 100 ml of toluene/heptane 1:1. The collected eluents were concentrated under vacuum to a volume of 50 ml. 300 ml of methanol were added and the resulting suspension stirred under reflux. The brown suspension was cooled down to room temperature and filtered. The solid was dissolved in 500 ml of dichloromethane and 500 ml of heptane. The solution was concentrated under vacuum to a volume of 300 ml until a suspension formed. The suspension was stirred at room temperature during two hours and filtered. The solid was washed with 50 ml of heptane and 50 ml of ethanol. The solid was dissolved in 450 ml DCM and 0.5 g of activated charcoal and 200 mg of thiocanuric acid wered added. The suspension was stirred at room room temperature during one hour and filtered over a 3 cm layer of silica gel. The silica gel layer was rinsed with 150 ml of dichloromethane. The collected filtrate was diluted with 300 ml of heptane and concentrated under vacuum to a volume of 200 ml until a suspension formed. The suspension was stirred at room temperature overnight. The suspension was filtered and the solid washed with 50 ml of heptane and 50 ml of ethanol to give 16.1 g (79% yield) of Intermediate 4-3 as a white solid.

**ESI-MS** (positive, m/z): exact mass of C₄₈H₄₁N₃O = 675.32; found 676.6 [M+1]⁺.

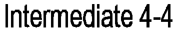

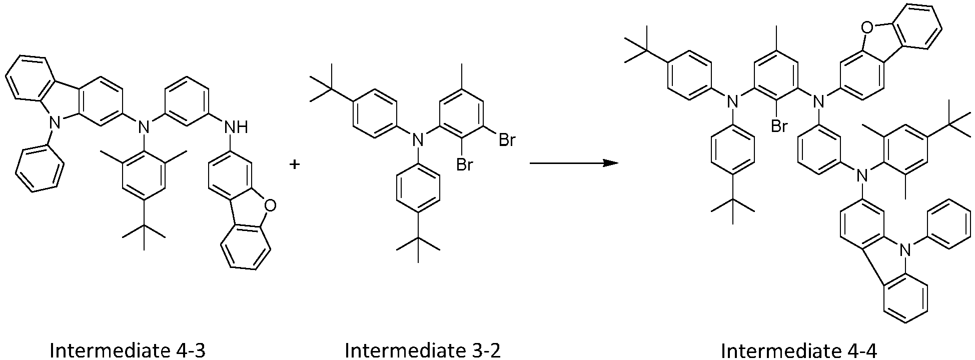

8.00 g (11.8 mmol) of Intermediate 4-3, 7.00 g (13.2 mmol) of Intermediate 3-2, 108 mg (0.12 mmol) of tris(dibenzylideneacetone)dipalladium(0), 138 mg (0.47 mmol) of tri-*tert-*butyl¬phosphonium tetrafluoroborate, and 2.80 g (29.1 mmol) of sodium *tert-*butoxide were suspended in 170 ml of toluene. The purple suspension was three times evacuated and backfilled with argon and heated at 81 °C during 3 hours. 0.5 g of thio cyanuric acid were added and heating continued during 15 minutes. The dark reaction mixture was cooled down to room temperature and filtered over a 3 cm layer of Hyflo^{®} filter aid, and the layer washed with 20 ml of toluene. The collected eluents were diluted with 600 ml ethanol under stirring, and stirring continued for 10 minutes. The suspension was filtered and the solid dissolved in 100 ml of dichloromethane. The solution was filtered over a 4 cm layer of silica gel, followed by rinsing the silica gel layer with 100 ml dichloromethane. The collected eluents were diluted with 200 ml of heptane. The solution was concentrated under vacuum to a volume of 150 ml and stirred at room temperature during two hours until a suspension formed. The suspension was filtered and the solid washed with 20 ml of heptane to give 8.6 g (64% yield) of Intermediate 4-4 as a beige solid.

**ESI-MS** (positive, m/z): exact mass of C₇₅H₇₁BrN₄O = 1122.48; found 1123.8 [M+1]⁺.

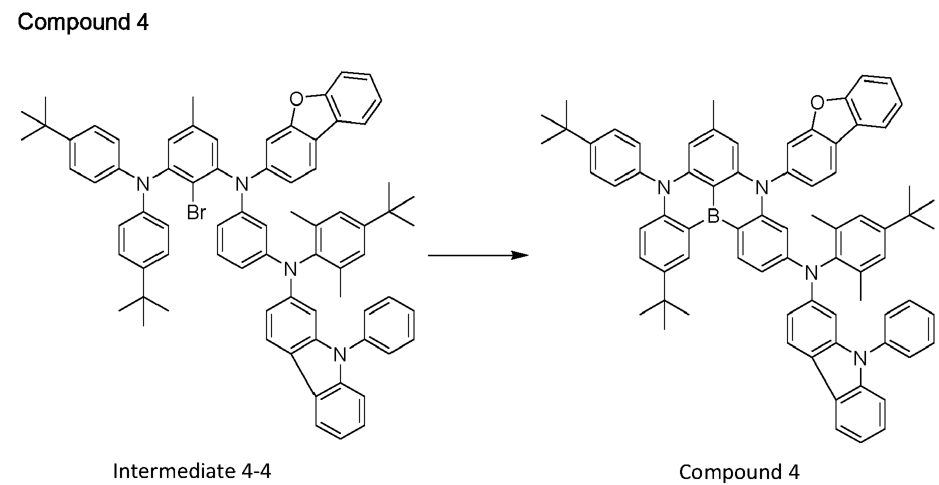

3.00 g (2.67 mmol) of Intermediate 4-4 were dissolved in 75 ml of water-free *tert*-butyl benzene. 2.7 ml of *tert*-butyl lithium (1.9 M solution in pentane) were slowly added at room temperature, and the solution stirred up to 30 °C during one hour. The light orange solution was stirred at room temperature during two hours. 0.9 ml (8.0 mmol) of trimethyl borate were added at icebath temperature followed by stirring at room temperature during 30 minutes. 16 ml of tribromobroane (1 M solution in heptane) were added at -30 °C. The brown-orange suspension was stirred at room temperature during 15 hours. 5.6 ml (32 mmol) of *N*,*N*-diisopropylethylamine were slowly added and stirring continued for 5 minutes. The brown-yellow suspension was treated with 30 ml of 10% aqueous sodium bicarbonate solution and stirred during 10 minutes. The organic layer was separated and dried over magnesium sulfate. The suspension was filtered and the solid washed with 50 ml of toluene. The filtrate was treated with 7.5 ml of acetic acid and heated under reflux during two hours. The orange solution was poured into 800 ml of methanol and stirred at room temperature during 30 minutes. The yellow suspension was filtered and the solid washed with 50 ml of methanol. The solid was dissolved in 250 ml of dichloromethane and 200 ml of heptane were added. The solution was concentrated under vacuum until a suspension formed. The suspension was stirred at room temperature during one hour. The suspension was filtered and the solid washed with 30 ml of heptane and 30 ml of ethanol. The solid was dissolved in a 3:1 mixture of dichloromethane and heptane. The solution was eluted over 24 g of silica gel and the silica rinsed with 150 ml of a 2:1 mixture of dichloromethane and heptane. The collected eluents were diluted with 150 ml of heptane and concentrated under vacuum to a volume of 150 ml. The resulting yellow suspension was stirred at room temperature during 30 minutes, then filtered and the solid washed with 30 ml of heptane to give 1.33 g (46% yield) of Compound 4 as a yellow solid.

**ESI-MS** (positive, m/z): exact mass of C₇₅H₆₉BN₄O = 1052.56; found 1053.8 [M+1]⁺.

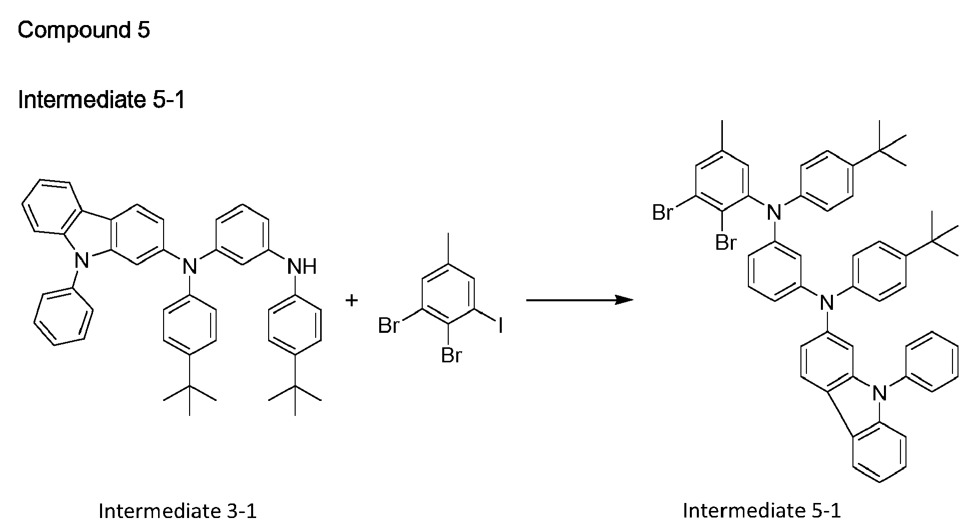

11.0 g (17.9 mmol) of Intermediate 3-1, 6.80 g (18.1 mmol) of 1,2-dibromo-3-iodo-5-methylbenzene (prepared in the same way as Intermediate 1-2, using 3,4-dibromotoluene as starting material), 328 mg (0.36 mmol) of tris(dibenzylideneacetone)dipalladium(0), 415 mg (0.72 mmol) of 4,5-bis(di-phenylphosphino)-9,9-dimethylxanthene (Xantphos), and 4.30 g (44.8 mmol) of sodium *tert-*butoxide were suspended in 150 ml of toluene. The brown suspension was three times evacuated and backfilled with argon and heated at 82 °C during 4 hours. 179 mg of tris(dibenzylideneacetone)dipalladium(0) and 207 mg of Xantphos were added and the heating continued at 84 °C during 3 hours. An additional 179 mg of tris(dibenzylideneacetone)dipalladium(0) and 207 mg of Xantphos were added and the heating continued at 84 °C during 7 hours. The dark suspension was cooled down to room tempeature and further purified by MPLC with the *CombiFlash Companion* (silica gel, heptane/ethyl acetate 4:1). The product fractions were collected and further purified by MPLC (silica gel, heptane/0-100% gradient of ethyl acetate). The product fractions were again collected and purified by MPLC (silica gel, heptane/0 to 25% gradient of dichloromethane) to give 7.25 g (47% yield) of Intermediate 5-1 as a white foam.

**ESI-MS** (positive, m/z): exact mass of C₅₁H₄₇Br₂N₃ = 859.21; found 860.4 [M+1]⁺.

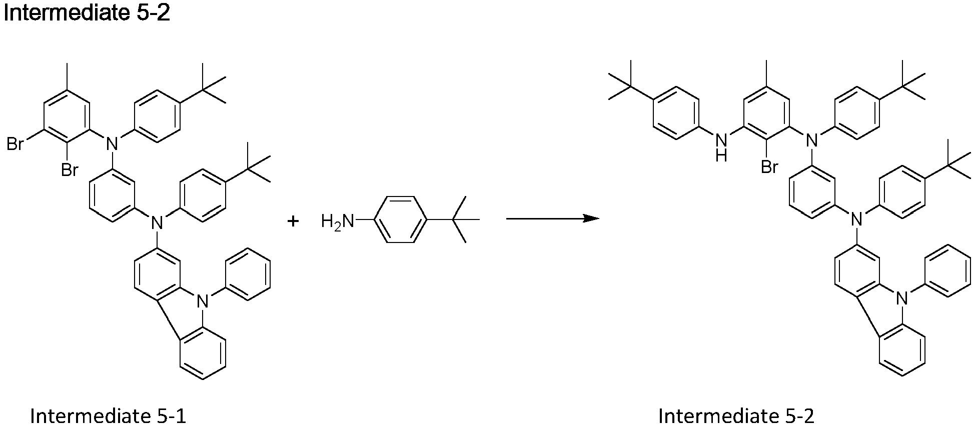

5.7 g (6.61 mmol) of Intermediate 5-1, 1.5 g (10.1 mmol) of 4-(*tert-*butyl)aniline, 91 mg (0.10 mmol) of tris(dibenzylideneacetone)dipalladium(0), 125 mg (0.20 mmol) of 2,2'-bis(diphenylphosphino)-1,1'-binaphthalene (BINAP), and 1.60 g (16.6 mmol) of sodium *tert-*butoxide were suspended in 50 ml of toluene. The dark suspension was three times evacuated and backfilled with argon and heated at 76 °C during 5 hours. The dark orange suspension was cooled down to room temperature, washed with 50 ml of water, dried over magnesium sulfate, and concentrated under vacuum. The yellow resin was further purified by MPLC with the *CombiFlash Companion* (silica gel, heptane/0-100% gradient of dichloromethane). The product fractions were collected and concentrated under vacuum. The solid product was suspended in 200 ml of 2-propanol and heated at 85 °C until a solution formed. The solution was concentrated under vacuum until a suspension formed. The suspension was filtered and washed with 20 ml of ethanol to give 6.7 g (58% yield) of Intermediate 5-2 as a white solid.

**ESI-MS** (positive, m/z): exact mass of C₆₁H₆₁BrN₄ = 928.41; found 931.5.

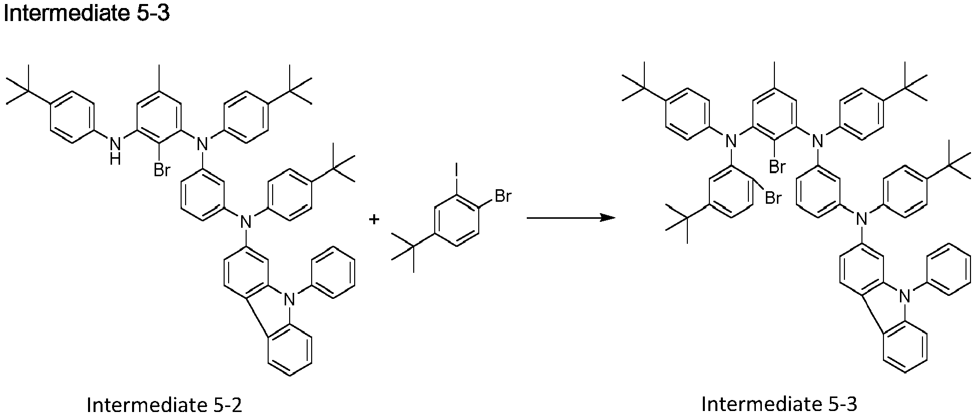

1.00 g (1.08 mmol) of Intermediate 5-2, 0.73 g (2.15 mmol) of 1-bromo-4-(*tert*-butyl)-2-iodobenzene, 20 mg (0.02 mmol) of tris(dibenzylideneacetone)dipalladium(0), 50 mg (0.08 mmol) of 4,5-bis(di-phenylphosphino)-9,9-dimethylxanthene (Xantphos), and 0.21 g (2.15 mmol) of sodium *tert-*butoxide were suspended in 25 ml of toluene. The brown reaction mixture was three times evacuated and backfilled with argon and heated at 103 °C during 19 hours. 10 mg of tris(dibenzylideneacetone)dipalladium(0), 25 mg of Xantphos were added and heating continued at 105 °C during 7 hours. The brown suspension was cooled down to 50 °C and treated with 50 ml of methanol and 5 ml of water. The suspension was stirred at room temperature during one hour. The resulting brown resin was dissovled in 100 ml of dichloromethane and 100 ml of methanol. Dichloromethane was removed under vacuum and the remaining mixture heated under reflux until a yellow suspension formed. The suspension was filtered and washed with 15 ml of ethanol to give 0.96 g (78%) of Intermediate 5-3 as a white solid.

**ESI-MS** (positive, m/z): exact mass of C₇₁H₇₂Br₂N₄ = 1138.41; found 1139.6 [M+1]⁺.

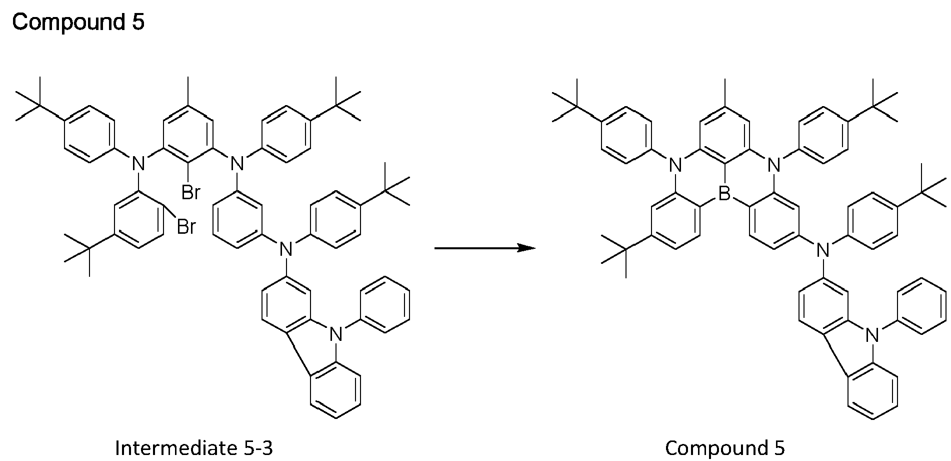

1.48 g (1.30 mmol) of Intermediate 5-3 were dissolved in 100 ml of water-free *tert*-butyl benzene. 2.7 ml of *tert*-butyl lithium (1.9 M solution in pentane) were slowly added at a maximum temperature of -30 °C, and the solution stirred up to room temperature during 50 minutes. The orange solution was cooled down to -14 °C and 0.45 ml (4.0 mmol) of trimethyl borate were added, followed by stirring up to room temperature during 40 minutes. 0.75 ml of tribromoborane (1 M solution in heptane) were added at a maximum temperature of -30 °C. The resulting orange suspension was stirred at room temperature during 20 hours. 2.0 ml (11.7 mmol) of *N,N-*diisopropylethylamine were added and the suspension stirred at 76 °C during one hour, followed by stirring at room temperature during 20 minutes. The orange suspension was poured into 450 ml of ethanol and 20 ml of water. The yellow suspension was stirred during 20 minutes, then filtered, and the solid washed with ethanol. The solid was dissolved in 100 ml of dichloromethane and filtered through a 6 cm layer of silica gel. The silica gel layer was rinsed with 100 ml of dichloromethane. The collected eluents were diluted with 150 ml of ethanol and concentrated under vacuum to a volume of 100 ml. The resulting suspension was filtered and the solid washed with ethanol to give 0.47 g (36% yield) of Compound 5 as a yellow solid.

**ESI-MS** (positive, m/z): exact mass of C₇₁H₇₁BN₄ = 990.58; found 991.7 [M+1]⁺.

### Device (invented compound as emitter dopant)

### Preparation and Evaluation of Organic EL Devices

The organic EL devices were prepared and evaluated as follows:

### Application Example 1

A glass substrate with 130 nm-thick indium-tin-oxide (ITO) transparent electrode (manufactured by Geomatec Co., Ltd.) used as an anode was first treated with N2 plasma for 100 sec. This treatment also improved the hole injection properties of the ITO. The cleaned substrate was mounted on a substrate holder and loaded into a vacuum chamber. Thereafter, the organic materials specified below were applied by vapour deposition to the ITO substrate at a rate of approx. 0.02-1 Å/sec at about 10⁻⁶ -10⁻⁸ mbar. As a hole injection layer, 10 nm-thick mixture of Compound HT-1 and 3% by weight of compound HI was applied. Then 80 nm-thick of compound HT-1 and 10 nm of Compound HT-2 were applied as hole-transporting layer 1 and hole-transporting layer 2, respectively. Subsequently, a mixture of 2% by weight of an emitter Compound 1 and 98% by weight of host Compound BH-1 was applied to form a 25 nm-thick fluorescent emitting layer. On the emitting layer, 10 nm-thick Compound ET-1 was applied as an hole-blocking layer and 15 nm of Compound ET-2 as electron-transporting layer. Finally, 1 nm-thick LiF was deposited as an electron-injection layer and 50 nm-thick Al was then deposited as a cathode to complete the device. The device was sealed with a glass lid and a getter in an inert nitrogen atmosphere with less than 1 ppm of water and oxygen. To characterize the OLED, electroluminescence (EL) spectra were recorded at various currents and voltages. EL peak maximum and Full Width at Half Maximum (FWHM) were recorded at 10 mA/cm². In addition, the current-voltage characteristic were measured in combination with the luminance to determine luminous efficiency and external quantum efficiency (EQE). Driving voltage (Voltage) was given at a current density of 10mA/cm². Lifetime of OLED device was measured as a decay of the luminance at constant current density of 50 mA/cm² to 95% of its initial value. The device results are shown in Table 1.

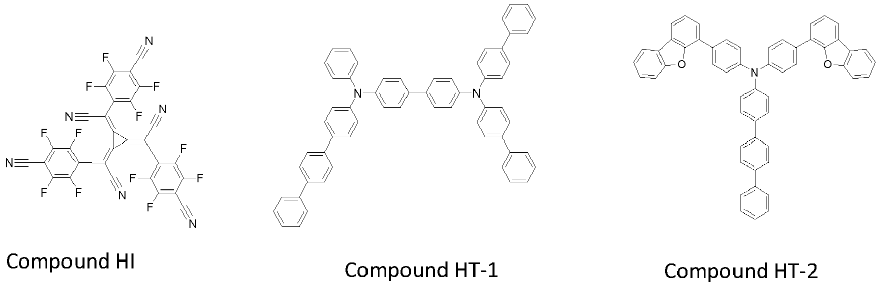

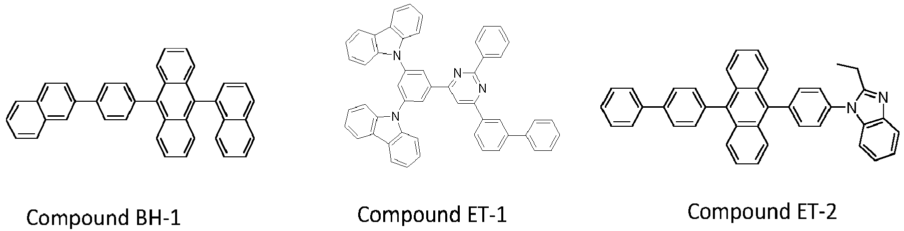

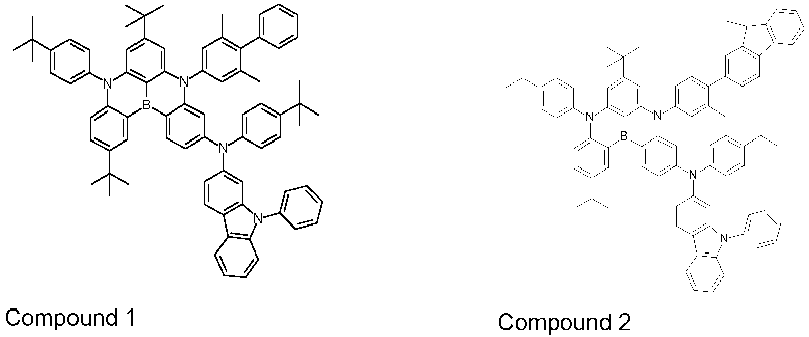

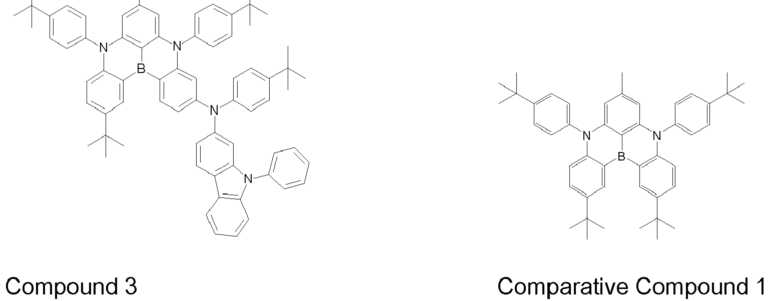

**Table 1: Results of the application examples**

| Example | Emitter | Voltage, V | EQE, % | EL max, nm |
|---|---|---|---|---|
| Ex. 1 | Compound 1 | 3.66 | 10.58 | 461 |
| Ex. 2 | Compound 2 | 3.64 | 10.92 | 461 |
| Ex. 3 | Compound 3 | 3.64 | 10.49 | 458 |
| Com. Ex. 1 | Comparative Compound 1 | 3.70 | 9.89 | 461 |

The results demonstrate that Compounds 1, 2, and 3 as fluorescent emitting material in OLED give superior EQE than Comparative Compound 1.

## Claims

1. A compound represented by formula (I) 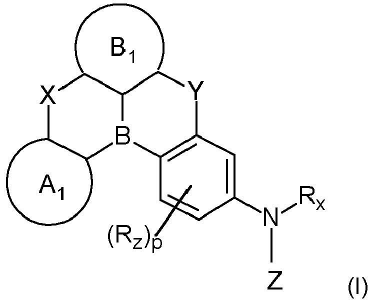 wherein
Z represents a group of formula (IIa), (IIb) or (IIc) 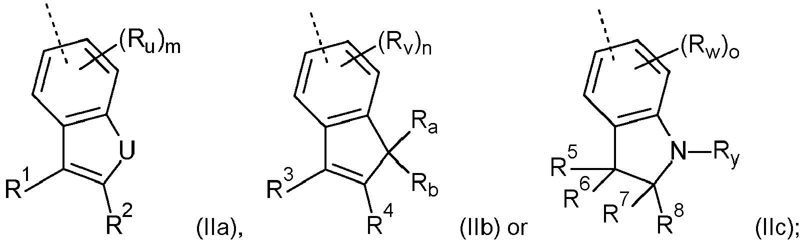
ring A₁ represents a substituted or unsubstituted aromatic group having 6 to 30 ring carbon atoms, or a substituted or unsubstituted heteroaromatic group having 5 to 30 ring atoms;
two substituents at ring A₁ can form a ring;
ring B₁ is anaromatic group having 6 to 30 ring carbon atoms substituted by at least one group R²⁶, or a heteroaromatic group having 5 to 30 ring atoms substituted by at least one group R²⁶;
R²⁶ represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; an alkylhalide group having from 1 to 20 carbon atoms which is unsubstituted or substituted; a cycloalkyl group having from 3 to 20 ring carbon atoms which is unsubstituted or substituted; CN; OR⁵¹; SR⁵²; BR⁵³R⁵⁴; SiR⁵⁵R⁵⁶R⁵⁷ or halogen;
X represents O, S, NR_{EX}, SiR⁴⁴R⁴⁵, or CR⁴⁶R⁴⁷;
Y represents O, S, NR_{EY}, SiR⁴⁴R⁴⁵, or CR⁴⁶R⁴⁷;
R_{EX} and R_{EY} each independently represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; an alkenyl group having from 2 to 20 carbon atoms which is unsubstituted or substituted; an iminyl group Rₓ-C=N, an alkynyl group having from 2 to 20 carbon atoms which is unsubstituted or substituted;
R_{EX} or a substituent on R_{EX} may be bonded to the ring A₁ and/or to the ring B₁ or to a substituent on the ring A₁ and/or the ring B₁ to form a ring structure which is unsubstituted or substituted;
R_{EY} or a substituent on R_{EY} may be bonded to the ring B₁ or to a substituent on the ring B₁ to form a ring structure which is unsubstituted or substituted;
R⁴⁴, R⁴⁵, R⁴⁶ and R⁴⁷ each independently represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted;
or
R⁴⁴ and R⁴⁵ or R⁴⁶ and R⁴⁷ can form a ring which is unsubstituted or substituted;
Rₓ represents an aryl group having from 6 to 30 ring carbon atoms which is unsubstituted or substituted; a heteroaryl group having from 5 to 30 ring atoms which is unsubstituted or substituted;
R¹, R², R³ and R⁴ each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted;
or
R¹ and R² or R³ and R⁴ can form a ring, preferably an aromatic ring, which is unsubstituted or substituted;
U represents NR⁴⁸, O, or S, preferably NR⁴⁸, or O, more preferably NR⁴⁸;
R⁴⁸ represents an aryl group having from 6 to 30 ring carbon atoms which is unsubstituted or substituted; or a heteroaryl group having from 5 to 30 ring atoms which is unsubstituted or substituted;
Rₐ and R_{b} each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted;
or
Rₐ and R_{b} can form a ring which is unsubstituted or substituted;
R⁵, R⁶, R⁷ and R⁸ each independently represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; preferably an aryl group having from 6 to 30 ring carbon atoms which is unsubstituted or substituted; or an alkyl group having from 1 to 20 carbon atoms which is unsubstituted or substituted;
and/or
R⁵ and R⁶, R⁶ and R⁷, R⁷ and R⁸ and/or R⁵ and R⁸, preferably R⁵ and R⁸ and/or R⁶ and R⁷, can form a substituted or unsubstituted aliphatic ring;
R_{y} represents an aryl group having from 6 to 30 ring carbon atoms which is unsubstituted or substituted; or a heteroaryl group having from 5 to 30 ring atoms which is unsubstituted or substituted;
Rᵤ, Rᵥ, R_{w} and R_{z} each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; an alkylhalide group having from 1 to 20 carbon atoms which is unsubstituted or substituted; a cycloalkyl group having from 3 to 20 ring carbon atoms which is unsubstituted or substituted; CN; NR⁴⁹R⁵⁰; OR⁵¹; SR⁵²; BR⁵³R⁵⁴; SiR⁵⁵R⁵⁶R⁵⁷ or halogen; preferably hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; NR⁴⁹R⁵⁰;
m, n, o and p each independently represents 0, 1, 2, or 3, preferably 0 or 1, more preferably 0;
R⁴⁹, R⁵⁰, R⁵¹, R⁵², R⁵³ and R⁵⁴ each independently represents an aryl group having from 6 to 60 ring carbon atoms which is unsubstituted or substituted; a heteroaryl group having from 5 to 60 ring atoms which is unsubstituted or substituted; an alkyl group having from 1 to 20 carbon atoms which is unsubstituted or substituted or a cycloalkyl group having from 3 to 20 ring carbon atoms which is unsubstituted or substituted;
and/or
R⁴⁹ and R⁵⁰ and/or R⁵³ and R⁵⁴ can form a substituted or unsubstituted ring;
R⁵⁵, R⁵⁶ and R⁵⁷ each independently represents an aryl group having from 6 to 60 ring carbon atoms which is unsubstituted or substituted; a heteroaryl group having from 5 to 60 ring atoms which is unsubstituted or substituted; an alkyl group having from 1 to 20 carbon atoms which is unsubstituted or substituted or a cycloalkyl group having from 3 to 20 ring carbon atoms which is unsubstituted or substituted; and
the dotted lines are bonding sites.

2. The compound according to claim 1, wherein
Rₓ represents a group of formula (III) 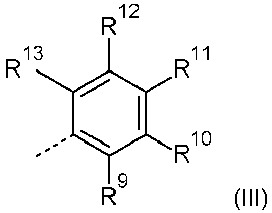
wherein R⁹, R¹⁰, R¹¹, R¹², and R¹³ each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; an alkylhalide group having from 1 to 20 carbon atoms which is unsubstituted or substituted; a cycloalkyl group having from 3 to 20 ring carbon atoms which is unsubstituted or substituted; CN; NR⁴⁹R⁵⁰; OR⁵¹; SR⁵²; BR⁵³R⁵⁴; SiR⁵⁵R⁵⁶R⁵⁷ or halogen;
and/or
two adjacent residues R⁹, R¹⁰, R¹¹, R¹² and/or R¹³ together may form a ring which is unsubstituted or substituted;
preferably, R⁹, R¹⁰, R¹¹, R¹², and R¹³ each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; or N R⁴⁹R⁵⁰;
and/or
two adjacent residues R¹⁰ and R¹¹ together may form an aliphatic ring which is unsubstituted or substituted;
and
the dotted line is a bonding site.

3. The compound according to claim 1 or 2, wherein
R_{y} and R⁴⁸ each independently represents a group of formula (IV) 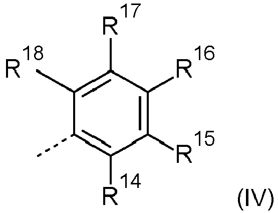
wherein R¹⁴, R¹⁵, R¹⁶, R¹⁷, and R¹⁸ each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; an alkylhalide group having from 1 to 20 carbon atoms which is unsubstituted or substituted; a cycloalkyl group having from 3 to 20 ring carbon atoms which is unsubstituted or substituted; CN; NR⁴⁹R⁵⁰; OR⁵¹; SR⁵²; BR⁵³R⁵⁴; SiR⁵⁵R⁵⁶R⁵⁷ or halogen;
and/or
two adjacent residues R¹⁴, R¹⁵, R¹⁶, R¹⁷ and/or R¹⁸ together may form a ring which is unsubstituted or substituted;
preferably, R¹⁴, R¹⁵, R¹⁶, R¹⁷, and R¹⁸ each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; or NR⁴⁹R⁵⁰; and
the dotted line is a bonding site.

4. The compound according to any one of claims 1 to 3, wherein
R_{EX} represents a group of formula (V) 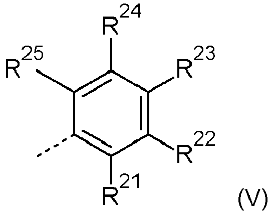
wherein R²¹, R²², R²³, R²⁴, and R²⁵ each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; an alkylhalide group having from 1 to 20 carbon atoms which is unsubstituted or substituted; a cycloalkyl group having from 3 to 20 ring carbon atoms which is unsubstituted or substituted; CN; NR⁴⁹R⁵⁰; OR⁵¹; SR⁵²; BR⁵³R⁵⁴; SiR⁵⁵R⁵⁶R⁵⁷ or halogen;
and/or
two adjacent residues R²¹, R²², R²³, R²⁴ and/or R²⁵ together may form a ring which is unsubstituted or substituted;
preferably, R²¹, R²², R²³, R²⁴, and R²⁵ each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; or NR⁴⁹R⁵⁰; or
two adjacent residues R²³ and R²⁴ together may form an aliphatic ring which is unsubstituted or substituted; and
the dotted line is a bonding site.

5. The compound according to any one of claims 1 to 4, wherein
R_{EY} represents a group of formula (VI) 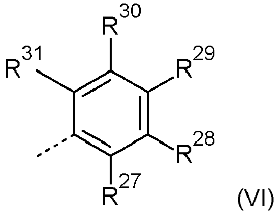
wherein R²⁷, R²⁸, R²⁹, R³⁰, and R³¹ each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; an alkylhalide group having from 1 to 20 carbon atoms which is unsubstituted or substituted; a cycloalkyl group having from 3 to 20 ring carbon atoms which is unsubstituted or substituted; CN; NR⁴⁹R⁵⁰; OR⁵¹; SR⁵²; BR⁵³R⁵⁴; SiR⁵⁵R⁵⁶R⁵⁷ or halogen;
and/or
two adjacent residues R²⁷, R²⁸, R²⁹, R³⁰ and/or R³¹ together may form a ring which is unsubstituted or substituted;
preferably, R²⁷, R²⁸, R²⁹, R³⁰, and R³¹ each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; or NR⁴⁹R⁵⁰;
and/or
two adjacent residues R²⁹ and R³⁰ together may form an aliphatic ring which is unsubstituted or substituted;
and
the dotted line is a bonding site.

6. The compound according to any one of claims 1 to 5, wherein
ring A₁ represents a group of formula (VII) 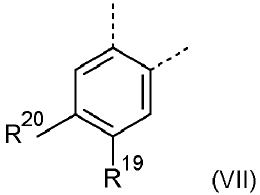
wherein R¹⁹ and R²⁰ each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; an alkylhalide group having from 1 to 20 carbon atoms which is unsubstituted or substituted; a cycloalkyl group having from 3 to 20 ring carbon atoms which is unsubstituted or substituted; CN; NR⁴⁹R⁵⁰; OR⁵¹; SR⁵²; BR⁵³R⁵⁴; SiR⁵⁵R⁵⁶R⁵⁷ or halogen;
or
R¹⁹ and R²⁰ together may form a ring which is unsubstituted or substituted; preferably, R¹⁹ and R²⁰ each independently represents hydrogen; an alkyl group having from 1 to 20 carbon atoms which is unsubstituted or substituted;
or
R¹⁹ and R²⁰ together may form an aliphatic ring which is unsubstituted or substituted; and the dotted lines are bonding sites.

7. The compound according to any one of claims 1 to 6, wherein
ring B₁ represents a group of formula (VIII) 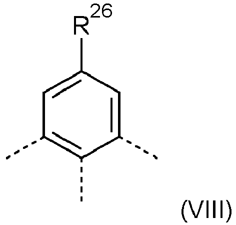
wherein R²⁶ represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; an alkylhalide group having from 1 to 20 carbon atoms which is unsubstituted or substituted; a cycloalkyl group having from 3 to 20 ring carbon atoms which is unsubstituted or substituted; CN; OR⁵¹; SR⁵²; BR⁵³R⁵⁴; SiR⁵⁵R⁵⁶R⁵⁷ or halogen; preferably, R²⁶ represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; or a cycloalkyl group having from 3 to 20 ring carbon atoms which is unsubstituted or substituted; and
the dotted lines are bonding sites.

8. The compound according to any one of claims 1 to 7, wherein
Z represents a group of formula (IIaa), (IIba), (IIca), (IIab), (IIbb) or (IIcb) 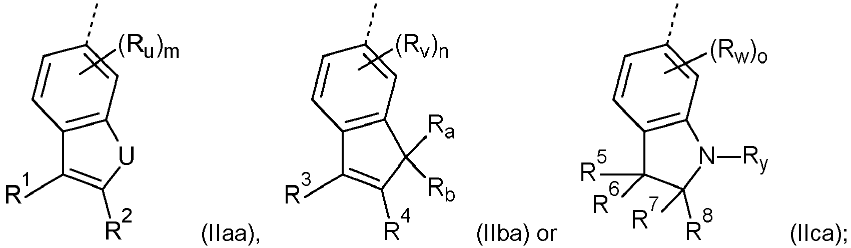 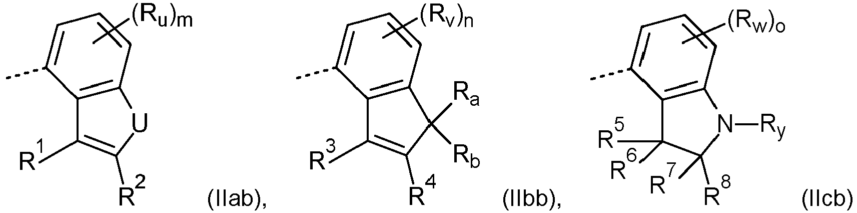
preferably, m, n and o are 0 or 1, more preferably 0;
the dotted lines are bonding sites.

9. The compound according to any one of claims 1 to 8, wherein Z represents a group of formula (IIa) or (IIc).

10. The compound according to any one of claims 1 to 9, wherein U in the compound of formula (Ila) represents NR⁴⁸.

11. The compound according to any one of claims 1 to 10, wherein R¹ and R² in the group of formula (IIa) together form a ring of formula (IX) 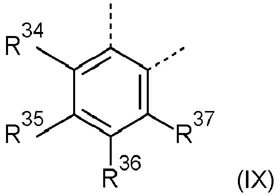
wherein R³⁴, R³⁵, R³⁶, and R³⁷ each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; an alkylhalide group having from 1 to 20 carbon atoms which is unsubstituted or substituted; a cycloalkyl group having from 3 to 20 ring carbon atoms which is unsubstituted or substituted; CN; NR⁴⁹R⁵⁰; OR⁵¹; SR⁵²; BR⁵³R⁵⁴; SiR⁵⁵R⁵⁶R⁵⁷ or halogen;
and/or
two adjacent residues R³⁴, R³⁵, R³⁶ and/or R³⁷ together may form a ring which is unsubstituted or substituted;
preferably, R³⁴, R³⁶, and R³⁷ each independently represents hydrogen;
R³⁵ represents hydrogen; or an alkyl group having from 1 to 20 carbon atoms which is unsubstituted or substituted; preferably hydrogen; and
the dotted lines are bonding sites.

12. The compound according to any one of claims 1 to 11, represented by the following structures (Ia) and (Ib)

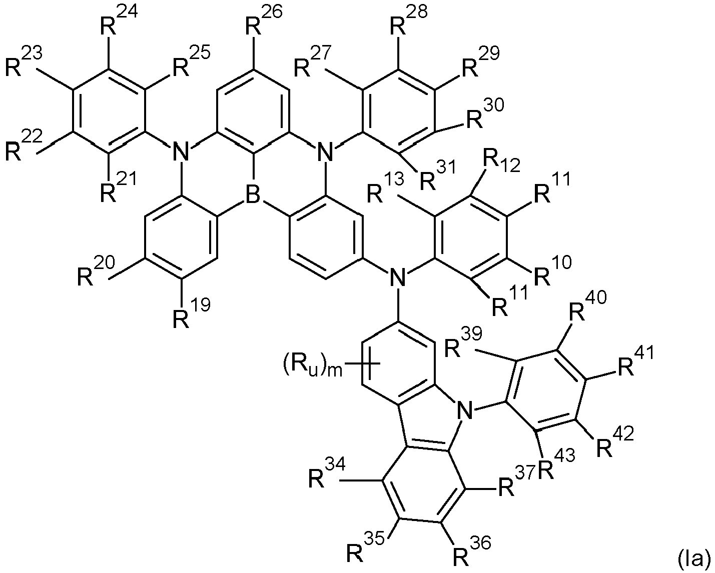

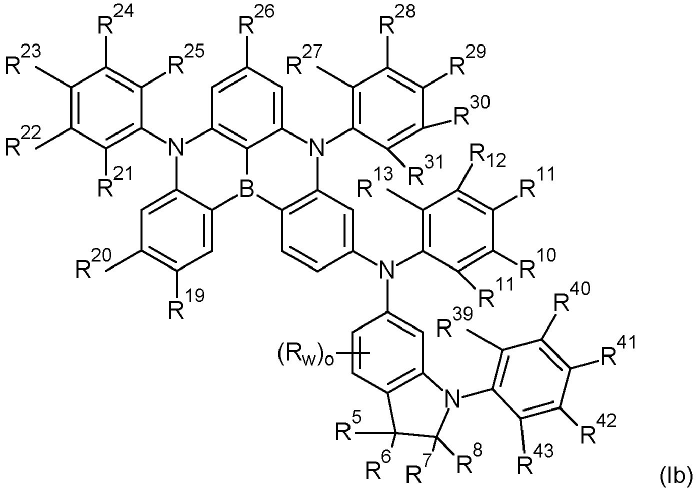

13. The compound according to any one of claims 1 to 12, wherein
R_{EX} represents a group of formula (Va) or a group of formula (Vb) 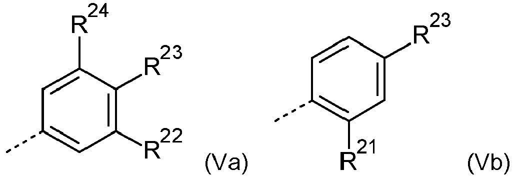 and/or
R_{EY} represents a group of formula (VIa) or a group of formula (Vlb) 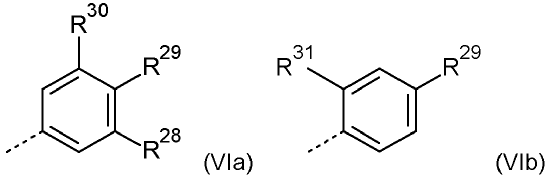 wherein
R²³ in the group of formula (Va) is Ar₁; and/or
R²⁹ group of formula (Vla) is Ar₂;
and/or
R²¹ in the group of formula (Vb) is Ar₃; and/or
R³¹ group of formula (Vlb) is Ar₄;
Ar₁, Ar₂, Ar₃, and Ar₄ are each independently an aryl group having from 6 to 30 ring carbon atoms which is unsubstituted or substituted; or a heteroaryl group having from 5 to 30 ring atoms which is unsubstituted or substituted;
wherein
Ar₁ or a substituent at Ar₁ may be fused to R²², and/or
Ar₂ or a substituent at Ar₂ may be fused to R²⁸,
wherein
R²⁴ is preferably hydrogen if Ar₁ is fused to R²², and/or
R³⁰ is preferably hydrogen if Ar₂ is fused to R²⁸;
R²² and R²⁴ in formula (Va), R²⁸ and R³⁰ in formula (VIa), R²³ in formula (Vb) and R²⁹ in formula (Vb) each independently represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; or NR⁴⁹R⁵⁰; and
the dotted lines are bonding sites.

14. The compound according to claim 13, wherein
R²² and R²⁴ in formula (Va), R²⁸ and R³⁰ in formula (VIa), R²³ in formula (Vb) and R²⁹ in formula (Vb)
each independently represents an alkyl group having from 1 to 20 carbon atoms which is unsubstituted or substituted; or a cycloalkyl group having from 3 to 20 ring carbon atoms which is unsubstituted or substituted.

15. The compound according to claim 13 or 14, wherein
Ar₁, Ar₂, Ar₃ and Ar₄ each independently represents 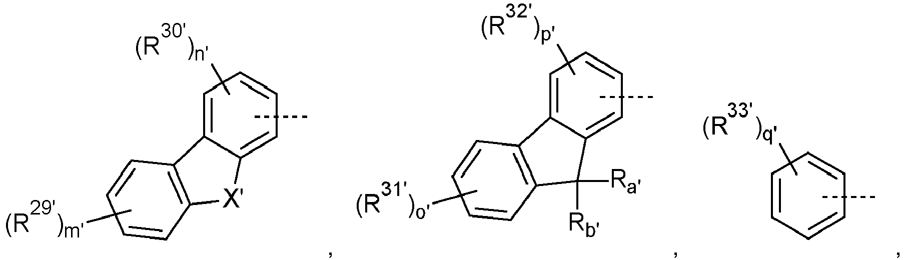 wherein
X' is O, S or NR^{34'} preferably O;
R_{a'} and R_{b'} each independently represents hydrogen, an alkyl group having from 1 to 20 carbon atoms which is unsubstituted or substituted; an aryl group having from 6 to 30 ring carbon atoms which is unsubstituted or substituted; a heteroaryl group having from 5 to 30 ring atoms which is unsubstituted or substituted;
R_{a'} and R_{b'} together form a ring structure which is unsubstituted or substituted;
R^{29'}, R^{30'}, R^{31'}, R^{32'}, R^{33'}and R^{34'} each independently represents an alkyl group having from 1 to 20 carbon atoms which is unsubstituted or substituted; a cycloalkyl group having from 3 to 20 ring carbon atoms which is unsubstituted or substituted; an aryl group having from 6 to 30 ring carbon atoms which is unsubstituted or substituted; or a heteroaryl group having from 5 to 30 ring atoms which is unsubstituted or substituted;
q' represents 0, 1, 2, 3, 4 or 5, preferably 0, 1 or 2, more preferably 0 or 1;
m' and o' each independently represents 0, 1, 2, 3 or 4, preferably 0 or 1, more preferably 0;
n' and p' each independently represents 0, 1, 2 or 3, preferably 0 or 1, more preferably 0;
and
the dotted lines are bonding sites.

16. A material, preferably an emitter material, for an organic electroluminescence device, comprising at least one compound according to any one of claims 1 to 15.

17. An organic electroluminescence device comprising at least one compound according to any one of claims 1 to 15.

18. The organic electroluminescence device according to claim 17, comprising a cathode, an anode and one or more organic thin film layers comprising an emitting layer disposed between the cathode and the anode, wherein at least one layer of the organic thin film layers comprises at least one compound according to any one of claims 1 to 15.

19. The organic electroluminescence device according to claim 18, wherein the light emitting layer comprises at least one compound according to any one of claims 1 to 15.

20. The organic electroluminescence device according to claim 19, wherein the light emitting layer comprises at least one host and at least one dopant, wherein the dopant comprises at least one compound according to any one of claims 1 to 15.

21. The organic electroluminescence device according to claim 20, wherein the host comprises at least one substituted or unsubstituted fused aromatic hydrocarbon compound and/or at least one substituted or unsubstituted anthracene compound.

22. The organic electroluminescence device according to claim 21, wherein the anthracene compound is represented by the following formula (10): 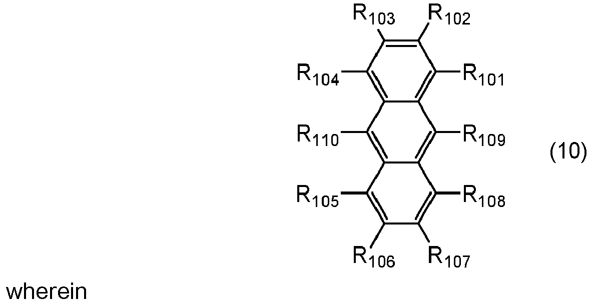
one or more pairs of two or more adjacent R₁₀₁ to R₁₁₀ may form a substituted or unsubstituted, saturated or unsaturated ring;
R₁₀₁ to R₁₁₀ that do not form the substituted or unsubstituted, saturated or unsaturated ring are independently a hydrogen atom, a substituted or unsubstituted alkyl group including 1 to 50 carbon atoms, a substituted or unsubstituted haloalkyl group including 1 to 50 carbon atoms, a substituted or unsubstituted alkenyl group including 2 to 50 carbon atoms, a substituted or unsubstituted alkynyl group including 2 to 50 carbon atoms, a substituted or unsubstituted cycloalkyl group including 3 to 50 ring carbon atoms, a substituted or unsubstituted alkoxy group including 1 to 50 carbon atoms, a substituted or unsubstituted alkylene group including 1 to 50 carbon atoms, a substituted or unsubstituted aryloxy group including 6 to 50 ring carbon atoms, a substituted or unsubstituted arylthio group including 6 to 50 ring carbon atoms, a substituted or unsubstituted aralkyl group including 7 to 50 carbon atoms, -Si(R₁₂₁)(R₁₂₂)(R₁₂₃), -C(=O)R₁₂₄, -COOR₁₂₅, -N(R₁₂₆)(R₁₂₇), a halogen atom, a cyano group, a nitro group, a substituted or unsubstituted aryl group including 6 to 50 ring carbon atoms, a substituted or unsubstituted monovalent heterocyclic group including 5 to 50 ring atoms, or a group represented by the following formula (31);
R₁₂₁ to R₁₂₇ are independently a hydrogen atom, a substituted or unsubstituted alkyl group including 1 to 50 carbon atoms, a substituted or unsubstituted cycloalkyl group including 3 to 50 ring carbon atoms, a substituted or unsubstituted aryl group including 6 to 50 ring carbon atoms or a substituted or unsubstituted monovalent heterocyclic group including 5 to 50 ring atoms; when each of R₁₂₁ to R₁₂₇ is present in plural, each of the plural R₁₂₁ to R₁₂₇ may be the same or different;
provided that at least one of R₁₀₁ to R₁₁₀ that do not form the substituted or unsubstituted, saturated or unsaturated ring is a group represented by the following formula (31). If two or more groups represented by the formula (31) are present, each of these groups may be the same or different;
-L₁₀₁-Ar₁₀₁ (31)
wherein in the formula (31),
L₁₀₁ is a single bond, a substituted or unsubstituted arylene group including 6 to 30 ring carbon atoms or a substituted or unsubstituted divalent heterocyclic group including 5 to 30 ring atoms;
Ar₁₀₁ is a substituted or unsubstituted aryl group including 6 to 50 ring carbon atoms or a substituted or unsubstituted monovalent heterocyclic group including 5 to 50 ring atoms.

23. An electronic equipment comprising the organic electroluminescence device according to any one of claims 17 to 22.

24. A light emitting layer comprising at least one host and at least one dopant, wherein the dopant comprises at least one compound according to any one of claims 1 to 15.

25. Use of a compound of formula (I) according to any one of claims 1 to 15 in an organic electroluminescence device.
